(19) Europäisches Patentamt / European Patent Office / Office européen des brevets

(11) **EP 3 535 615 B1**

(12) **EUROPÄISCHE PATENTSCHRIFT**

(45) Veröffentlichungstag und Bekanntmachung des Hinweises auf die Patenterteilung:
**27.09.2023** **Patentblatt 2023/39**

(21) Anmeldenummer: **17797595.0**

(22) Anmeldetag: **02.11.2017**

(51) Internationale Patentklassifikation (IPC):
**G02B 6/42** (2006.01)      **G02B 6/12** (2006.01)
**G02B 6/138** (2006.01)

(52) Gemeinsame Patentklassifikation (CPC):
**G02B 6/4204;** G02B 6/138; G02B 2006/12147

(86) Internationale Anmeldenummer:
**PCT/EP2017/078086**

(87) Internationale Veröffentlichungsnummer:
**WO 2018/083191 (11.05.2018 Gazette 2018/19)**

(54) **VERFAHREN ZUR HERSTELLUNG EINES OPTISCHEN SYSTEMS UND OPTISCHES SYSTEM**

METHOD FOR PRODUCING AN OPTICAL SYSTEM AND OPTICAL SYSTEM

PROCÉDÉ DE FABRICATION D'UN SYSTÈME OPTIQUE ET SYSTÈME OPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.11.2016 DE 102016221464**

(43) Veröffentlichungstag der Anmeldung:
**11.09.2019 Patentblatt 2019/37**

(73) Patentinhaber: **Karlsruher Institut für Technologie**
**76131 Karlsruhe (DE)**

(72) Erfinder:
• **DIETRICH, Philipp-Immanuel**
  **97999 Igersheim (DE)**
• **KOOS, Christian**
  **74936 Siegelsbach (DE)**
• **BLAICHER, Matthias**
  **76275 Ettlingen (DE)**
• **REUTER, Ingo**
  **76139 Karlsruhe (DE)**
• **XU, Yilin**
  **76307 Karlsbad (DE)**

(74) Vertreter: **Altmann Stößel Dick Patentanwälte PartG mbB**
**Theodor-Heuss-Anlage 2**
**68165 Mannheim (DE)**

(56) Entgegenhaltungen:
EP-A1- 3 130 950      WO-A1-2015/134566
JP-A- 2011 248 312

• **DIETRICH P-I ET AL: "Lenses for low-loss chip-to-fiber and fiber-to-fiber coupling fabricated by 3D direct-write lithography", 2016 CONFERENCE ON LASERS AND ELECTRO-OPTICS (CLEO), OSA, 5. Juni 2016 (2016-06-05), Seiten 1-2, XP033025584, [gefunden am 2016-12-16] in der Anmeldung erwähnt**
• **NGUYEN MINH-HANG ET AL: "SU-8 Lenses: Simple Methods of Fabrication and Application in Optical Interconnection Between Fiber/LED and Microstructures", JOURNAL OF ELECTRONIC MATERIALS, WARRENDALE, PA, US, Bd. 45, Nr. 5, 3. März 2016 (2016-03-03), Seiten 2529-2535, XP035945045, ISSN: 0361-5235, DOI: 10.1007/S11664-016-4408-6 [gefunden am 2016-03-03]**
• **Albertas Zukauskas ET AL: "Improvement of the Fabrication Accuracy of Fiber Tip Microoptical Components via Mode Field Expansion", Journal of Laser Micro Nanoengineering, 1. März 2014 (2014-03-01), Seite 68, XP055441906, Ibaraki DOI: 10.2961/jlmn.2014.01.0014 Gefunden im Internet: URL:http://www.jlps.gr.jp/jlmn/upload/2d86 6f0f548b597000594a79349feb22.pdf in der Anmeldung erwähnt**

## Beschreibung

### Gebiet der Erfindung

Die vorliegende Erfindung liegt auf dem Gebiet der Optik, insbesondere der Mikrooptik, und betrifft ein optisches System, welches über mindestens zwei gesonderte optische Komponenten und mindestens eine optische Verbindung zwischen den beiden optischen Komponenten verfügt, und ein Verfahren zu seiner Herstellung. Bei den optischen Komponenten kann es sich beispielsweise um Glasfasern oder integriert-optische Schaltkreise (engl. *Photonic Integrated Circuits,* PIC) handeln, die unter anderem Fotodetektoren, Lichtquellen, Modulatoren oder passive optische Bauteile wie Leistungsteiler oder Filter umfassen können. Andere Arten von optischen Komponenten sind denkbar.

Die optische Verbindung, welche auch als "optische Kopplung" bezeichnet werden kann, umfasst hierbei eine Anordnung, mit der Licht zwischen einer ersten optischen Komponente und einer zweiten optischen Komponente übertragen werden kann. Diese Anordnung kann strahlformende optische Elemente enthalten, mit der sich eine Ausbreitungsrichtung und/oder Form des von einer der Komponenten abgestrahlten Lichts bzw. des von der anderen der Komponenten empfangenen Lichts modifizieren lässt.

In vielen Fällen werden bei der optischen Kopplung möglichst geringe Verluste angestrebt. Der in diesem Zusammenhang verwendete Begriff der "Kopplungseffizienz" oder "Koppeleffizienz" beschreibt den Quotienten aus der optischen Leistung, welche von einer empfangenden optischen Komponente empfangen wird, und der optischen Leistung, welche von einer abstrahlenden optischen Komponente abgestrahlt wird.

Die mit dem erfindungsgemäßen Verfahren hergestellten optischen Systeme finden vorzugsweise Anwendung in der optischen Datenübertragung, der Messtechnik und Sensorik, den Lebenswissenschaften und der Medizintechnik, oder der optischen Signalverarbeitung. Weitere Einsatzbereiche sind denkbar.

### Stand der Technik

Ein entscheidender Schritt beim Aufbau optischer Systeme ist die optische Verbindung der das System bildenden optischen Komponenten. Für eine verlustarme optische Kopplung sind dabei zwei Aspekte von großer Bedeutung: Einerseits werden die zu verbindenden optischen Komponenten derart zueinander ausgerichtet und fixiert, dass das von einer Facette eines ersten Bauteils abgestrahlte Licht die Facette des zweiten Bauteils an einer bestimmten Stelle und aus einer bestimmten Richtung trifft. In vorteilhafter Weise werden hierzu die zu verbindenden Komponenten sowohl bzgl. ihrer Position als auch bzgl. ihrer Orientierung mit hoher Präzision ausgerichtet und befestigt. Andererseits sollte das von der ersten Komponente abgestrahlte Licht an der Facette der zweiten Komponente eine vorteilhafte Feldverteilung aufweisen, um eine möglichst hohe Koppeleffizienz zu erreichen. Diese beiden Aspekte stehen im Mittelpunkt der heute verwendeten Koppelverfahren.

Hierbei bezeichnet der Begriff der "Facette" einer optischen Komponente diejenige Fläche einer Licht abstrahlenden optischen Komponente, welche das Licht bei Abstrahlung als letztes durchstößt. Umgekehrt bezeichnet die Facette einer Licht empfangenden optischen Komponente diejenige Fläche der optischen Komponente, die das Licht bei einem Empfang durch die optische Komponente als erstes beaufschlagt. Die Begriffe "Modenfeld" oder "Strahlprofil" beschreiben beide eine Feldverteilung eines von einer optischen Komponente abgestrahlten Lichtfelds, wobei zwischen dem Modenfeld an der Facette der optischen Komponente und in einer Ebene an einer bestimmten weiteren Position unterschieden werden kann. Unter einer "Veränderung des Modenfelds" wird eine Beeinflussung des Modenfelds in Bezug auf seine Ausbreitung (Propagation) in Strahlrichtung verstanden. Diese Veränderung kann hierbei insbesondere in einer Kollimation, Aufweitung oder Fokussierung durch eine strahlformende Komponente bestehen. Der Begriff des "Modenfelddurchmessers" beschreibt eine räumliche Ausdehnung der Intensitätsverteilung einer bestimmten, von einer optischen Komponente abgestrahlten Mode. Bei häufig auftretenden Gauß'schen Strahlprofilen wird die räumliche Ausdehnung hierbei beispielsweise durch den Durchmesser des Gebietes definiert wird, in welchem die Intensität des Lichts mehr als $1/e^2$, d.h. mehr als ca. 13,5 %, der maximalen Intensität des Lichts beträgt. Bei nichtrotationssymmetrischen, beispielsweise elliptischen Strahlprofilen wird hierbei üblicherweise zwischen einem maximale und einem minimalen Durchmesser unterschieden.

Der Begriff der "Positionierungsgenauigkeit" bezieht sich auf die Summe aller statistischen und systematischen Abweichungen von einer Ist-Position der beiden optischen Komponenten nach erfolgter Positionierung und Fixierung im Vergleich zu einer Soll-Position. Allgemein führen große Modenfelddurchmesser zu hoher Positionierungstoleranz bezüglich translatorischer Positionierung, während kleine Modenfelddurchmesser zu geringer Positionierungstoleranz bezüglich translatorischer Positionierung führen. Die Positionierungstoleranz beschreibt hierbei eine Abhängigkeit der Kopplungseffizienz von der Abweichung der Ist-Position einer optischen Komponente von der Soll-Position mit maximaler Kopplung. Eine hohe Positionierungstoleranz zeichnet sich durch eine geringe Abhängigkeit der Kopplungseffizienz von der Abweichung der Ist-Position von der Soll-Position aus.

Im Hinblick auf eine Ausrichtung von optischen Bauteilen bei der Montage von Systemen werden sogenannte aktive Positionierungsverfahren und passive Positionierungsverfahren unterschieden. Bei passiven Positionierungsverfahren wird die Ausrichtung der zu verbindenden optischen Komponenten zueinander meistens über mechanische Strukturen wie z.B. Anschläge oder Fassungen für optische Komponenten erreicht, oft mit Unterstützung durch bildgebende Verfahren. Diese Verfahren lassen sich vergleichsweise einfach umsetzen, allerdings sind die erreichbaren Genauigkeiten beschränkt. Dies wird insbesondere dann zu einem Problem, wenn die zu verbindenden optischen Komponenten lateral einmodige Wellenleiter mit hohem Brechungsindexunterschied zwischen Wellenleiterkern und Mantel aufweisen. In diesem Fall wird die Feldverteilung an der Bauteilfacette durch das Modenfeld des jeweiligen Wellenleiters bestimmt, das in vielen Fällen Durchmesser von wenigen Mikrometern oder gar weniger als 1 $\mu$m aufweisen kann. So weisen Wellenleiter aus Indium-Phosphid (InP) oder Silizium einen Modenfelddurchmesser von einem Mikrometer oder weniger auf. Diese Modefelddurchmesser lassen sich durch auch als "Taper" bezeichnete Verjüngungen oder Verbreiterungen des Wellenleiters auf typischerweise 2 $\mu$m bis 4 $\mu$m erhöhen; allerdings kann dies in vielen Fällen zu einem stark elliptischen Modenfeld führen.

Eine hohe Koppeleffizienz erfordert Positionierungsgenauigkeiten in der Größenordnung eines Bruchteils dieser Modenfelddurchmesser und daher ist mit passiven Justageverfahren aufgrund mechanischer Toleranzen bzw. einer beschränkten Auflösung der verwendeten bildgebenden Verfahren in vielen Fällen nicht erreichbar. Passive Justageverfahren werden daher vornehmlich zur optischen Kopplung von Komponenten mit mehrmodigen optischen Wellenleitern verwendet, bei denen die Verteilung des ein- bzw. ausgekoppelten Feldes in der Bauteilfacette einen wesentlich größeren Durchmesser von oftmals deutlich mehr als 10 $\mu$m aufweist und damit die Anforderungen an die Positioniergenauigkeit des Bauteils entsprechend reduziert werden. Solche multimodigen photonischen Systeme sind jedoch sehr begrenzt in ihrer Leistungsfähigkeit, was sich bei Kommunikationssystemen z.B. in einer maximal übertragbaren Datenrate oder der Länge einer Übertragungsstrecke bemerkbar machen kann. In vielen Fällen werden daher optische Systeme mit transversal einmodigen Wellenleitern bevorzugt.

Für die Ankopplung von einmodigen Wellenleitern mit kleinem Modenfelddurchmesser werden dagegen meist aktive Justageverfahren eingesetzt, bei denen während des Justagevorganges fortwährend die Koppeleffizienz gemessen und maximiert wird. Diese Verfahren kommen ohne mechanische Anschläge oder hochauflösende bildgebende Verfahren aus, machen es aber notwendig, dass Licht von einer der zu verbindenden Komponente abgestrahlt wird und dass der in die zweite Komponente eingekoppelte Anteil des Lichtes messtechnisch erfasst wird. Dies erfordert üblicherweise eine elektrische oder optische Kontaktierung der beiden Komponenten und damit ein vergleichsweise komplexes Verfahren, welches in vielen Fällen einen hohen Anteil an händischen Arbeitsschritten erfordert. Hinzu kommt, dass zur Befestigung der Bauteile nach der Montage oftmals Klebeverfahren verwendet werden. Um zu verhindern, dass eine Schrumpfung des Klebers zu eine Dejustierung der Bauteile führen kann, sollte die Koppeleffizienz in vielen Fällen während des gesamten Aushärtevorganges der Klebestelle überwacht und beibehalten werden. Dies führt zu einem vergleichsweise geringen Durchsatz bei aktiven Justageverfahren und damit zu entsprechend hohen Kosten für eine optische Aufbautechnik, welche die Kosten der verwendeten optischen Komponenten oftmals übersteigen. In vielen Fällen ist eine Kopplung von Komponenten mit kleinen Modenfeldern sogar prinzipiell unmöglich. Dies betrifft zum Beispiel die simultane optische Verbindung von Komponenten, die jeweils mehrere Koppelstellen aufweisen, deren Position zueinander fabrikationsbedingt Abweichungen in der Größenordnung der Modenfelddurchmesser aufweisen. Ein bedeutsames Beispiel ist die Kopplung mehrerer Glasfasern, die zu einem sog. Array zusammengefasst wurden. Hierbei beträgt die Variation des Abstandes einzelner Fasern bis zu mehreren Mikrometern, so dass die gleichzeitige Ausrichtung aller Glasfasern an einem Wellenleiterarray mit kleinen Modenfelddurchmessern problematisch ist.

Zusätzlich zu den hohen Anforderungen an die Koppeleffizienz besteht in vielen Fällen das Problem, dass die optischen Feldverteilungen an den Facetten der zu verbindenden optischen Komponenten in Amplitude und/oder Phase stark voneinander abweichen, was auch bei optimaler Positionierung zu einer vergleichsweise geringen Koppeleffizienz führt. Dies erfordert in vielen Fällen zusätzliche Elemente, wie z.B. Mikrolinsen mit sphärischen, zylindrischen oder generell asphärischen Formen, die ebenfalls mit sehr hoher Genauigkeit zwischen den zu verbindenden optischen Komponenten positioniert werden. Dies erhöht nicht nur die Anzahl der zu Freiheitsgrade in der Justierung und damit den Justierungsaufwand beträchtlich, sondern führt auch zu vergleichsweise großen Anordnungen, die oftmals nicht den in der Praxis herrschenden Anforderungen an Kompaktheit und Robustheit gerecht werden können. Die hohe Anzahl der zu optimierenden Freiheitsgrade verkompliziert eine Montage stark. Zudem kann es bei einer hohen Anzahl von optischen Flächen im Strahlengang zu hohen Reflexionsverlusten und zu Rückreflexionen kommen, die insbesondere bei der Ankopplung von Lichtquellen wie Lasern oder Superlumineszenzdioden (SLED) ein Problem darstellen können.

Im Falle der Kopplung einer Glasfaser an einen optischen Chip kann eine Modenfeldanpassung auch durch eine "Faserlinse" (engl. "lensed fiber") erreichet werden, wobei die Faserlinse eine entsprechend gekrümmte Oberfläche der Faserfacette bezeichnet, welche hierzu über die Funktion einer fokussierenden Linse verfügt. Hierbei kann die gekrümmte Oberfläche der Faserfacette z.B. durch Aufschmelzen, Ätzen oder Polieren erzielt werden. Dieses Verfahren wurde für einzelne Faser-Chip Verbindungen entwickelt und wird in diesem Zusammenhang bereits seit vielen Jahren für die Ankopplung von Einmodenfasern an Laserdioden verwendet. Allerdings sind die erzielbaren Koppelverluste verhältnismäßig hoch, insbesondere dann, wenn das vom optischen Chip angestrahlte Modenfeld einen elliptischen Querschnitt aufweist. Dies ist in erster Linie einer unzureichenden Kontrolle über die genaue Form der fokussierenden Glasfläche zuzuschreiben. Hinzu kommt, dass das Verfahren nur sehr schwer auf die Kopplung mit Faserarrays übertragen werden kann, da die Herstellung der Faserlinsen meistens nur für einzelne Fasern möglich ist.

Optische Chips lassen sich nicht nur über Wellenleiterfacetten an der Chipkante ankoppeln, sondern auch über entsprechende Koppelstrukturen auf der Chipoberfläche. Derartige Verfahren finden derzeit vor allem bei der Ankopplung von sog. Silizium-Photonik-Chips Anwendung. Hierbei wird eine Faser oder ein Array von Fasern in einem steilen Winkel, insbesondere von nahezu 90°, auf ein auf dem optischen Chip integriertes Gitter gerichtet, das das Licht in die Chipebene beugt und in den entsprechenden Wellenleiter fokussiert. Dieses Konzept erlaubt die optische Ankopplung von Wellenleitern auf dem gesamten Chip und hat insbesondere den Vorteil, dass es keiner aufwendigen Präparation von Wellenleiterfacetten an der Chipkante bedarf. Damit wird es möglich, Chips bei der Herstellung mit einem einfachen Sägeverfahren zu vereinzeln, wohingegen bei der Ankopplung über die Wellenleiterkante wesentlich aufwendigere Spaltverfahren, evtl. in Kombination mit nachfolgenden Polier- oder Ätzprozessen angewandt werden. Allerdings weisen Gitterkoppler in vielen Fällen vergleichsweise hohe Verluste auf und ermöglichen es zudem nur, über einen vergleichsweise schmalbandigen Spektralbereich effizient zu koppeln.

Als alternativen Ansatz offenbart US 8,903,205 B2 ein Verfahren zum Verbinden von optischen Komponenten mittels Polymerwellenleitern (engl. *photonic wirebonds,* PWB), die *in- situ* durch ein dreidimensionales direktschreibendes Lithographieverfahren erzeugt werden. Hierbei werden die zu verbindenden optischen Komponenten zunächst mit geringer Genauigkeit auf einer gemeinsamen Grundplatte befestigt und anschließend durch Polymerwellenleiter miteinander verbunden. Dieses Verfahren kommt ohne hochgenaue Justierung der zu verbindenden optischen Komponenten aus, da die Form der Polymerwellenleiter an die Ist-Position der Komponenten angepasst werden kann. Allerdings weist das Konzept einige Einschränkungen im Hinblick auf die Architektur der damit zu erzeugenden mikrooptischen Systeme auf. So erfordern photonische Wirebonds stets eine mechanische Verbindung der optischen Elemente über einen PolymerWellenleiter, was in vielen Fällen nicht möglich ist, z.B. wenn der Abstand der optischen Elemente wesentlich größer ist als die Schreibfelder üblicher, für die Herstellung von PWB geeigneter Lithographie-Systeme. In ähnlicher Weise sind optische Verbindungen über photonische Wirebonds nicht lösbar und können insbesondere nicht zur Erzeugung von steckbaren Verbindungen verwendet werden. Darüber hinaus stellt die Zugänglichkeit der Kopplungsstellen der zu verbindenden optischen Komponenten beim photonischen Wire-Bonden ein Problem dar. Der hier beschriebene Arbeitsablauf sieht vor, dass die optischen Komponenten erst auf einem gemeinsamen Bauteilträger fixiert werden, und dass das daraus entstandene Multi-Chip-Modul erst in einem zweiten Schritt mit lithographisch erzeugten photonischen Wirebonds versehen wird. Da dazu Lithographie-Systeme mit hoher numerischer Apertur erforderlich sind, lassen sich photonische Wirebonds praktisch nur auf der Oberseite oder an anderen, nach außen gewandten Flächen des Multi-Chip-Moduls erzeugen; ein Adressieren von Koppelstellen im Innern des Moduls oder in einem zum Modul gehörenden Gehäuse würde zu einer Störung bzw. Abschattung des Lithographiestrahls führen und ist daher nicht realisierbar. In ähnlicher Weise ist es mit photonischen Wirebonds nicht möglich, optische Komponenten in Form von Chips zu stapeln (engl. *chip stacking*) und die verschiedenen Lagen untereinander optisch zu verbinden. Außerdem sollte die elektrische Anbindung der optischen Komponenten, bei der z.B. metallische Drahtbonds zum Einsatz kommen, so gestaltet werden, dass die optischen Koppelstellen zugänglich bleiben. Dies erfordert oftmals einen vergleichsweise komplexen Fertigungsablauf, bei dem zwischen der Herstellung optischer und elektronischer Verbindungen hin- und hergewechselt wird. Ein weiterer Nachteil besteht in nachgelagerten, zum lithographischen Verfahren gehörenden Schritten, wie z.B. der Behandlung des belichteten Photoresists mit einem Entwickler zur Freistellung der erzeugten Wellenleiterstrukturen, bei welchem das gesamte Multi-Chip-Modul in Kontakt mit einem Lösungsmittel tritt und dementsprechend bevorzugt aus chemisch resistenten Materialien aufgebaut sein sollte. Schließlich erfordern Polymerwellenleiter häufig ein, diese umgebendes Mantelmaterial zur Einstellung des Brechungsindexkontrastes, was das Verfahren zusätzlich verkompliziert.

US 9,002,157 B2 offenbart ein Verfahren zur lithographischen Herstellung einer dreidimensionalen photonischen Komponente, welche mindestens zwei präzise zueinander ausgerichtete optische Elemente umfasst, zwischen denen Licht übertragen wird. Eine hohe Genauigkeit der relativen Ausrichtung der optischen Elemente wird dadurch erreicht, dass sie in einem einzigen Arbeitsgang mittels Zwei-Photonen-Lithographie hergestellt werden. Dieses Verfahren bezieht sich also auf eine optische Komponente, die in einem Schritt vollständig durch dreidimensional direktschreibende Lithographie hergestellt wird, und die präzise zueinander ausgerichtete Elemente enthält. Die Kombination bestehender optischer Komponenten mit weiteren, lithographisch erzeugten Zusatzelementen, wird nicht adressiert. Dementsprechend erlaubt das Verfahren auch keine robuste und effiziente Kopplung zwischen bestehenden optischen Komponenten.

EP 0 940 701 A2 offenbart eine Anordnung zur Einkopplung eines elliptischen Modenfelds eines kantenemittierenden Lasers in eine Einmodenfaser mit rotationssymmetrischem Modenfeld mit möglichst geringen Verlusten. Die Anordnung umfasst eine diskrete Kombination aus einer fokussierenden Linse und einer anamorphen Mikrolinse, die jeweils individuell im Strahlengang positioniert werden. Zur Herabsetzung der Anforderungen an die Positioniergenauigkeit wird die anamorphe Mikrolinse in der Nähe der Faserfacette und die fokussierende Linse in der Nähe der Laserfacette positioniert. Da die fokussierende Linse und die anamorphe Mikrolinse individuell in fünf bzw. sechs Freiheitsgraden relative zur Laser- bzw. Faserfacette präzise ausgerichtet und fixiert werden, ist ein erheblicher Montageaufwand erforderlich.

US 8 968 987 B2 offenbart die Herstellung von optischen Spiegeln in Vias (Durchlöcher) einer optischen Leiterplatte mittels eines dreidimensional-direktschreibenden Lithographieverfahrens. Die Spiegel dienen zur optischen Ankopplung von in die Leiterplatte eingebetteten Wellenleitern. Das Konzept geht nicht darauf ein, wie die einzukoppelnden Lichtstrahlen erzeugt werden, thematisiert also weder die Ankopplung an eine zweite optische Komponenten noch die damit verbundenen Aspekte der Strahlformung bzw. der mechanischen Toleranzen.

Zukauskas et al., Improvement of the Fabrication Accuracy of Fiber Tip Microoptical Components via Mode Field Expansion, Journal of Laser Micro/Nanoengineering Vol. 9, No. 1, Seite 68-72, 2014, beschreiben die Herstellung einer Struktur mittels 3D Zwei-Photonen-Lithographie auf der Facette einer Einmodenfaser. Die hierbei hergestellte Struktur wird in einem möglichst großen Abstand zur Facette der Einmodenfaser geschrieben, um so die Genauigkeitsanforderungen bei der Platzierung der Struktur relativ zum Faserkern herabzusetzen. Die Ankopplung an weitere optische Bauteile wie z.B. integrierte Chips wird nicht thematisiert.

Y. Fu et al., Integrated Micro-Cylindrical Lens with Laser Diode for Single-Mode Fiber Coupling, IEEE Photonics Technology Letters, Vol. 12, No. 9, S. 1213, 2000, beschreibt einen Ansatz, mit fokussierten Ionenstrahlen (FIB, Focussed Ion Beam) eine Zylinderlinse auf Lasern herzustellen. Es wird dabei ein subtraktives Verfahren verwendet, d.h. Material wird von der Bauteilfacette entfernt, um eine Fläche mit refraktiver Wirkung zu erzeugen. Hierdurch ist jedoch die Herstellung von nur maximal einer strahlformenden Fläche pro optischer Komponente möglich. Außerdem ist eine Aufweitung des Modenfeldes zur Herabsetzung der Genauigkeitsanforderungen beim Positionieren von Bauteilen mit diesem Verfahren nicht oder nur sehr eingeschränkt möglich. Zudem kann das Herstellungsverfahren zu Schäden im Kristallgitter des Lasers führen und ist nicht für alle Bauteile geeignet. Weiterhin sind Herstellungsverfahren mit FIB sind nicht skalierbar, da sie sehr langsam und kostenintensiv sind.

S. Thiele et al., Ultra-compact on-chip LED collimation optics by 3D-printing, Opt. Lett. 41, Seite 3029, 2016, beschreiben die Herstellung einer 3D-Freiformoptik zur Strahlformung des von einer lichtemittierenden Diode (Light Emitting Diode, LED) erzeugten Lichtes. Mit den darin beschriebenen Freiformoptiken, welche auf lateral hochgradig multimodige Lichtfelder ausgelegt sind, ist eine Kopplung zu weiteren optischen Komponenten nicht möglich.

T. Gissibl et al., Two-photon direct laser writing of ultracompact multi-lens objectives, Nature Photonics 10, 2016, beschreiben die Herstellung einer makroskopischen Freiformoptik auf einer einmodigen optischen Fasern mittels 3D Druck, wobei Möglichkeiten zur strahlenoptischen Anpassung der Strahldivergenz aufgezeigt werden. Es wird jedoch nicht auf eine Anwendung für optische Verbindungen eingegangen.

Schneider et al., Optical coherence tomography system mass-producible on a silicon photonic chip, Opt. Express 24, Seite 1573-1586, 2016 beschreibt die Herstellung einer Linse mit 3D-Lithographie auf einem mikrooptischen Chip sowie Kopplungsexperimente in Fasern. Hierbei wurde ein strahlformendes optisches Element jedoch nur auf eine optische Komponente geschrieben, und der Strahl wurde auf die Facette der Glasfaser fokussiert, wodurch jedoch keine Erhöhung der Positioniertoleranzen über den Modenfelddurchmesser der Glasfaser hinaus erreicht werden kann. Zudem wurden in dem in der Veröffentlichung beschriebenen Experiment die Komponenten nur zu einer temporären Kopplung mit Hilfe von Mikropositionier-Tischen relativ zueinander platziert.

Dietrich et al., Lenses for Low-Loss Chip-to-Fiber and Fiber-to-Fiber Coupling Fabricated by 3D Direct-Write Lithography, Conf. on Lasers and Electro-Optics (CLEO' 16), Paper SM1G.4., 2016 beschreibt die Herstellung einer Linse mit 3D-Lithographie auf einer optischen Faser sowie Kopplungsexperimente mit Lasern. Hierbei wurde ein strahlformendes optisches Element jedoch nur auf eine optische Komponente geschrieben, wodurch keine Erhöhung der Positioniertoleranzen über den Modenfelddurchmesser der beteiligten optischen Komponenten hinaus erreicht werden konnten. Zudem wurden auch hier die Komponenten nur zur temporären Kopplung mit Hilfe von Mikropositionier-Tischen relativ zueinander platziert.

M. Blaicher, Towards Scalable Hybrid 2D-3D Nanophotonic Circuits, Magisterarbeit, Karlsruher Institut für Technologie, 2014, offenbart eine durch Mikro-3D-Druck hergestellte Wellenleiter-Linsen Kombination, die eine Auskopplung von in einem planar integrierten Wellenleiter geführtem Licht in eine Richtung senkrecht zur Substratoberfläche bewirkt. Diese Bauteile bestehen aus gedruckten Wellenleitern, welche Licht aus einem siliziumphotonischen Wellenleiter in eine senkrechte Richtung umlenken und über eine Linse in den Freiraum abstrahlen können.

Nguyen Minh-Hang et al., SU-8 Lenses: Simple Methods of Fabrication and Application in Optical Interconnection Between Fiber/LED and Microstructures, J. Electronic Materials 45(5), 2016, S. 2529-2535, beschreibt Verfahren zur Herstellung von Off-Plane-Linsen aus SU-8 auf Glas für optische Verbindungen. Diese Verfahren ermöglichen die Herstellung der Off-Plane-Linsen mit flexibler Spotgröße und Brennweite in Abhängigkeit von der SU-8-Well-Größe, dem SU-8-Tropfenvolumen und der Viskosität. Weiterhin werden On-Plane-Linsen aus SU-8 mittels Photolithographie hergestellt, die mit den Off-Plane-Linsen aus SU-8 kaskadiert angeordnet werden, um Lichtpunkte zu erzeugen, die auf einige Mikrometer reduziert sind. Die kaskadierten Linsen können als Koppler für die Lichteinkopplung von Faser/Leuchtdiode (LED) in Mikro- und Nanostrukturen eingesetzt werden.

JP 2011 248312 A offenbart optische Elemente, die eine erste Lichteinfalls-/Lichtaustrittsfläche, die Lichteinfalls-/Lichtaustrittselementen zugewandt ist, eine zweite Lichteinfalls-/ Lichtaustrittsfläche, die einer optischen Faser zugewandt ist, und eine Lichtreflexionsfläche umfassen. Die Lichtreflexionsfläche reflektiert das von einer der ersten und zweiten Lichteinfalls-/Lichtaustrittsfläche auf die andere der ersten und zweiten Lichteinfalls-/Lichtaustrittsfläche einfallende Licht. Die zweite Lichteinfalls-/Lichtaustrittsfläche weist einen Linsenoberflächenabschnitt mit einer positiven optischen Wirkung auf.

WO 2015/134566 A1 offenbart Verfahren zur Bildung einer Faserkopplungsvorrichtung, die ein Substrat umfasst, das eine Substratoberfläche und mindestens ein optoelektronisches und/oder photonisches Element aufweist und ferner mindestens eine Faserkopplungs-Ausrichtungsstruktur umfasst, die optisch durchlässig ist. Das Verfahren umfasst a) Aufbringen eines polymerisierbaren Materials auf die Substratoberfläche, b) selektives Polymerisieren eines Bereichs des polymerisierbaren Materials unter Verwendung eines Verfahrens der 3D-Lithographie, um den Bereich des polymerisierbaren Materials in ein Polymermaterial umzuwandeln, wodurch mindestens eine Faserkopplungs-Ausrichtungsstruktur gebildet wird, und c) Reinigen des Substrats und des Polymermaterials von verbleibendem nicht polymerisiertem polymerisierbarem Material, wodurch die mindestens eine Faserkopplungs-Ausrichtungsstruktur der Faserkopplungsvorrichtung freigelegt wird.

Das nachveröffentlichte Dokument EP 3 130 950 A1 offenbart auf optischen Komponenten mittels direktschreibenden Lithographieverfahren additiv hergestellte Umlenkelemente, die es ermöglichen, einen von einem oberflächenemittierenden Bauteil senkrecht zur Substratebene emittierten Lichtstrahl in eine Richtung parallel zur Substratebene abzulenken und dabei Höhe und den Durchmesser des Strahls unabhängig voneinander festzulegen.

Darüber hinaus sind weitere optische Systeme, die gesonderte optische Komponenten und mindestens eine optische Verbindung zwischen den optischen Komponenten aufweisen, sowie Verfahren zu deren Herstellung bekannt. DE 199 29 878 A1 offenbart einen Träger zur Montage von optoelektronischen Komponenten für ein Lichtleitersystem, welche ebene oder mit einem Relief versehene Spiegelstrukturen umfasst, die mittels konventioneller Silizium-Mikrostrukturierung hergestellt sind. US 2008/0142815 A1 beschreibt einen optischen Modulhalter, der zur Verbindung von optoelektronischen Komponenten und optischen Fasern dient, wobei zunächst ein Modulhalter mittels Spritzguss integral aus einem Harzmaterial gefertigt wird und dann eine optische Faser und/oder optoelektronische Komponenten in eine dafür vorgesehene Aussparung eingeführt und befestigt werden. EP 0 781 423 B1 offenbart eine Anordnung von mehreren diskreten Linsen, welche mittels einer Silizium-Mikrostruktur zueinander positioniert und fixiert werden. US 6 302 593 B1 beschreibt ein System, bei dem Gradientenindex-Linsen (sog. GRIN-Linsen) mittels integrierter Mikromanipulationssysteme relativ zu den Facetten vormontierter optischer Fasern ausgerichtet werden. In US 6 253 004 B1 wird eine Koppelstruktur zur Verbindung eines optoelektronischen Bauelements und einer Einmodenfaser beschrieben, mit dem die Positionierungstoleranz erhöht werden kann. Dabei kommen strahlformende Elemente, wie z.B. eine auf einer Rückseite eines GaAs-Wafers strukturierte Mikrolinse oder eine an ein Ende einer Einmodenfaser angebrachte Gradientenindex-Linse, zum Einsatz. Die hochgenaue Strukturierung der Mikrolinse auf der Rückseite des Wafers erfordert dabei besondere Herstellungsprozesse und ist zudem nur auf eine bestimmte Klasse von optoelektronischen Bauteilen anwendbar.

## Aufgabe der Erfindung

Ausgehend hiervon, besteht die Aufgabe der vorliegenden Erfindung darin, ein Verfahren und eine Vorrichtung bereitzustellen, welche die aufgeführten Nachteile und Einschränkungen des Standes der Technik zumindest teilweise überwinden.

Insbesondere soll ein Verfahren bereitgestellt werden, das es erlaubt, optische Komponenten, welche über dieselben oder unterschiedliche Modenfelddurchmesser verfügen können, in einem robusten und automatisierbaren Montageprozess mit möglichst geringen Verlusten optisch miteinander zu verbinden. Eine effiziente optische Verbindung soll dabei insbesondere auch für breitbandiges Licht, d.h. für Licht unterschiedlicher Wellenlängen, möglich sein. Der Montageprozess soll hierbei mit möglichst niedrigen Anforderungen an die Positionierungsgenauigkeit auskommen und dadurch soweit wie möglich auf passiven Positionierungsmethoden aufbauen können. Für eine effektive Montage soll die Zahl der mechanischen Freiheitsgrade im Montageprozess möglichst gering gehalten werden. In diesem Zusammenhang soll auch die Verwendung zusätzlicher diskreter optischer Elemente, wie z.B. Mikrolinsen, für die Anpassung unterschiedlicher Feldverteilungen in den Facetten der zu verbindenden optischen Komponenten vermieden werden. Zudem soll das Verfahren möglichst geringe Anforderungen an Genauigkeiten und Oberflächengüten beim Vereinzeln von optischen Chips vor der Montage stellen und universell auf eine Vielzahl verschiedener optischer Komponenten anwendbar sein.

## Offenbarung der Erfindung

Diese Aufgabe wird durch ein Verfahren zur Herstellung eines optischen Systems und ein optisches System mit den Merkmalen der unabhängigen Patentansprüche gelöst. Vorteilhafte Weiterbildungen, welche einzeln oder in beliebiger Kombination realisierbar sind, sind in den abhängigen Ansprüchen dargestellt.

Im Folgenden werden die Begriffe "haben", "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen, neben den durch diese Begriffe eingeführten Merkmalen, keine weiteren Merkmale vorhanden sind, oder auf Situationen, in welchen ein oder mehrere weitere Merkmale vorhanden sind. Beispielsweise kann sich der Ausdruck "A hat B", "A weist B auf", "A umfasst B" oder "A schließt B ein" sowohl auf die Situation beziehen, in welcher, abgesehen von B, kein weiteres Element in A vorhanden ist (d.h. auf eine Situation, in welcher A ausschließlich aus B besteht), als auch auf die Situation, in welcher, zusätzlich zu B, ein oder mehrere weitere Elemente in A vorhanden sind, beispielsweise Element C, Elemente C und D oder sogar weitere Elemente.

Weiterhin wird darauf hingewiesen, dass die Begriffe "mindestens ein" und "ein oder mehrere" sowie grammatikalische Abwandlungen dieser Begriffe, wenn diese in Zusammenhang mit einem oder mehreren Elementen oder Merkmalen verwendet werden und ausdrücken sollen, das das Element oder Merkmal einfach oder mehrfach vorgesehen sein kann, in der Regel lediglich einmalig verwendet werden, beispielsweise bei der erstmaligen Einführung des Merkmals oder Elementes. Bei einer nachfolgenden erneuten Erwähnung des Merkmals oder Elementes wird der entsprechende Begriff "mindestens ein" oder "ein oder mehrere" in der Regel nicht mehr verwendet, ohne Einschränkung der Möglichkeit, dass das Merkmal oder Element einfach oder mehrfach vorgesehen sein kann.

Weiterhin werden im Folgenden die Begriffe "vorzugsweise", "insbesondere", "beispielsweise" oder ähnliche Begriffe in Verbindung mit optionalen Merkmalen verwendet, ohne dass alternative Ausführungsformen hierdurch beschränkt werden. So sind Merkmale, welche durch diese Begriffe eingeleitet werden, optionale Merkmale, und es ist nicht beabsichtigt, durch diese Merkmale den Schutzumfang der Ansprüche und insbesondere der unabhängigen Ansprüche einzuschränken. So kann die Erfindung, wie der Fachmann erkennen wird, auch unter Verwendung anderer Ausgestaltungen durchgeführt werden. In ähnlicher Weise werden Merkmale, welche durch "in einer Ausführungsform der Erfindung" oder durch "in einem Ausführungsbeispiel der Erfindung" eingeleitet werden, als optionale Merkmale verstanden, ohne dass hierdurch alternative Ausgestaltungen oder der Schutzumfang der unabhängigen Ansprüche eingeschränkt werden soll. Weiterhin sollen durch diese einleitenden Ausdrücke sämtliche Möglichkeiten, die hierdurch eingeleiteten Merkmale mit anderen Merkmalen zu kombinieren, seien es optionale oder nicht-optionale Merkmale, unangetastet bleiben.

In einem ersten Aspekt betrifft die vorliegende Erfindung ein Verfahren zur Herstellung eines optischen Systems, welches über mindestens zwei gesonderte optische Komponenten und mindestens eine optische Verbindung zwischen den beiden optischen Komponenten verfügt. Wie bereits beschrieben, umfasst die optische Verbindung, welche auch als "optische Kopplung" bezeichnet werden kann, eine optisch leitfähige Einrichtung, welche dafür sorgt, dass Licht, vorzugsweise mit möglichst geringen Verlusten, zwischen einer ersten optischen Komponente und einer zweiten optischen Komponente, insbesondere von einer der optischen Komponente zu der zweiten optischen Komponente und/oder von der zweiten optischen Komponente zu der ersten optischen Komponente, übertragen werden kann. Eine Qualität der optischen Kopplung kann durch den Begriff "Kopplungseffizienz" angegeben werden, der einen Quotienten aus einer optischen Leistung, welche von einer empfangenden optischen Komponente empfangen wird, und der optischen Leistung, welche von einer abstrahlenden optischen Komponente abgestrahlt wird, bezeichnet, wobei sich - je nach Anordnung der optischen Komponenten im optischen System - die erste oder die zweite optische Komponente als empfangende oder als abstrahlende optische Komponente einsetzen lassen.

Das vorliegende Verfahren umfasst die folgenden Schritte, welche vorzugsweise in der angegebenen Reihenfolge, beginnend mit Schritt a) und endend mit Schritt d), durchgeführt werden, wobei ein oder mehrere, insbesondere aufeinanderfolgende Schritte, auch zumindest teilweise gleichzeitig ausgeführt werden können:

a) Bereitstellen mindestens einer ersten optischen Komponente und mindestens einer zweiten, gesonderten optischen Komponente, wobei die erste optische Komponente ein erstes Strahlprofil und die zweite optische Komponente ein zweites Strahlprofil aufweist;

b) Entwerfen des optischen Systems unter Festlegung einer Anordnung der ersten optischen Komponente und der zweiten optischen Komponente sowie von Form und Zielposition mindestens eines strahlformenden Elements, wobei das strahlformende Element fest mit der ersten optischen Komponente und/oder der zweiten optischen Komponente verbunden werden, wobei das strahlformende Element dazu eingerichtet ist, um das erste Strahlprofil und/oder das zweite Strahlprofil derart zu verändern, dass nach einer Positionierung der ersten optischen Komponente und der zweiten optischen Komponente eine optische Kopplung zwischen der ersten optischen Komponente und der zweiten optischen Komponente entsteht;

c) Herstellen des strahlformenden Elements mittels eines dreidimensional direktschreibenden Lithographieverfahrens in-situ an der Zielposition, wodurch eine um das strahlformende Element ergänzte optische Komponente erhalten wird; und

d) Positionieren und Fixieren der um das strahlformende Element ergänzten optischen Komponente auf einer gemeinsamen Grundplatte, wodurch das optische System erhalten wird.

Erfindungsgemäß werden zwei gesonderte strahlformende Elemente derart eingesetzt, dass die oben aufgeführten Schritte b) bis d) wie folgt ausgeführt werden:

b) Entwerfen des mikrooptischen Systems unter Festlegung einer Anordnung der ersten optischen Komponente und der zweiten optischen Komponente sowie von Form und Zielposition eines ersten strahlformenden Elements und eines zweiten strahlformenden Elements, wobei das erste strahlformende Element fest mit der ersten optischen Komponente und das zweite strahlformende Element fest mit der zweiten optischen Komponente verbunden werden, wobei das erste strahlformende Element dazu eingerichtet ist, um das erste Strahlprofil zu verändern, und das zweite strahlformende Element dazu eingerichtet ist, um das zweite Strahlprofil zu verändern, so dass nach einer Positionierung der ersten optischen Komponente und der zweiten optischen Komponente eine optische Kopplung zwischen der ersten optischen Komponente und der zweiten optischen Komponente entsteht;
c) Herstellung des ersten strahlformenden Elements und des zweiten strahlformenden Elements mittels eines dreidimensional direktschreibenden Lithographieverfahrens in-situ an den Zielpositionen der ersten mikrooptischen Komponente und der zweiten mikrooptischen Komponente, wodurch eine um das erste strahlformende Element ergänzte erste mikrooptische Komponente und eine um das zweite strahlformende Element ergänzte zweite mikrooptische Komponente erhalten werden; und
d) Positionieren und Fixieren der um das erste strahlformende Element ergänzten optischen Komponente und der um das zweite strahlformende Element ergänzten optischen Komponente auf einem gemeinsamen Substrat, wodurch das optische System erhalten wird.

Gemäß Schritt a) erfolgt eine Bereitstellung der zu verbindenden optischen Komponenten sowie die Bereitstellung von Informationen über die zugehörigen Strahlprofile der optischen Komponenten. Vorzugsweise wird hierzu jede der optischen Komponenten ausgewählt aus der Gruppe umfassend Einmoden- oder Mehrmodenfasern aus organischen oder anorganischen Materialien, halbleiterbasierte integriert-optische Chips wie z.B. Laser, Fotodioden, Superlumineszenz-Dioden oder Siliziumphotonik-Chips oder andere integriert-optische Chips auf Basis von Halbleitern oder dielektrischen Materialien wie z.B. Gläsern, Silizium-Dioxid, Silizium-Nitrid oder Polymeren, optische Leiterplatten, oder Elemente für die Freistrahl-Optik wie z.B. Linsen, Strahlteiler, Isolatoren, Spiegel oder Beugungsgitter. Die optischen Komponenten können optischen Wellenleiter mit geringem Indexkontrast (z.B. Glas-basierte optische Wellenleiter) oder mit mittlerem bzw. hohem Indexkontrast (z.B. halbleiterbasierte Wellenleiter) aufweisen. Die Ein- bzw. Auskopplung von Licht kann an der Kante einer optischen Komponente erfolgen, beispielsweise bei kantenemittierenden Laser oder wellenleiterbasierten Systemen mit entsprechenden Facetten an der Chipkante, oder auf der Oberfläche, beispielsweise bei oberflächenemittierenden Lasern (Vertical Cavity Surface Emitting Lasers, VCSEL), bei oberflächenbeleuchteten Photodioden, oder bei wellenleiterbasierten Chips mit entsprechenden Koppelstrukturen (z.B. Gitterkoppler, Umlenkspiegel). Informationen über die entsprechenden Strahlprofile können aus Design-Daten der Bauteile abgeleitet und/oder mit einem handelsüblichen Gerät für die (Laser-)Strahldiagnostik (sog. "Beam Profiler") messtechnisch während oder im Vorfeld des Montageprozesses gewonnen werden. Messtechnische Verfahren bieten sich besonders dann an, wenn bauteilspezifische Abweichungen der Form und Position des Strahlprofils individuell erfasst und zum Entwurf der strahlformenden Elemente in Schritt b) verwendet werden sollen. Auf diese Weise wird es möglich, anderweitig schwer zu vermeidende fertigungsbedingte Toleranzen der optischen Komponenten durch eine entsprechende Ausgestaltung der strahlformenden Elemente zu kompensieren.

Gemäß Schritt b) erfolgt ein Entwurf des umzusetzenden optischen Systems, welcher sowohl die Zielpositionen der zu verbindenden optischen Komponenten als auch die Planung der dreidimensionalen Form der zugehörigen strahlformenden Elemente sowie ihrer Zielposition relativ zur jeweiligen optischen Komponente umfasst. In vielen Fällen liegt bereits ein erster Entwurf des Systems vor, der zumindest die Anordnung und die groben Zielpositionen der zu verbindenden optischen Komponenten enthält, so dass lediglich eine etwaige Anpassung dieser Zielpositionen an individuelle Besonderheiten, wie z.B. fertigungsbedingte Toleranzen der optischen Komponenten, in Betracht gezogen werden kann. Die Zielposition kann dabei sowohl eine laterale Position in der Grundplattenebene als auch eine die vertikale Position senkrecht zur Grundplattenebene aufweisen. In einer besonderen Ausgestaltung kann die Festlegung der Zielposition auch dadurch erfolgen, dass, insbesondere für den Fall eines wohl kollimierten Lichtstrahls, die Zielposition entlang der Ausbreitungsrichtung des kollimierten Strahls über einen bestimmten Bereich wählbar festgelegt werden kann.

Die Positionierung der zu verbindenden optischen Elemente kann vorzugsweise derart erfolgen, dass die optischen Achsen der Strahlprofile kollinear zueinander ausgerichtet sind, so dass sich die Facetten zweier optischer Komponenten gegenüberliegen. In diesem Fall wird durch die strahlformenden Elemente bevorzugt lediglich eine Anpassung der Modenfelder vorgenommen werden. Alternativ kann die Positionierung so erfolgen, dass die Achsen der Strahlprofile in einer gemeinsamen Ebene liegen, aber nicht kollinear zueinander sind. In diesem Fall werden die strahlformenden Elemente neben einer Anpassung der Modenfelder vorzugsweise auch eine Anpassung der Ausbreitungsrichtung der modifizierten Strahlprofile bewirken. Die Achsen der unmodifizierten Strahlprofile können dabei einen beliebigen Winkel einschließen. Um bei der Erzeugung der strahlformenden Elemente den bekannten Effekt der internen Totalreflexion zu nutzen, können insbesondere auch von 90° abweichende Winkel verwendet werden, wodurch ein hinreichend flaches Auftreffen von Licht auf die totalreflektierende Oberfläche ermöglicht werden kann.

Während Schritt b) erfolgt weiterhin ein Entwurf des mindestens einen strahlformenden Elements, welches die Strahlprofile der zu verbindenden optischen Komponenten derart beeinflusst, dass für gegebene mechanische Toleranzen eine verlustarme Kopplung zwischen den optischen Komponenten möglich ist. Ziel ist die Herstellung einer optischen Kopplung mit geringen Verlusten, welche eine für das verwendete Montagesystem hinreichend große Positionierungstoleranz aufweist. Hierbei ist in vielen Fällen zwischen einer Toleranz der rotatorischen Ausrichtungsgenauigkeit und einer Toleranz der translatorischen Positionierungsgenauigkeit abzuwägen: Eine Erhöhung der Toleranz der translatorischen Positionierungsgenauigkeit kann üblicherweise mit einer Aufweitung des Modenfelddurchmessers einhergehen, die zu einer Verringerung der Strahldivergenz und damit zu einer reduzierten Toleranz der rotatorischen Ausrichtungsgenauigkeit führt. Falls erforderlich, können durch einen geeigneten Entwurf des strahlformenden Elements zusätzlich herstellungsspezifische individuelle Variationen der Form und Position von Modenfeldern in den optischen Komponenten kompensiert werden.

Um die Kopplungsverluste weiter zu verringern, kann es vorteilhaft sein, eine spätere Einbettung in ein optisch transparentes Einbettungsmedium mit einem von den strahlformenden Elementen abweichenden Brechungsindex vorzusehen und im Entwurf des umzusetzenden Gesamtsystems zu berücksichtigen. Dies kann zu einer geänderten Form und Anzahl der strahlformenden Elemente führen.

Zur Strahlformung können Elemente zum Einsatz kommen, die zumindest teilweise aus einem optisch transparenten Bereich bestehen können, der unmittelbar an die Facette des jeweiligen Bauteils anschließen kann und bei einem gegebenen Modenfelddurchmesser zu einem kleineren Divergenzwinkel des aus der Facette austretenden Strahlenbündels führen kann. Im Falle von optischen Verbindungen mit hoher Leistung kann es dagegen vorteilhaft sein, die strahlformenden Elemente an denjenigen Stellen zu strukturieren, an denen sich das Modenfeld durch Propagation in Freiraum bereits aufgeweitet haben kann, so dass die Leistungsdichte im Bereich der strahlformenden Elementen gering bleibt. Zum Entwurf des mindestens einen strahlformenden Elements können Simulationen durchgeführt werden. In einer bevorzugten Ausführungsform ist die optische Verbindung so gestaltet, dass die durch das strahlformende Element oder die strahlformenden Elemente modifizierten Strahlprofile der zu verbindenden optischen Elemente einen großen Strahldurchmesser mit geringer Divergenz aufweisen. Die Größe des Modenfelddurchmessers nimmt hierbei bei einer Wellenlänge von 1.55 $\mu$m einen Wert von 5 $\mu$m bis 100 $\mu$m an, besonders bevorzugt von 10 $\mu$m bis 80 $\mu$m, insbesondere von 15 $\mu$m bis 50 $\mu$m. Das strahlformende Element kann aus einem oder mehreren Teilen bestehen, die in einem oder mehreren Arbeitsschritten mittels eines dreidimensional direktschreibenden Lithographieverfahrens mit hoher Präzision im lokalen Koordinatensystem der jeweiligen Komponente erzeugt werden.

In einer bevorzugten Ausführungsform kann der Strahlengang der optischen Verbindung insbesondere folgende Abschnitte aufweisen:

(i) Einen strahlaufweitenden Abschnitt, welcher sich dadurch auszeichnet, dass in diesem Abschnitt der Strahldurchmesser zunimmt. Der strahlaufweitende Abschnitt kann die natürliche Divergenz des aus dem optischen Element austretenden Lichtfeldes nutzen und/oder das Lichtfeld durch ein Teilelement des strahlformenden Elements modifizieren. Die Divergenz kann insbesondere mittels konkaven Linsen, konvexen Spiegeln oder diffraktiven Elementen vergrößert werden, welche mit einem Verfahren zur 3D-Strukturierung, z.B. mit Zweiphotonen-Lithographie, hergestellt werden können. Eine weitere Möglichkeit zur Aufweitung kann in der Herstellung einer wellenleitenden Struktur bestehen, welche den Modenfelddurchmesser zunächst verkleinert. Bei anschließender Propagation des Strahls außerhalb der optischen Komponente im freien Raum kann sich eine hohe Divergenz ergeben. Die Divergenz des Lichtstrahls im strahlaufweitenden Abschnitt und/oder einer fiktiven Fortsetzung des Lichtstrahls in ein Fernfeld kann bevorzugt höchstens 6°, besonders bevorzugt höchstens 15°, insbesondere höchstens 30° betragen, jeweils definiert als halber Öffnungswinkel bezogen auf eine Intensität von 13,5% der maximalen Intensität.

(ii) Einen kollimierten Abschnitt, welcher sich dadurch auszeichnet, dass sich in diesem Abschnitt der Strahldurchmesser nur geringfügig ändert. In einem Übergangsbereich zwischen dem strahlaufweitendem Abschnitt und dem kollimierten, aufgeweiteten Abschnitt kann vorzugsweise ein kollimierendes optisches Element eingesetzt werden, beispielsweise ein konkaver Spiegel oder eine konvexe Linse. Hierbei kann sich beispielsweise eine Strahltaille ausbilden. Die "Strahltaille" kann sich dabei an einer Position eines Gauß'schen oder gaußähnlichen Strahls befinden, an dem eine im Wesentlichen ebene Phasenfront auftritt. Die Größe der Strahltaille, d.h. der Taillendurchmesser, kann dabei bei einer Wellenlänge von 1550 nm bevorzugt einen Wert von 5 $\mu$m bis 100 $\mu$m, besonders bevorzugt von 10 $\mu$m bis 80 $\mu$m, insbesondere von 15 $\mu$m bis 50 $\mu$m annehmen. Die zughörige Strahldivergenz bezogen auf den halben Öffnungswinkel ergibt sich aus einschlägigen Formeln für Gauß'sche Strahlen und beträgt bevorzugt höchstens 12°, besonders bevorzugt höchstens 6°, insbesondere höchstens 4°. Bei Wellenlängen oberhalb oder unterhalb von 1550 nm können sich diese Werte entsprechend ändern. Vorzugsweise entspricht hierbei die durch das erste strahlformende Element erzeugte Feldverteilung möglichst gut derjenigen Feldverteilung, die von der zweiten strahlformenden Komponente mit maximaler Effizienz in die zweite optische Komponente eingekoppelt wird. (iii) Einen strahlverengenden Abschnitt, welcher sich dadurch auszeichnet, dass hier der Strahldurchmesser wieder abnimmt. Die Ausgestaltung des strahlverengenden Abschnittes kann hierbei analog zu den Maßnahmen erfolgen, welche in Abschnitt (i) beschrieben werden.

Nach dem Entwurf der strahlformenden Elemente kann vorzugsweise eine Überführung der Elemente in einen maschinenlesbaren Datensatz für eine nachfolgende Fertigung gemäß Schritt c) erfolgen. Die Überführung in ein maschinenlesbares Format könnte beispielsweise in der Überführung in das STL-Format bestehen. Das STL-Format (engl. *Standard Tessellation Language*) stellt eine Standardschnittstelle vieler CAD-Systeme dar und ist dazu eingerichtet, geometrische Informationen dreidimensionaler Datenmodelle für die Fertigung bereitzustellen. Andere Arten von maschinenlesbaren Formaten sind jedoch ebenfalls möglich.

Gemäß Schritt c) erfolgt eine Herstellung der strahlformenden Elemente mit Hilfe eines dreidimensional direktschreibenden Lithographieverfahrens in-situ an der Zielposition. Hierbei bezeichnet der verwendete Begriff des "dreidimensional direktschreibenden Lithographieverfahrens" ein Mikrostrukturierungsverfahren, mit dem es möglich ist, ein oder mehrere Materialien gemäß eines angegebenen dreidimensionalen Musters oder Layouts in additiver oder subtraktiver Weise zu strukturieren oder abzulagern. Damit lassen sich dreidimensionale Strukturen mit einer Genauigkeit von bevorzugt besser als 1000 nm, besonders bevorzugt besser als 500 nm, und ganz besonders bevorzugt besser als 100 nm erzeugen, wobei der Begriff "dreidimensional" eine mögliche Formgebung der Strukturen in ein, zwei oder drei Raumrichtungen bezeichnet. Die Auflösung des dreidimensional direktschreibenden Lithographieverfahrens kann hierbei bevorzugt besser als 10 $\mu$m, besonders bevorzugt besser als 2 $\mu$m, und ganz besonders bevorzugt besser als 1 $\mu$m, sein, wobei sich der Begriff "Auflösung" auf die größte Ausdehnung des kleinsten mit dem Verfahren herstellbaren Strukturelements bezieht. Das dreidimensionaldirektschreibende Lithographieverfahren kann bevorzugt so ausgelegt sein, dass es unter normalen atmosphärischen Umgebungsbedingungen durchgeführt werden kann und kein Vakuum benötigt wird. Insbesondere eignen sich additive oder subtraktive dreidimensional direktschreibende Lithographieverfahren, die es erlauben, Materialien mit einer Rate von bevorzugt mehr als 50 $\mu$m$^3$/s, mehr bevorzugt von mehr als 500 $\mu$m$^3$/s, besonders bevorzugt von mehr als 1000 $\mu$m$^3$/s, und ganz besonders bevorzugt von mehr als 10 000 $\mu$m$^3$/s abzulagern bzw. zu entfernen. In einer besonders bevorzugten Ausgestaltung kann das dreidimensional direktschreibende Lithographieverfahren ausgewählt sein aus einem direktschreibenden Lithographieverfahren und aus Zwei-Photonen-Lithographie.

Der Begriff "in-situ" beschreibt hierbei ein Vorgehen, welches sich dadurch auszeichnet, dass die strahlformenden Elemente direkt an der vorgesehenen Zielposition, insbesondere direkt an einer Bauteilfacette oder an einer der optischen Komponenten befindlichen Haltestrukturen, erzeugt werden. Somit kann sich das so erzeugte strahlformende Element bevorzugt direkt an die zugehörige optische Komponente anschließen und kann daher direkt mit der optischen Komponente verbunden oder in einer unmittelbaren Umgebung der optischen Komponente angeordnet sein. Wie unten näher ausgeführt, kann hierzu das strahlformende Element ein durch Beleuchtung strukturierbares Material umfassen. Damit unterscheidet sich das vorliegende Verfahren von aus dem Stand der Technik bekannten Prozessen, in welchen ein oder mehrere strahlformende Elemente an einer Stelle außerhalb der Zielposition hergestellt und erst hieran anschließend an die gewünschte Zielposition eingefügt werden. Nachteilig an diesen Prozessen ist jedoch insbesondere, dass in einem zugehörigen Montageprozess sehr hohe Anforderungen an die Positionierung der zuvor hergestellten strahlformenden Elemente gestellt werden müssen, so dass in der Regel aktive Positionierungsmethoden erforderlich sind.

Bei Anwendung der Zwei-Photonen Lithographie wird im Brennpunkt (Fokus) eines gepulsten Lasers hoher Spitzenintensität eine Absorption von zwei Photonen herbeigeführt, welche eine chemische Veränderung eines üblicherweise als Fotolack (engl. *resist*) bezeichneten photochemisch strukturierbaren Materials bewirkt. Durch Belichten der gewünschten Struktur kann dadurch eine Aushärtung der gewünschten Struktur bewirkt werden. Ein nicht-belichteter Anteil des Fotolacks kann in einen weiteren Schritt, welcher auch als Entwicklungsschritt bezeichnet wird, insbesondere durch Wegspülen des unbelichteten Materials, entfernt werden, so dass nur die gewünschte, belichtete Struktur übrig bleibt. Das Verfahren kann auch so ausgestaltet sein, dass nur die belichtete Struktur aufgelöst wird und der verbleibende Rest in einem nachfolgenden Entwicklungsschritt erhalten bleibt, wofür ein geeignetes Resistmaterial verwendet wird. Durch das beschriebene Herstellungsverfahren lassen sich Strukturen mit beliebiger Form herstellen. Insbesondere können Strukturen hergestellt werden, welche dazu eingerichtet sind, um den Modenfelddurchmesser von Lichtstrahlen in nahezu beliebiger Weise zu beeinflussen (modifizieren), welche hier als strahlformende Elemente bezeichnet werden.

In einer bevorzugten Ausgestaltung auf Basis von direktschreibender Laserlithographie könnte hierbei zunächst eine Einteilung des herzustellenden strahlformende Elements in Ebenen erfolgen, wobei die Ebenen in bevorzugt einem Abstand von 20 nm bis 500 nm, besonders bevorzugt von 40 nm bis 200 nm, insbesondere von 50 nm und 150 nm, zueinander angeordnet sein können. Die Ebenen können insbesondere durch Linien beschrieben werden, welche einen Abstand von bevorzugt 20 nm bis 500 nm, besonders bevorzugt von 40 nm bis 200 nm, insbesondere von 50 nm bis 150 nm, aufweisen. Enden und Anfänge der Linien können in einem Datensatz durch kartesische Koordinaten beschrieben werden. Andere Darstellungsweisen sind jedoch möglich, etwa auf Basis zylindrischer Koordinatensysteme. Ein dreidimensional-direktschreibendes LaserLithographie-System kann die entsprechenden Linien abrastern und auf diese Weise eine dreidimensionale Struktur herstellen. Alternativ können Schreibstrategien angewandt werden, welche an die Form der optischen Komponenten angepasst sind, und bei denen beispielsweise Schreiblinien bevorzugt parallel zur Oberfläche geführt werden die Bildung von stufenförmigen Strukturen auf der Oberfläche des strahlformenden Elements zu verhindern.

In einer besonders bevorzugten Ausgestaltung kann das strahlformende Element homogen ausgeführt sein und somit nur ein einziges Element aus einem einzigen Material umfassen, welches in direktem Kontakt mit der optischen Komponente oder einer unten näher beschriebenen zusätzlichen Haltestruktur steht und mit dieser fest verbunden sein kann. Damit kann es verzichtbar sein, ein Verbindungsmittel, insbesondere ein Klebstoff oder ein Adhäsiv, einzusetzen, um gesondert hergestellte oder bereitgestellte Elemente miteinander zu verbinden. Auf diese Weise lässt sich das Herstellungsverfahren für optische Systeme gegenüber einer Anwendung von aus dem Stand der Technik bekannten Prozessen weiter vereinfachen.

Schritt c) kann unter Verwendung eines direktschreibenden Laser-Lithographieverfahrens insbesondere wie folgt ausgeführt werden:

(α) Montage der optischen Komponenten im Lithographie-System und Vermessung ihrer Position relativ zum Koordinatensystem des Lithographie-Systems. Hierzu können insbesondere Justiermarken auf der Chipoberfläche verwendet werden, die gemeinsam mit den auf dem Chip befindlichen optischen Komponenten erzeugt wurden und daher präzise in Bezug zu den optischen Komponenten ausgerichtet sein können. Als Justiermarker können hierbei auch typischerweise bereits vorhandene, einen weiteren Zweck erfüllende Strukturen, wie z.B. ein optisch anzubindender Wellenleiter oder eine Koppelstruktur, dienen. Die Erfassung der Justiermarken kann beispielsweise über eine kamerabasiertes Verfahren oder ein anderes bildgebendes Verfahren erfolgen. Für eine Erfassung der Justiermarken in drei Positionen können beispielsweise auch konfokale bildgebende Verfahren verwendet werden. Es ist insbesondere möglich, Teile des optischen Strahlenganges des Lithographie-Systems sowohl zur Erfassung der Justiermarken als auch zur Belichtung der herzustellenden strahlformenden Elemente zu verwenden.

(β) Herstellung der in Schritt b) entworfenen strahlformenden Elemente im lokalen Koordinatensystem der optischen Komponenten: Die strahlformenden Elemente sind dabei fest mit den jeweiligen zugehörigen optischen Elementen verbunden. Die Positioniergenauigkeit mit der die strahlformenden Komponenten auf den optischen Komponenten realisiert werden können, kann dabei bevorzugt besser als 500 nm, besonders bevorzugt besser als 200 nm, insbesondere besser als 100 nm sein. Zur Erzielung dieser Positioniergenauigkeit können Justiermarken verwendet werden, die auf den optischen Komponenten und angebracht sind und deren Relativposition bzgl. der Wellenleiterfacetten der optischen Komponenten sehr genau bekannt ist, wobei die Genauigkeit bevorzugt besser als 300 nm, besonders bevorzugt besser als 150 nm, insbesondere besser als 70 nm ist. Diese Justiermarken können während des Lithographie-Schrittes mit hoher Genauigkeit erfasst werden, wobei Abweichungen Genauigkeit bevorzugt kleiner als 500 nm, besonders bevorzugt kleiner als 200 nm, insbesondere kleiner als 100 nm. Die Herstellung der strahlformenden Elemente kann direkt an oder auf den optischen Komponenten erfolgen. Alternativ kann die Herstellung der strahlformenden Elemente auch an oder auf einer Halterung erfolgen, welche fest mit den optischen Komponenten verbunden sein kann. Insbesondere kann es sich bei der Halterung auch um eine mit einem Strukturierungsverfahren für dreidimensionale Strukturen, insbesondere Zwei-Photonen Lithographie, hergestellte Struktur handeln. Die Herstellung der Halterung kann im selben Verfahrensschritt wie die Herstellung der strahlformenden Elemente erfolgen.

Die Ausgestaltung von Schritt c) kann optional eine Vorbereitung der zu verbindenden optischen Komponenten vorsehen, welche beispielsweise eine geeignete Oberflächenmodifikation durch einen Haftvermittler oder ein Aufbringen von Halterungen mit verankernder Wirkung enthält.

In einer optionalen Ausgestaltung kann hierbei mindestens eine der optischen Komponenten eine Haltestruktur aufweisen, insbesondere eine als Abstandhalter ausgeführte Haltestruktur, welcher vorzugsweise in Form einer festen Grundplatte, als Oberflächenbeschichtung und/oder als Funktionalisierung der Oberfläche ausgeführt ist. Alternativ oder zusätzlich kann die Haltestruktur auch durch ein lithographisches Verfahren hergestellt werden, welches vorzugsweise in demselben Verfahrensschritt, welcher auch die Herstellung des strahlformenden Elements umfasst, erfolgen kann. Die Verwendung des Abstandhalters und/oder von strahlformenden Elementen, welche direkt über eine Haltestruktur verfügen können, kann insbesondere vorteilhaft sein, um die strahlformenden Elemente von der mindestens einen optischen Komponente räumlich zu trennen, wodurch sich eine beim Schreiben der strahlformenden Elemente durch den Lithographiestrahl hervorgerufene Beschädigung der optischen Komponente vermeiden lässt. Zudem lassen sich hierdurch Wechselwirkungen zwischen der optischen Komponente und einem Lithographie-Laserstrahl, die zu einer Beeinträchtigung der Ergebnisse aus der Lithographie führen können, etwa durch Abschattung oder Mikroexplosionen in der Nähe von metallischen Bauteilen, weitgehend verhindern. Weiterhin verringert sich die auf das strahlformende Element auftreffende Intensität durch mit zunehmendem Abstand des Elements von der Facette des optischen Elements, so dass eine Beabstandung auch zu einer erhöhten Stabilität in Beug auf eine hohe optische Leistungen führen kann.

Weiterhin kann eine Zwischenschicht zwischen einer der optischen Komponenten und einem zugehörigen strahlformenden Element aufgebracht werden, wobei die Zwischenschicht als Haltestruktur und/oder als Haftvermittler dienen kann. Hierbei kann eine reflexionsmindernde Beschichtung auf mindestens eine Oberfläche der strahlformenden Elemente aufgebracht werden. Alternativ oder zusätzlich können auch Zwischenräume zwischen den strahlformenden Elementen zumindest teilweise mit einem optisch transparenten Material aufgefüllt werden, wobei das optisch transparente Material insbesondere dazu eingerichtet sein kann, Reflexionsverluste zwischen den strahlformenden Elementen und/oder eine chromatische Aberration eines die strahlformenden Elementen durchlaufenden Lichtstrahls zu verringern.

Generell kann die Vorbereitung der optischen Komponenten durch eine Strukturierung mit einem Lithographieverfahren, wofür insbesondere die Zwei-Photonen Lithographie ausgewählt werden kann, erfolgen. Die Vorbereitung der zu verbindenden optischen Komponenten kann auch Schritte umfassen, welche die Kompatibilität zu einem anschließenden Herstellungsprozess erhöht. Dies kann vorzugsweise ein Beschichten der optischen Komponenten mit Materialien erfolgen, welche eine chemische Kompatibilität erhöhen, Reflexionen verringern und/oder die Haftung verbessern.

Schritt d) sieht die Positionierung und Fixierung der um das mindestens eine strahlformende Element ergänzten optischen Komponente auf einer gemeinsamen Grundplatte an einer dafür vorgesehenen Zielposition vor. In der oben beschriebenen, besonders bevorzugten Ausgestaltung erfolgt während Schritt d) somit die Positionierung und Fixierung der um die beiden strahlformenden Elemente ergänzten optischen Komponente auf der gemeinsamen Grundplatte an den dafür vorgesehenen Zielpositionen vor. Eine gesonderte Positionierung der strahlformenden Elemente ist gemäß dem vorliegenden Verfahren somit nicht erforderlich, da sich die strahlformenden Elemente nach Schritt c) bereits an der Zielposition befinden. Die gemeinsame Grundplatte kann hierbei in Form einer einzelnen Grundplatte ausgeführt sein, auf welche die genannten optischen Elemente positioniert und fixiert werden können. Alternativ kann die Grundplatte jedoch auch als feste Verbindung mehrerer Einzelgrundplatten ausgeführt sein. Hierbei kann insbesondere auch eine weitere optische Komponente oder eine elektrische Komponente als Grundplatte für die Positionierung und Fixierung mindestens der optischen Komponenten dienen.

Die Positionierung der um das strahlformende Elemente ergänzten optischen Komponente kann vorzugsweise derart erfolgen, dass hierbei die verwendeten strahlformenden Elemente in Bezug auf die jeweils zugehörigen optischen Komponenten mit einer Genauigkeit von bevorzugt besser als 5 μm, besonders bevorzugt besser als 2 μm, insbesondere besser als 1 μm positioniert werden können.

Zur Positionierung und Fixierung der um das strahlformende Element ergänzten optischen Komponente können sowohl passive als auch aktive Verfahren für die Positionierung zum Einsatz kommen. Als Verfahren zum Fixieren kann hierbei bevorzugt eines der folgenden Verfahren dienen: Kleben, Ultraschall-Bonden, Löten, Stecken, Klemmen, Schrauben, Ansprengen, Kaltverschweißen, Verschweißen, Legen, Verbinden durch elektrostatische und/oder magnetische Kräfte, etwa durch Dispersionskräfte oder durch Strukturen, welche Gecko-Füße imitieren. Durch eine entsprechende Ausgestaltung der strahlformenden Elemente kann dabei bevorzugt mit Toleranzen von mehr als 500 nm, besonders bevorzugt mit Toleranzen von mehr als 2 μm, insbesondere mit Toleranzen von mehr als 5 μm gearbeitet werden. Für die vertikale Positionierung der optischen Komponenten ist je nach eingesetzter Positionierungstechnik unter Umständen die Verwendung von geeigneten, beispielsweise gestuften Grundplatten für die richtige Höhenjustierung vorteilhaft. Die laterale Positionierung der zu verbindenden optischen Elemente kann beispielsweise durch ein kamerabasiertes Verfahren sehr präzise ausgeführt werden.

In einer weiteren optionalen Ausgestaltung kann eine Einbettung der optischen Komponenten und der strahlformenden Elemente in ein Einbettungsmedium erfolgen. Bei dem Einbettungsmedium kann es sich beispielsweise um ein transparentes, vorzugsweise bei Beaufschlagung mit ultravioletter Strahlung aushärtendes Medium handeln. Das Einbettungsmedium kann die optischen Bauteile, d.h. die optischen Komponenten und die strahlformenden Elemente, vor Umwelteinflüssen schützen und/oder optischen Verluste durch Reflexion reduzieren. Vorzugsweise wird die nachfolgende Einbettung der optischen Bauteile in den vorherigen Schritten, insbesondere der oben beschriebenen Simulation, berücksichtigt. Insbesondere können die die strahlformenden Komponenten auch in einen Einbettungsmedium hergestellt werden. Hierbei würde ein Verfahren verwendet werden, welches entweder den Brechungsindex eines vorzugsweise festen Mediums bei Einwirkung eines Lithographie-Mechanismus erhöht oder verringert.

In vorteilhafter Weise kann es das erfindungsgemäße Verfahren erlauben, mehrere strahlformende Elemente, insbesondere mehrere optische Flächen, zu kaskadieren. Auf diese Weise kann eine Anzahl an Freiheitsgraden für die technische Auslegung der optischen Verbindung erhöht werden. Dies kann insbesondere ein Überführen eines nichtrotationssymmetrischen Strahlprofils in ein symmetrisches Strahlprofil mit strahlformenden Elementen, die sich an einem beliebigen Ort entlang der optischen Achse des Lichtstrahls befinden können, ermöglichen. Weitere Anwendungen eine Kaskade von optischen Flächen sind jedoch denkbar.

In einer weiteren Ausgestaltung können durch die Verwendung von 3D-Freiformoptiken mit typischerweise mehreren optischen Flächen Rückreflexionen in lichtemittierende Bauteile wir Laser oder SLED vermieden werden, beispielsweise, indem reflektierende Oberflächen der strahlformenden Elemente entsprechend geneigt werden.

Ein Effekt, welcher aus der Aufweitung und Kollimation des Lichtstrahls resultieren kann, ist die Herabsetzung der Anforderungen an die Positioniergenauigkeit in axialer Richtung des sich ausbreitenden Lichtstrahls. Die tolerierbaren Positionsabweichungen in axialer Richtung liegen bei einem geeignet kollimierten Lichtstrahl um Größenordnungen über den Positionierungstoleranzen transversal zum Lichtstrahl.

Durch Vergrößerung und Kollimation des Strahlprofils zwischen verschiedenen optischen Bauteilen kann sich weiterhin ein Strahl ergeben, welcher über längere Strecken mit relativ zum Strahldurchmesser geringer Aufweitung propagieren kann. In einer besonderen Ausgestaltung kann dadurch ein Einbringen von zusätzlichen optischen Bauteilen innerhalb der Koppelstrecke erfolgen. Bei den zusätzlichen optischen Bauteilen kann es sich vorzugsweise um Bauteile handeln, die sich auf optischen Chips nur schwer herstellen lassen, insbesondere optische Dünnschicht-Filter, Polarisatoren, Strahlteiler, Wellenplatten oder nicht-reziproke Bauteile wie Faraday-Rotatoren oder Isolatoren.

Durch ein Aufweiten des Strahlprofils können zwar die Anforderungen an die Positionierungsgenauigkeit der Bauteile herabgesetzt werden, gleichzeitig erhöhen sich aber in der Regel die Anforderungen an die Genauigkeit, mit welcher die Orientierung der Bauteile zueinander ausgerichtet wird. Dies lässt sich an einem einfachen Beispiel eines Gauß-Strahles durch die Abhängigkeit des Taillendurchmessers vom Divergenzwinkel verdeutlichen. Eine verringerte Empfindlichkeit gengenüber translatorischen Positionierungsfehlern lässt sich oft nur mit einer erhöhten Empfindlichkeit gegenüber rotatorischen Fehlern in der Ausrichtung der Bauteile erkaufen. In einer besonderen Ausführungsform des Verfahrens wird dieser Zielkonflikt beim Entwurf der strahlformenden Elemente berücksichtigt und damit ein optimaler Ausgleich zwischen translatorischen und rotatorischen Genauigkeitsanforderungen erreicht.

Durch die Einbettung einer oder mehrerer optischer Bauteile in ein optisch dichtes Medium kann eine Verringerung der Strahldivergenz im Innern des Mediums im Vergleich zur Ausbreitung im Freiraum herbeigeführt werden. Dieser Effekt ähnelt dem eines Immersionsmikroskops, welches durch ein Immersionsmedium, dass die Probe einbettet und einen höheren Brechungsindex als 1 aufweist, eine höhere Auflösung erzielt. Das Immersionsmedium kann flüssig oder fest sein. In einer weiteren Ausgestaltung der Erfindung lässt sich dieser Effekt nutzen, indem das strahlformende Element direkt an die Facette einer optischen Komponente angeschlossen wird. Diese Ausgestaltung ist insbesondere bei optischen Bauteilen wünschenswert, die von sich aus mit einer derart hohen Divergenz abstrahlen, dass eine Kollimation mit einem von der Facette beabstandeten strahlformenden Element nur schwer möglich oder aufgrund eines optischen Grenzwinkels nicht zu erreichen ist. Dies ist beispielsweise bei der optischen Kopplung an die Stirnfläche eines Silizium-auf-Isolator-Nanowellenleiters der Fall, die bei einer Wellenlänge von 1.55 $\mu$m oftmals Modenfelddurchmesser von in der Größenordnung von ca. 1 $\mu$m aufweisen und damit entsprechend hohe Divergenzwinkel besitzen.

Die beschriebene Aufweitung und Kollimation des Lichtstrahls setzt zwar die Anforderungen an die relative Positioniergenauigkeit zwischen den um die strahlformenden Elemente ergänzten optischen Komponenten herab, erfordert dafür aber eine sehr präzise Positionierung der strahlformenden Elemente relativ zur jeweils zugehörigen optischen Komponente. Aufgrund der beschriebenen hohen Ausrichtungsgenauigkeit von in-situ, vorzugsweise mit Zwei-Photonen Lithographie hergestellten, Freiformoptiken stellt dieser Umstand jedoch kein Problem dar. Die Herstellung von strahlformenden Elementen mittels Zwei-Photonen Lithographie ermöglicht ein sehr genaues Ausrichten von 3D-Freiformoptiken zu bestehenden optischen Komponenten mit einer Ausrichtgenauigkeit deutlich unterhalb von 100 nm. Typischerweise kann das Lithographie-System mit einer konfokalen Scaneinheit ausgestattet sein, welche den Laser für die Lithographie gelichzeitig auch als Lichtquelle für die Erfassung von Justiermarken auf den optischen Komponenten einsetzen kann. Ist ein systematischer Fehler in der Beleuchtungsoptik vorhanden, so kann davon ausgegangen werden, dass sich dieser gleichermaßen auf die Positionsmessung der optischen Komponenten als auch auf die Strukturierung der strahlformenden Elemente auswirkt. Systematische Fehler bei der Positionsmessung werden daher kompensiert, was die Positionierungsgenauigkeit weiter erhöht. Wird eine Kamera für die Positionsmessung verwendet, so wird auch zu einem Großteil der gleiche optische Pfad wie für die Lithographie verwendet, sodass sich auch hier systematische Abweichungen zumindest teilweise kompensieren.

Eine Strukturierung von 3D-Freiformoptiken direkt auf die optischen Komponenten geht mit verschiedenen Problemen bezüglich der Wechselwirkung des für das Lithographieverfahren verwendeten Lichtstrahls und der jeweiligen optischen Komponente einher. Wechselwirkung ist dabei sowohl als gegenseitiges Einwirken des Laserstrahls auf die optischen Komponenten als auch auf eine umgekehrte Wirkung sowie auf nur eine der beiden Wirkungsrichtungen zu verstehen. Insbesondere können Probleme bei der Herstellung der strahlformenden Elemente auf optische Komponenten mit hoher Reflexion, scharfen Kanten und/oder mit metallischem Charakter auftreten. Hierbei kommt es bei der Herstellung von Strukturen mittels Zwei-Photonen Lithographie oftmals zu Mikroexplosionen, welche sich durch Defekte, Mikro- und/oder Makroblasenbildung äußern können. Weiterhin können es je nach Oberflächenbeschaffenheit zusätzlich Haftprobleme auftreten. Diese Effekte können eine zuverlässige Beschreibung entsprechender optischer Bauteile erschweren oder verhindern.

Eine mögliche Lösung für die zuvor genannten Probleme kann in einer Anpassung der Herstellungsparameter liegen. Vorzugsweise kann die Leistung des Lithographie-Systems in einer unmittelbaren Umgebung des zu beschreibenden strahlformenden Elements reduziert werden, falls es zu Mikroexplosionen kommt, oder erhöht werden, falls Haftungsprobleme auftreten. Eine solche Anpassung kann jedoch üblicherweise komponentenspezifisch durchzuführen sein und kann somit einen hohen Entwicklungsaufwand erfordern. Alternativ dazu können sich Probleme durch Wechselwirkung der Lithographiestrahls mit der Probe auch dadurch lösen lassen, dass die Strukturen nicht direkt auf den zu verbindenden optischen Komponenten erstellt werden, sondern auf einer weiteren Trägerstruktur, welche fest mit den optischen Komponenten verbunden ist. Die Trägerstruktur kann insbesondere dasselbe Material oder ein Material mit optisch identischen Eigenschaften wie die optischen Komponenten oder die strahlformenden Elemente umfassen. Die Trägerstruktur kann insbesondere auch mit demselben Verfahren hergestellt werden, das auch zur Strukturierung der strahlformenden Elemente verwendet wird. Eine beispielhafte Ausgestaltung ist eine auf Stützstrukturen hergestellte Linse. Die Stützstrukturen, insbesondere in Form von Pfeilern, können hierbei derart verankert sein, dass keine unerwünschte Wechselwirkung des Lithographie-Systems mit dem zu beschreibenden strahlformenden Element auftritt. Alternativ oder zusätzlich können die Stützstrukturen an einer Stelle verankert sein, an welcher eine durch den Schreibprozess auftretende Wechselwirkung mit der zu verbindenden optischen Komponente nicht problematisch ist. Insbesondere kann es dabei sinnvoll sein, keinen direkten Kontakt zwischen den strahlformenden Elementen und den Facetten der zu verbindenden optischen Komponenten zuzulassen. Durch die Herstellung strahlformender Elemente mit Abstand zu den optischen Komponenten kann sich das Modenfeld durch die Propagation im Raum aufweiten, sodass die zugehörige Leistungsdichte abnimmt. Hiermit können auch Laserstrahlen mit hoher Leistung gekoppelt werden.

Während des Betriebs einer optischen Kopplungsstrecke können räumlich inhomogene Temperaturänderungen auftreten, wodurch die strahlformenden Elemente geringfügig verformt werden können, so dass eine Winkelabweichung zu der ursprünglichen Struktur auftreten kann. Hierdurch kann es zu einer Abnahme der Kopplungseffizienz durch eine Ablenkung des Lichtstrahls auf einem abgelenkten Pfad im Vergleich zu dem ursprünglichen Pfad. Durch eine entsprechende Anordnung strahlformender Elemente kann auch diese Abweichung kompensiert werden, so dass ein eintreffender Strahl das optische System unabhängig von den temperaturbedingten Abweichungen wieder verlässt.

Durch eine große Anzahl an strahlformenden Elementen kann sich weiterhin das Problem ergeben, dass hohe Reflexionsverluste entstehen. In einer besonderen Ausgestaltung können diese durch ein Einbetten der strahlformenden Elemente in ein Umgebungsmaterial verringert werden, da hierdurch der Brechungsindexkontrast, d.h. eine Differenz des Brechungsindexes, aus welchem die strahlformenden Elemente hergestellt wurden, zu dem Brechungsindex des Umgebungsmaterials, verringert werden kann.

Generell hängen Reflexionsverluste in optischen Medien im Wesentlichen von der Anzahl der optischen Grenzflächen sowie von der Brechungsindex-Differenz (Indexkontrast) zwischen den Materialen, welche jeweils eine Grenzfläche bilden, ab. Es kann gezeigt werden, dass ein optisches System mit vielen optischen Grenzflächen und geringem Indexkontrast weniger Verluste aufweist als ein im Hinblick auf die optische Brechkraft äquivalentes System mit hohem Indexkontrast und wenigen Grenzflächen. Dies kann beispielsweise durch die folgende Überlegung veranschaulicht werden: Zunächst kann als vereinfachende Annahme davon ausgegangen werden, dass die Reflexion von Strahlen, welche auf eine Oberfläche treffen, näherungsweise derjenigen von senkrecht eintreffenden Strahlen entspricht. Dies ist näherungsweise gerechtfertigt für Linsen, die im Wesentlichen im inneren Bereich ihrer Querschnittsfläche mit Licht beaufschlagt werden. Damit ergibt sich nach den Fresnel-Gleichungen für die Reflexion $R$ an vollständig transparenten Oberflächen

$$R = \frac{(n - n'_0)^2}{(n + n'_0)^2}, \qquad (1)$$

wobei $n$ der Brechungsindex der Linsen und $n'_0$ der des Umgebungsmediums ist. Weiterhin wird angenommen, dass die sogenannte "Linsenmachergleichung" gilt:

$$f = r \frac{n}{n - n'_0}, \qquad (2)$$

wobei $f$ die Brennweite und $r$ der Krümmungsradius einer sphärischen Linsenoberfläche sind. Weiterhin ist Reflexion gleichzusetzen mit Verlust. Insbesondere im Grenzfall kleiner Reflexionsverluste ist der Gesamtverlust $R_{total}$ einer Kaskade aus $k$ im Hinblick auf die Leistungsreflexion äquivalenten Flächen das $k$-Fache der Reflexionsverluste einer einzelnen Fläche:

$$R_{total} = kR. \qquad (3)$$

Ausgehend von der Annahme, dass alle Grenzflächen der Kaskade dieselbe Brennweite $f$ aufweisen, erhält mit die Brennweite $f_{total}$ des Gesamtsystems durch reziproke Addition der einzelnen Brennweiten,

$$f_{total} = \frac{1}{\sum_i \frac{1}{f_i}} = \frac{f}{k} . \tag{4}$$

Eine Grenzfläche mit hohem Indexkontrast und entsprechend kleiner Brennweite lässt sich also durch eine Kaskade von Grenzflächen mit geringem Indexkontrast und individuell großer Brennweite ersetzen.

In der weiteren Überlegung wird nun unter Beibehaltung der Form der Grenzflächen der Brechungsindex $n_0'$ des Umgebungsmediums zwischen dem Brechungsindex der Luft $n_0 = 1$ und dem Brechungsindex $n$ des Linsenmaterials variiert und gleichzeitig die Anzahl der Grenzflächen so angepasst, dass die Brennweite $f_{total}$ des Gesamtsystems erhalten bleibt, d.h., der Verlust an Brechkraft durch einen geringer werdenden Brechungsindexkontrast wird durch eine größere Anzahl optische Grenzflächen kompensiert. Mit der Linsenmachergleichung und der reziproken Additivität der Brennweiten ergibt sich für die Anzahl der notwendigen Flächen

$$k = \frac{r \dfrac{n}{n-n_0'}}{r \dfrac{n}{n-n_0}} = \frac{n-n_0}{n-n_0'} . \tag{5}$$

Daraus lässt sich der Gesamtverlust des so entstehenden Systems wie folgt abschätzen:

$$R_{total} = kR = \frac{n-n_0}{n-n_0'} \frac{(n-n_0')^2}{(n+n_0')^2} . \tag{6}$$

Damit ergibt sich eine nahezu Abnahme des Gesamtverlustes mit dem Brechungsindexunterschied $n - n_0'$ zwischen Linsenmaterial und Umgebungsmedium. Die Anzahl der notwendigen Flächen steigt hingegen. Grundsätzlich können damit Verluste beliebig minimiert werden, allerdings mit einer sehr hohen Anzahl von optischen Grenzflächen. Aus der analytischen Betrachtung ergibt sich zusammenfassend, dass ein optisches System mit wenigen Grenzflächen und hohem Indexunterschied durch ein äquivalentes optisches System mit einer höheren Anzahl an Grenzflächen mit geringerem Indexunterschied ersetzt werden kann. Im Hinblick auf die Ausgestaltung der strahlformenden Elemente kann zur Minimierung der Reflexionsverluste eine Anzahl an optischen Flächen gewählt werden, die bevorzugt von 2 bis 100, besonders bevorzugt von 4 bis 50, insbesondere von 6 bis 12 beträgt.

Die Variation des Brechungsindexkontrasts der Linsenflächen eröffnet neue Freiheitsgrade in der Auslegung der optischen Koppelstrecke. Insbesondere könnte bei geringerem Indexkontrast gleichzeitig die Krümmung der Linsenoberflächen verstärkt werden, da Streuverluste für Strahlen mit streifenden Einfall bei schwachem Indexkontrast schwächer ausfallen und zudem Totalreflexion bei Durchtritt einer Grenzfläche von einem optisch dünneren zu einem optisch dichteren Medium weniger problematisch ist.

In einer weiteren Ausgestaltung kann das Umgebungsmedium auch einen höheren Brechungsindex als das Material des strahlformenden Elements aufweisen. Dieser Umstand kann vorzugsweise im Design der strahlformenden Elemente berücksichtigt werden und äußert sich z.B. in einer entsprechenden Umkehrung der Krümmungsrichtung refraktiver Flächen. So kann beispielsweise eine konkave, in ein hochbrechendes Umgebungsmaterial eingebettete Linsenstruktur eine fokussierende Wirkung entfalten.

Für die Herstellung des beschriebenen Systems mit geringem Brechungsindexkontrast kann das oben beschriebene dreidimensional direktschreibende Lithographieverfahren, insbesondere die Zwei-Photonen-Lithographie, mit einem anschließenden Einbettungsschritt verwendet werden. Hierbei können insbesondere auch unterschiedliche Einbettungsmaterialien verwendet werden. Diese können auch Zusatzfunktionen, insbesondere eine Herabsetzung der chromatischen Aberration, übernehmen. Weiterhin können bei dem Einbettungsschritt auch Hohlräume ausgespart werden. Die Hohlräume können mit einem anderen beliebigen Medium gefüllt werden oder ungefüllt bleiben. Zur Herstellung der strahlformenden Elemente kann auch ein Material genutzt wird, dessen Brechungsindex sich durch eine Belichtung ändern kann, insbesondere ein Ormocer®, ein Glas oder ein Polymer.

In einer weiteren Ausgestaltung kann ein Aufbringen von Umgebungsmedium mit dem gleichen Brechungsindex wie die verwendeten strahlformenden Elemente erfolgen, insbesondere dann, wenn die vom Lichtstrahl durchdrungenen Kontaktflächen zwischen dem Umgebungsmedium und den strahlformenden Elementen über keine relevante optische Funktion verfügen.

In einer weiteren Ausgestaltung kann es das erfindungsgemäße Verfahren erlauben, strahlformende Elemente herzustellen, die über innere, mit Luft oder einem anderen niedrigbrechenden Medium gefüllte Hohlräume verfügen können. Die Oberflächen dieser Hohlräume lassen sich als strahlformende Grenzflächen nutzen, deren Brechkraft von einem äußeren Einbettungsmedium nicht beeinflusst wird. Dieses Verfahren kann es insbesondere ermöglichen, kompakte Elemente mit hoher Brechkraft herzustellen, auch wenn sich aus anderweitigen Gründen eine äußere Einbettung in ein Medium als erforderlich erweisen kann, welches lediglich einen geringem Indexkontrast zum Material des strahlformenden Elementes aufweisen kann.

In einer weiteren Ausgestaltung können Antireflex-Beschichtungen zur zusätzlichen Herabsetzung von Reflexionsverlusten eingesetzt werden.

In einer weiteren Ausgestaltung können anstelle von brechenden optischen Elementen spiegelnde optische Elemente oder reflektierende optische Elemente eingesetzt werden, insbesondere um die Reflexionsverluste zusätzlich herabzusetzen. Hierbei kann die Totalreflexion an Übergängen von Medien mit geringem Indexkontrast und hohem Indexkontrast ausgenutzt werden.

In einer weiteren Ausgestaltung kann die Herstellung der strahlformenden Elemente derart erfolgen, dass diese zunächst an einer Vielzahl zusammenhängender optischer Komponenten erzeugt werden, bevor ein Vereinzelungsschritt zur Vereinzelung der optischen Komponenten zur jeweiligen Weiterverwendung in einem oder mehreren optischen Systemen ausgeführt wird. So lassen sich beispielsweise strahlformende Elemente auf oberflächenemittierenden Bauteilen besonders effizient herstellen, so lange die Bauteile noch in Form eines Wafers vorliegen, der erst nach dem Schreiben der strahlformenden Elemente in Einzelelemente zerlegt wird.

In einem weiteren Aspekt betrifft die vorliegende Erfindung ein optisches System gemäß Anspruch 10.

Das vorliegende optische System unterscheidet sich somit insbesondere dadurch von aus dem Stand der Technik bekannten optischen Anordnungen, dass die strahlformenden Elemente in-situ an der Zielposition, vorzugsweise direkt an einer Bauteilfacette oder an entsprechenden Haltestrukturen eines der optischen Komponenten, durch ein dreidimensional direkt-schreibendes Lithographieverfahren erzeugt werden und dass die strahlformenden Elemente gezielt dazu genutzt werden können, um die Koppeleffizienz zwischen zwei optischen Komponenten zu verbessern und die zugehörigen Positionierungstoleranzen zu erhöhen. Insbesondere werden hierbei die strahlformenden Elemente in-situ an der Zielposition gemäß Schritt c) des hierin beschriebenen Verfahrens hergestellt.

Erfindungsgemäß weist jede der beiden optischen Komponenten ein eigenes strahlformendes Element auf, so dass das optische System zwei, jeweils um ein strahlformendes Element ergänzte optische Komponenten umfasst. Allerdings sind auch nicht-erfindugsgemäße optische Systeme denkbar, in welchen sich die beiden optischen Komponenten ein gemeinsames, in-situ an der Zielposition mittels eines dreidimensional direktschreibenden Lithographieverfahrens erhältliches strahlformendes Element teilen.

In einer besonders bevorzugten Ausgestaltung sind hierbei die strahlformenden Elemente in Formgebung und Positionierung jeweils dazu eingerichtet, dass die optische Kopplung zwischen den optischen Komponenten bei einer gewählten Positionierungsgenauigkeit mindestens eine festgelegte Kopplungseffizienz aufweist.

Insbesondere ist jede der optische Komponenten ausgewählt aus der Gruppe umfassend Einmoden- oder Mehrmodenfasern aus organischen oder anorganischen Materialien, halbleiterbasierte integriert-optische Chips wie z.B. Laser, Fotodioden, Superlumineszenz-Dioden oder Silizium-Photonik-Chips, integriert-optische Chips auf Basis von anderen Halbleitern oder dielektrischen Materialien wie z.B. Gläsern, Silizium-Dioxid, Silizium-Nitrid oder Polymeren, optische Leiterplatten, oder Elemente für die Freistrahl-Optik wie z.B. Linsen, Strahlteiler, Isolatoren, Spiegel oder Beugungsgitter. Die optischen Komponenten können optischen Wellenleiter mit geringem Indexkontrast (z.B. Glas-basierte optische Wellenleiter) oder mit mittlerem bzw. hohem Indexkontrast (z.B. halbleiterbasierte Wellenleiter) aufweisen. Die Ein- bzw. Auskopplung von Licht kann an der Kante einer optischen Komponente erfolgen, beispielsweise bei kantenemittierenden Laser oder wellenleiterbasierten Systemen mit entsprechenden Facetten an der Chipkante, oder auf der Oberfläche, beispielsweise bei oberflächenemittierenden Lasern (Vertical Cavity Surface Emitting Lasers, VCSEL), bei oberflächenbeleuchteten Photodioden, oder bei wellenleiterbasierten Chips mit entsprechenden Koppelstrukturen (z.B. Gitterkoppler, Umlenkspiegel).

In einer möglichen Ausgestaltung weist die optische Verbindung der beiden optischen Komponenten mindestens zwei strahlformende Elemente auf, wobei mindestens ein strahlformendes Element dazu eingerichtet ist, die lokale Strahldivergenz zu erhöhen, während mindestens ein weiteres strahlformenden Elemente dazu eingerichtet ist, die lokale Strahldivergenz zu verringern. Insbesondere kann hierzu mindestens eines der strahlformenden Elemente in Form eines Strahlaufweiters ausgestaltet werden, wobei der Strahlaufweiter über eine Struktur verfügt, welche ausgewählt ist aus einer reflektierenden Struktur, einer lichtleitenden Struktur oder einer diffraktiven Struktur.

In einer besonderen Ausgestaltung verfügt jede der optische Komponenten über eine Mehrzahl von optischen Koppelstellen, wobei jede der optischen Koppelstellen mit mindestens einem strahlformenden Element fest verbunden ist, wobei die strahlformenden Elemente jeweils dazu eingerichtet sind, um eine vorzugsweise gleichzeitige optische Kopplung zwischen den optischen Komponenten über alle optische Koppelstellen auszubilden.

In einer bevorzugten Ausgestaltung kann eine der optischen Komponenten als optischer Chip ausgeführt sein. Der insbesondere im Bereich der integrierten Optik verwendete Begriff des "optischen Chips" bezeichnet hierbei ein planares Substrat, auf dem sich eine oder eine mehrere optische Komponente befinden, welche üblicherweise durch ein Mikrostrukturierungsverfahren herstellbar sind. Ein optischer Chip kann beispielsweise ein oder mehrere Fotodetektoren, Lichtquellen, Wellenleiter, passive Bauelemente wie z.B. Filter oder Leistungsteiler, elektro-optische Modulatoren oder Kombinationen hiervon aufweisen. Weitere Ausführungen sind denkbar, insbesondere auch die Kombination von photonischen und elektronischen Bauelementen auf einem gemeinsamen Chip.

Die auf dem optischen Chip angebrachten strahlformenden Elemente können derart ausgelegt sein, dass sie eine Umlenkung von in der Chip-Ebene propagierendem Licht in eine im Wesentlichen senkrecht zur Oberfläche des Chips orientierten Richtung bewirken können und/oder Licht aus einer im Wesentlichen senkrecht zur Oberfläche des Chips orientierten Richtung in eine in der Chip-Ebene liegende Propagationsrichtung umlenken können. Hierbei bezeichnet der Begriff "im Wesentlichen senkrecht" einen Winkel von mindestens 50°, bevorzugt von mindestens 60°, insbesondere von etwa 90°, relativ zur Oberfläche des optischen Chips. Hierbei kann das in eine, im Wesentlichen senkrecht zur Oberfläche der optischen Chips orientierte Richtung propagierende Licht einen anderen weiteren optischen Chip oder ein in dem optischen Chip und/oder dem weiteren optischen Chip eingebrachtes optisch transparentes Fenster durchdringen. Alternativ oder zusätzlich kann das in eine im Wesentlichen senkrecht zur Oberfläche des optischen Chips orientierte Richtung propagierende Licht in den weiteren optischen Chip eingekoppelt werden, wobei die auf dem weiteren optischen Chip angebrachten strahlformenden Elemente so ausgelegt sein können, dass sie Licht aus einer im Wesentlichen senkrecht zur Oberfläche des Chips orientierten Richtung in eine in der Chip-Ebene liegende Propagationsrichtung umlenken können. In dieser Ausgestaltung kann das in eine, im Wesentlichen senkrecht zur Oberfläche des optischen Chips orientierte Richtung proagierende Licht vorzugsweise in eine oder mehrere als Wellenleiterarray ausgelegte optische Komponenten eingekoppelt werden, wobei die auf der betreffenden optischen Komponente angebrachten strahlformenden Elemente derart ausgelegt sein können, dass sie Licht aus einer im Wesentlichen senkrecht zur Oberfläche des Chips orientierten Richtung in eine in der Chip-Ebene liegende Propagationsrichtung umlenken können. In einer möglichen Ausgestaltung kann mindestens eines der strahlformenden Elemente einen Wellenleiter, einen sich aufweitenden Teil und einen die Divergenz des austretenden Strahls verringernden Teil umfassen.

Für weitere Einzelheiten in Bezug auf das vorliegende optische System wird auf die Beschreibung des erfindungsgemäßen Verfahrens verwiesen.

## Vorteile der Erfindung

Die vorliegende Erfindung weist eine Reihe von Vorteilen gegenüber den aus dem Stand der Technik bekannten Verfahren und optischen Systemen auf. Das vorliegende Verfahren erlaubt es, optische Komponenten, welche über denselben oder über unterschiedliche Modenfelddurchmesser verfügen können, in einem robusten und automatisierbaren Montageprozess mit möglichst geringen Kopplungsverlusten optisch miteinander zu verbinden. Die optische Verbindung ist hierbei insbesondere auch für breitbandiges Licht, d.h. für Licht unterschiedlicher Wellenlängen, möglich. Der Montageprozess stellt vergleichsweise geringe Anforderungen an die Positionierungsgenauigkeiten. So liegen die Toleranzen für translatorische Positioniergenauigkeiten bevorzugt bei mehr als 500 nm, besonders bevorzugt mit Toleranzen bei mehr als 2 $\mu$m, und ganze besonders bevorzugt bei mehr als 5 $\mu$m oder gar 10 $\mu$m. Die Zahl der mechanischen Freiheitsgrade während des Montageprozess kann gering gehalten werden, da die strahlformenden Elemente mit hoher Präzision an den Facetten der zu verbindenden optischen Komponenten ausgerichtet und fest mit diesen verbunden sind. Das Verfahren kann automatisierbar eingerichtet werden und lässt sich auf eine große Vielfalt lateral einmodiger oder mehrmodiger Systeme anwenden. Insbesondere lassen sich auch optische Komponenten mit nichtrotationssymmetrischem Modenfeldprofilen, etwa Halbleiterlaser, Super-Lumineszenz-Dioden (SLED) oder integriert-optische Wellenleiter ankoppeln. Weiterhin ist es möglich, Rückreflexionen zu vermeiden, insbesondere bei der Verbindung von Lasern und SLEDs. Die Kopplungsverluste können gering gehalten werden, bevorzugt unter 2 dB, besonders bevorzugt unter 1 dB, insbesondere unter 0,5 dB. Zudem ist es möglich, das von einer optischen Komponente abgestrahlte Licht innerhalb eines strahlformenden Elements um einen bestimmten Winkel ablenken zu können, so dass sich z.B. auch optische Komponenten, die in zueinander orthogonale Richtungen abstrahlen, miteinander verbinden lassen.

Die erfindungsgemäße *in-situ* Herstellung der strahlformenden Elemente an oder auf den zu verbindenden optischen Komponenten weist insbesondere die im Folgenden aufgeführten Vorteile auf. In diesem Zusammenhang ist es möglich, zur Erhöhung der Präzision beim Aufbau des Systems auf Markierungen auf der Chipoberfläche zurückzugreifen, die gemeinsam mit den optischen Strukturen auf dem Chip gefertigt wurden und daher eine sehr hohe relative Positioniergenauigkeit zu diesen aufweisen. Weiterhin ist es möglich, Licht über die Oberfläche eines optischen Chips verlustarm und breitbandig in einen in Chipebene verlaufenden Lichtwellenleiter einzukoppeln. Hierbei kann insbesondere auch eine optische Verbindung zwischen aufeinandergestapelten Chips erfolgen. Zudem kann der Abstand zwischen optischen Komponenten variabel sein, sodass sowohl geringe Baugrößen und entsprechend kurze Koppelstrecken als auch großflächige Systeme mit langen Koppelstrecken möglich werden. Insbesondere ist es möglich, auch optische Komponenten mit einem nicht rotations-symmetrischem Modenfeldprofil an Komponenten mit einem rotationssymmetrischen Modenfeldprofilen ankoppeln zu können. Weiterhin ist es möglich, Rückreflexionen zu minimieren, insbesondere bei der optischen Anbindung von Lasern und Superlumineszenzdioden (SLED). Dies ist insofern wichtig, da es sonst zu einer Rückkopplung des von einem Laser bzw. einer SLED abgestrahlten Lichts in das Bauteil kommt, was zu einer Störung des Betriebsverhaltens führen kann. Zudem ist es möglich, das von einer optischen Komponente abgestrahlte Licht auch um einen bestimmten Winkel ablenken zu können, so dass sich z.B. auch optische Komponenten, die in zueinander nicht kollineare Richtungen abstrahlen, optisch miteinander verbinden lassen. Weiterhin ist es möglich, fertigungsbedingte Ungenauigkeiten bei der Herstellung von optischen Komponenten während der Montage des Systems zu kompensieren, so dass es beispielsweise möglich wird, Komponenten mit Wellenleiterarrays trotz unvermeidlicher Variationen im Abstand benachbarter Wellenleiter miteinander zu koppeln. Weiterhin ermöglicht die Methode, Komponenten mit wiederholbaren Koppelverlusten miteinander zu verbinden bzw. zu trennen, wie es beispielsweise bei Stecksystemen der Fall ist. Das Verfahren ist weiterhin skalierbar und somit auch für eine große Anzahl von Komponenten automatisiert anwendbar. Es ist zudem möglich, das Verfahren flexibel mit weiteren Schritten zum Aufbau von optischen Systemen zu kombinieren, so dass beispielsweise Schritte zur elektrischen Verdrahtung von Bauteilen in den Fabrikationsablauf integriert werden können. Dabei besteht insbesondere die Möglichkeit, das Verfahren so zu gestalten, dass das teilweise oder vollständig montierte optische System keinen nasschemischen Behandlungsschritten wie z.B. der Verarbeitung in einem Entwicklerbad ausgesetzt wird.

Durch die hohe Präzision der verwendeten Herstellungsverfahren und der Möglichkeit, die strahlformenden Elemente bereits während der Herstellung direkt an Markierungen auf den optischen Komponenten auszurichten, ergibt sich eine inhärente hohe Positionierungsgenauigkeit der strahlformenden Elemente relativ zu den zu verbindenden optischen Komponenten. Dies ist insbesondere dann der Fall, wenn für eine Vermessung der Position der optischen Komponenten dasselbe optische System verwendet wird, wie für die Durchführung der Lithographie. Damit ist das vorliegende Verfahren insbesondere auch für einmodige Bauteile mit geringen Modenfelddurchmessern geeignet. Durch Verwendung eines dreidimensional direkt-schreibenden Lithographieverfahrens lassen sich zudem strahlformende Elemente mit nahezu beliebigen Formen herstellen, so dass das vorliegende Verfahren über einen weiten Einsatzbereich verfügt. Weiterhin können bauteilspezifische, beispielsweise durch Fertigungstoleranzen verursachte Abweichungen kompensiert werden, so dass auch optische Bauteile, insbesondere Laser, mit höheren Fertigungstoleranzen verwendet werden können. Zudem lassen sich auch kleine Stückzahlen kosteneffizient herstellen, da applikationsspezifische strahlformende Element mit geringem Aufwand herstellbar sind. Weiterhin können die Facetten der zu verbindenden optischen Komponenten direkt in das im Vergleich zur Luft hochbrechende Material der strahlformenden Elemente eingebettet werden, was den Vorteil aufweist, dass sich auch sehr kleine Modenfelder mit hoher Divergenz koppeln lassen, da die Divergenz bei steigendem Brechungsindex des Umgebungsmediums abnimmt. Die Anforderungen an die Positionierungsgenauigkeit der optischen Komponenten bezüglich Position und Rotation können abhängig von der verfügbaren Positionierungs- und Fixierungstechnologie angepasst und damit der Zielkonflikt zwischen größtmöglichen rotatorischen und translatorischen Positionierungs-toleranzen auf optimale Weise gelöst werden. Mittels geeigneter Haltestrukturen können die strahlformenden Elemente so erzeugt werden, dass sie sich vorzugsweise an Stellen geringerer Leistungsdichte befinden, was insbesondere deren Betriebsdauer und Stabilität bezüglich hoher optischer Leistungen erhöhen kann. Zusätzlich lässt sich bei dem erfindungsgemäßen Verfahren der Brechungsindexunterschied an den Oberflächen der strahlformenden Elemente flexibel einstellen, indem diese in ein Umgebungsmaterial mit geeignetem Brechungsindex eingebettet werden. Dies eröffnet zusätzliche Freiheitsgrade bei der Auslegung der optischen Koppelstrecke und erlaubt insbesondere eine Kaskadierung einer Vielzahl von Elementen mit geringem Indexkontrast und dementsprechend individuell geringer Brechkraft, durch die sich Rückreflexionen und Reflexionsverluste entlang des Strahlpfades stark verringern lassen. Darüber hinaus können durch eine entsprechende Auslegung der strahlformenden Elemente auch Richtungsänderungen, z.B. um 90°, des zu koppelnden Lichtstrahls bewirkt werden. Schließlich können optische Systeme hergestellt werden, welche dazu eingerichtet sind, etwaige Abweichungen der strahlformenden Elemente von ihrer ursprünglichen vorgesehenen Form zu korrigieren.

Insbesondere eine Verwendung von strahlformenden Elementen, welche über sowohl über einen aufweitenden Teil als auch über einen kollimierenden Teil verfügen, weist folgende Vorteile auf. Die Anforderungen an die Positionierungsgenauigkeit kann dadurch weiter herabgesetzt werden. Die Verwendung eines aufweitenden Teils und eines kollimierenden Teils kann zusätzliche Freiheitsgrade bereitstellen, um einen Lichtstrahl zu beeinflussen. Vorzugsweise können mehrere Linsen dazu eingesetzt werden, um, ein nicht-rotationssymmetrisches Strahlprofil eines Lasers in ein rotationssymmetrisches Strahlprofil zu überführen, wobei sich die strahlformenden Komponenten in einen beliebigen Abstand zu der optischen Komponente mit dem nicht rotationssymmetrischen Strahlprofil befinden können. Die zusätzlichen Freiheitsgrade erlauben darüber hinaus, optische Systeme weitgehend ohne Rückreflexion herzustellen.

Ein wesentlicher Vorteil des vorliegenden Verfahrens betrifft dessen universelle Anwendbarkeit. Mittels eines dreidimensional-direktschreibenden Lithographieverfahrens wird es möglich, strahlformende Elemente mit nahezu beliebigen Formgebungen herzustellen. Dadurch ist es möglich, strahlformende Elemente für einen weiten Bereich an Systemkonzepten zu realisieren.

Auch in Bezug auf Prozesskompatibilität weist die vorliegende Erfindung eine Reihe von Vorteilen auf. Diese Vorteile ergeben sich insbesondere aufgrund der Möglichkeit, die Positionierung der zu verbindenden optische Komponenten von der Strukturierung der zugehörigen strahlformenden Elemente zu trennen. Die Strukturierung mit Zwei-Photonen-Lithographie erfordert eine Reihe von Verfahrensschritten, welche an optisch gut zugänglichen Bauteilen durchgeführt werden oder welche die Behandlung mit speziellen Chemikalien erfordern, so dass sie vorzugsweise möglichst früh im Verfahrensablauf auftreten sollten. Die vorliegende Erfindung erlaubt es, die Zwei-Photonen Lithographie früh im Verfahrensablauf einzusetzen, da hierdurch keine mechanische Verbindung zwischen den optischen Komponenten hergestellt wird. Folglich können die optischen Komponenten auch nach der Strukturierung mit der Zwei-Photonen-Lithographie bewegt und positioniert werden. So werden gemäß des in Ansatz US 8,903,205 B2 offenbarten Standes der Technik beispielsweise alle optischen Bauteile zunächst positioniert und anschließend durch mit Zweiphotonen-Lithographie erzeugte Lichtwellenleiter miteinander verbunden. Dabei tritt das Problem auf, dass die zu beschreibende Stelle oftmals nicht zugänglich ist, da beispielsweise ein Gehäuse im Weg ist. Weiterhin kann auch das optische Bauteil selbst das Schreiben eines weiteren optischen Bauteils blockieren, da die optisch aktive Seite nicht zugänglich sein kann, wie etwa beim Flip-Chip Bonding. Im Unterschied hierzu ermöglicht das vorliegende Verfahren eine Strukturierung der strahlformenden Elemente vor deren Positionierung in ihrer finalen Position. Dadurch werden zudem Anordnungen von aufeinandergestapelten Chips möglich, die untereinander optisch verbunden sind. In diesem Zusammenhang können in den Chips entsprechende Aussparungen vorgesehen werden, durch die die Lichtstrahlen hindurchtreten.

In ähnlicher Weise sind Konfigurationen möglich, in denen auf der Oberfläche von integriert-optischen Chips angebrachte strahlformende Elemente zu einer Lichtabstrahlung senkrecht zur Oberfläche des Chips führen und damit eine Einkopplung in ein Array von ggf. ebenfalls mit strahlformenden Elementen verbundenen Wellenleitern ermöglichen. In dieser Konfiguration ist es insbesondere möglich, die auf dem Chip aufgebrachten strahlformenden Elemente so auszulegen, dass sie in einem planaren Wellenleiter auf dem Chip propagierendes Licht in eine im wesentlichen senkrecht zur Chipoberfläche orientierte Richtung ablenken. Derartige Konfigurationen bieten sich z.B. für Netzwerk-Switches an, bei denen eine Vielzahl von optischen Sender- und Empfängerkomponenten auf einem leistungsfähigen elektrischen Chip oder einer elektrischen Leiterplatte angebracht werden. Als Netzwerk-Switch wird in diesem Zusammenhang ein optisches System verstanden, das in der Lage ist, optische Signale an einer Vielzahl von Eingängen zu empfangen und in modifizierter oder nicht modifizierter Form über eine Vielzahl von Ausgängen auszugeben. Dabei ist es unerheblich, ob in diesem Switch optoelektronische Wandlungen bzw. elektronische Signalverarbeitungsschritte vorgenommen werden oder nicht.

Mit dem vorliegenden Verfahren können weiterhin auch optische Bauteile zunächst mit Zwei-Photonen-Lithographie erzeugt und anschließend in ein Gehäuse eingebracht werden, in welchem sie für eine direkte Beschreibung durch das Lithographieverfahren unzugänglich wären. Durch das erfindungsgemäße Trennen von Strukturierung der strahlformenden Elemente und Positionierung der zu verbindenden optischen Komponenten ergeben sich weitere verfahrensrelevante Vorteile. Würden die strahlformenden Elemente erst nach Montage des optischen Systems erzeugt, so wäre es erforderlich, das gesamte System einem Entwicklungsprozess zu unterziehen. Die hierfür erforderlichen Chemikalien sind aufgrund mangelnder chemischer Kompatibilität mit Bestandteilen des optischen Systems jedoch oftmals nicht einsetzbar, so dass ein derartiger Prozess nicht durchführbar ist. Wird jedoch die Strukturierung der strahlformenden Elemente dagegen vor der Montage der zugehörigen optischen Komponenten vorgenommen, so entfallen diese Probleme. Weiterhin kann so eine höhere Automatisierung des Herstellungsprozesses ermöglich werden. Insbesondere kann eine große Anzahl der mit strahlformenden Elementen zu beschreibenden optischen Komponenten zunächst temporär fixiert und dann in einem einzigen vollständig automatisierten Prozess geschrieben werden, bevor sie zur Integration in das optische System vereinzelt werden. Damit wird es insbesondere möglich, optische Komponenten bereits auf Wafer-Ebene und vor einer Vereinzelung mit strahlformenden Elementen zu versehen.

Ein weiterer wesentlicher Vorteil der vorliegenden Erfindung besteht in einer Anpassung der notwendigen Ausrichtungsgenauigkeit an die verfügbare Positionierungstechnologie. Für die Positionierung von optischen Bauteile ist typischerweise eine sehr hohe Positionierungenauigkeit notwendig. Diese Positionieranforderung kann nur durch kostenintensive Spezialmaschinen sichergestellt werden, welche eine Positioniergenauigkeit von unter 1 $\mu$m gewährleisten. Weiterhin ist oftmals aktives Alignment erforderlich, was einen großen Aufwand und damit hohe Kosten verursacht. Durch die erfindungsgemäße Aufweitung des Modenfelds hat eine Fehlausrichtung der zu verbindenden optischen Komponenten jedoch eine erheblich geringere Auswirkung auf deren Kopplungseffizienz. Es lassen sich somit kostengünstigere Maschinen mit geringerer Positioniergenauigkeit einsetzen. Weiterhin kann das Erfordernis des aktiven Alignments wegfallen. Im Vergleich zu konventionellen Verfahren, bei denen zusätzliche Mikrolinsen zur Strahlformung im Montageprozess positioniert und fixiert werden, reduziert sich die Zahl der Positionierungsschritte und der damit verbundenen Freiheitsgrade, die bei der Justage zu berücksichtigen sind. Zudem vereinfacht sich die Fixierung der optischen Bauteile auf dem Bauteilträger, bei der oftmals ein Schrumpf von Adhäsiven zu einer Positionsabweichungen führen kann.

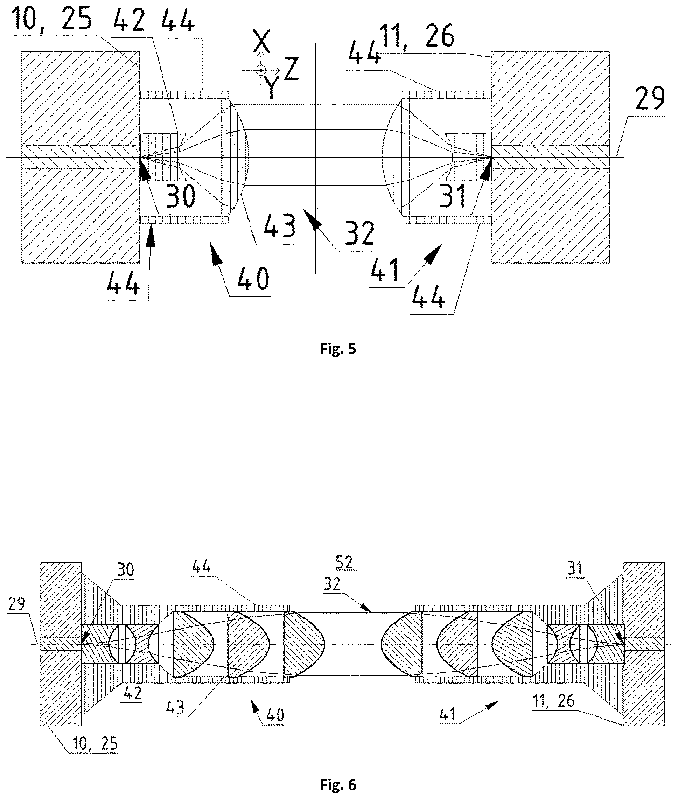

Ein weiterer wesentlicher Vorteil der vorliegenden Erfindung besteht in der Bereitstellung von geringen Kopplungsverlusten zwischen den erfindungsgemäß gekoppelten optischen Komponenten. Dies liegt zum einen an einer im Vergleich zum Stand der Technik wesentlich höheren Freiheit bzgl. der Formgebung der strahlformenden Elemente sowie an geringeren Reflexionsverlusten bei einer großen Zahl von aufeinanderfolgenden optischen Elementen im Strahlpfad. So betragen die Kopplungsverluste bei einem Übergang von einem Medium mit einem typischen Brechungsindex von 1,52 zu Luft, welches einen Brechungsindex von 1 aufweist, etwa 4 %, d.h. -0,18 dB. In einer beispielhaften Anordnung basierend auf refraktiven Strahlaufweitern mit einer ersten Mikrolinse zum Kollimieren und einer zweiten Mikrolinse zum Fokussieren des Strahls ergibt sich, wie in Abbildung 5 gezeigt, an beispielsweise sechs Oberflächen zwischen dem Linsenmaterial und der umgebenden Luft ein theoretischer Gesamtverlust von 23 %, d.h. -1,13 dB für die Verbindung zweier optischen Komponenten. Diese Grenze lässt sich in der Praxis nicht wesentlich unterschreiten, da die meisten Flächen für Antireflex-Beschichtungen nicht oder nur schwer, zugänglich sind. Das Verzichten auf eine konkave, aufweitende Linse ist möglich, führt aber oftmals zu sehr ausgedehnten Komponenten, welche nicht praktikabel für die Herstellung sind. Mit dem erfindungsgemäßen Verfahren wird es allerdings möglich, ein strahlformendes Element zu realisieren, das, wie in Figur 6 dargestellt, eine Vielzahl von beispielsweise 18 Flächen mit einem wesentlich geringeren Brechungsindexunterschied aufweist. Wird für das Material des strahlformenden Elements beispielhaft ein Brechungsindex von 1.52 und für das dieses Element umgebende Füllmaterial ein Brechungsindex von 1,47 angenommen, so ergibt sich ein theoretischer Gesamtverlust durch Reflexion von lediglich 0,5 %, d.h. 0,02 dB.

Ein weiterer Vorteil der vorliegenden Erfindung betrifft eine Anpassung von nichtrotationssymmetrischen Modenfeldern. Es wird insbesondere möglich, unter Verwendung eines einzigen strahlformenden Freiformelements ein nicht-rotationssymmetrisches Strahlprofil in ein rotationssymmetrisches Strahlprofil zu überführen. Zudem eröffnet die Verwendung entsprechender Freiformelemente eine sehr große Flexibilität hinsichtlich der Platzierung der strahlformenden Elemente entlang des Strahlpfades.

Ein weiterer Vorteil ist, dass fabrikationsbedingte Toleranzen von Bauteilen, beispielsweise beim Spalten von Lasern, durch eine geeignete Freiformstruktur kompensiert werden können. So können z.B. Längenvariationen von optischen Bauteilen durch entsprechende angepasste strahlformende Elemente ganz oder teilweise kompensiert werden. Ausführungsbeispiele hierfür finden sich im Folgenden in den Figuren und der zugehörigen Beschreibung.

**Kurze Beschreibung der Figuren**

Weitere Einzelheiten und Merkmale der vorliegenden Erfindung ergeben sich aus der nachfolgenden Beschreibung von bevorzugten Ausführungsbeispielen, insbesondere in Verbindung mit den abhängigen Ansprüchen. Hierbei können die jeweiligen Merkmale für sich alleine oder zu mehreren in Kombination miteinander verwirklicht sein. Die Erfindung ist nicht auf die Ausführungsbeispiele beschränkt.

Die Ausführungsbeispiele sind schematisch in den nachfolgenden Figuren dargestellt. Hierbei bezeichnen gleiche Bezugsziffern in den Figuren gleiche oder funktionsgleiche Elemente bzw. hinsichtlich ihrer Funktionen einander entsprechende Elemente.

Im Einzelnen zeigen:

Figur 1 eine schematische Darstellung eines nicht-erfindungsgemäßen Beispiels a) einer mit einem ersten strahlformenden Element verbundenen ersten optischen Komponente und b) einer mit einem zweiten strahlformenden Element verbundenen zweiten optischen Komponente;

Figur 2 eine schematische Darstellung eines Ausführungsbeispiels für ein optisches System aus zwei optisch gekoppelten und durch strahlformende Elemente ergänzten optischen Komponenten;

Figur 3 eine schematische Darstellung eines weiteren nicht-erfindungsgemäßen Beispiels a) der mit dem ersten strahlformenden Element verbundenen ersten optischen Komponente und b) der mit dem zweiten strahlformenden Element verbundenen zweiten optischen Komponente;

Figur 4 ein weiteres Ausführungsbeispiel für ein optisches System, das zwei optisch gekoppelte optische Komponenten, beispielsweise Einmodenfasern, umfasst;

Figur 5 ein weiteres Ausführungsbeispiel für ein optisches System zur optischen Kopplung zweier mit je einem Strahlaufweiter ausgestatteten optischen Komponenten, beispielsweise Einmodenfasern;

Figur 6 ein weiteres Ausführungsbeispiel für ein optisches System, das über ein Einbettungsmedium verfügt;

Figur 7 ein weiteres nicht-erfindungsgemäßes Beispiel für ein optisches System, das sowohl refraktive als auch reflektierende strahlformende Elemente aufweist;

Figur 8 ein weiteres Ausführungsbeispiel für ein optisches System, das das über ein in die Koppelstrecke eingebrachtes zusätzliches optisches Element verfügt;

Figur 9 ein Ausführungsbeispiel für eine optisches Kopplung, die ein nichtrotationssymmetrischen Strahlprofils in ein rotations-symmetrisches Strahlprofil überführt;

Figur 10 ein weiteres nicht-erfindungsgemäßes Beispiel für ein optisches System, bei dem die strahlformenden Elemente refraktive und reflektive Flächen miteinander kombinieren;

Figur 11 ein weiteres nicht-erfindungsgemäßes Beispiel für ein optisches System, bei dem die strahlformenden Elemente refraktive und reflektive Flächen miteinander kombinieren;

Figur 12 ein weiteres nicht-erfindungsgemäßes Beispiel für ein optisches System, bei dem die strahlformenden Elemente refraktive und reflektive Flächen miteinander kombinieren;

Figur 13 ein weiteres nicht-erfindungsgemäßes Beispiel für eine optische Kopplung zwischen einer Einmodenfaser und einem integrierten Wellenleiter;

Figur 14 ein weiteres nicht-erfindungsgemäßes Beispiel für ein optisches System, bei dem Winkelabweichungen reflektierender Flächen der strahlformenden Elemente automatisch kompensiert werden;

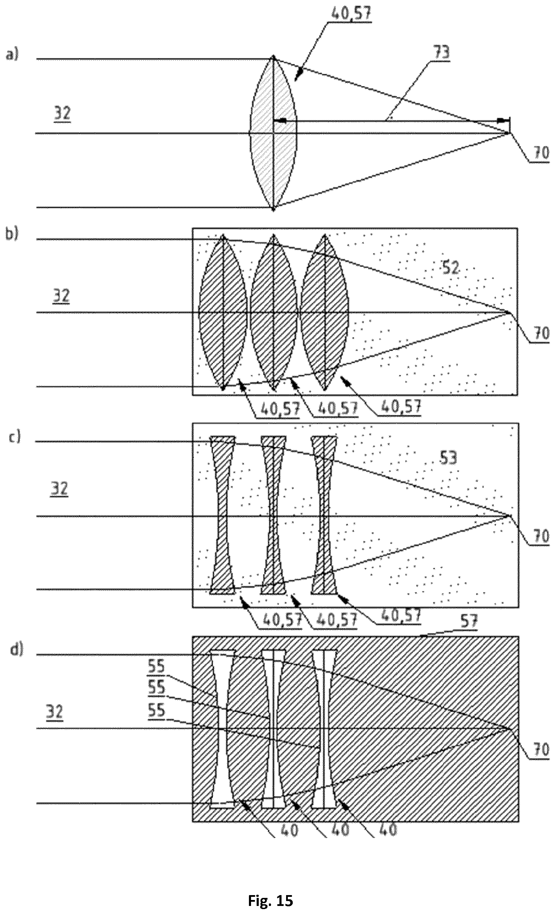

Figur 15 Ausführungsbeispiele für strahlformende Elemente zur Verringerung der Reflexionsverluste durch Ersetzung weniger optischer Grenzflächen mit hohem Indexkontrast durch mehrere optische Grenzflächen mit niedrigem Brechungsindex, wobei das strahlformende Element a) als bikonvexe Linse, b) als drei bikonvexe Linsen in einem Einbettungsmedium mit niedrigerem Brechungsindex als die drei bikonvexen Linsen, c) als drei bikonkave Linsen in einem Einbettungsmedium mit höherem Brechungsindex als die drei bikonkaven Linsen und d) mit drei Hohlräumen in Form von bikonkaven Linsen in einem Material mit im Vergleich zum Hohlraum erhöhten Brechungsindex ausgestaltet ist;

Figur 16 eine Darstellung der Ergebnisse aus Gleichung (6) unter Annahme eines Brechungsindex der Linsen n = 1,52;

Figur 17 eine Darstellung des Verlaufs des halben Öffnungswinkel ½ Θ in Grad (°) bei einer Wellenlänge λ = 1550 nm gegenüber einem Durchmesser D des Modenfelds bei einer Intensität des Lichts von $1/e^2$, d.h. ca. 13,5 %, der maximalen Intensität des Lichts;

Figur 18 ein weiteres Ausführungsbeispiel für ein optisches System, in dem jede optische Komponente über eine Vielzahl von Koppelstellen und zugehörigen strahlformenden Elementen verfügt,

Figur 19 eine beispielhafte Verbindung von optischen Komponenten, die jeweils über eine Vielzahl von Koppelstellen und zugehörigen strahlformenden Elementen verfügen;

Figur 20 eine elektronenmikroskopische Aufnahme eines weiteren Ausführungsbeispiels der strahlformenden Elemente, die jeweils eine Kombination aus einem Freiform-Lichtwellenleiter und einen kollimierendem Teil aufweisen;

Figur 21 ein weiteres nicht-erfindungsgemäßes Beispiel für ein optisches System, in dem die optischen Komponenten durch dedizierte Abstandshalter voneinander beanstandet sind;

Figur 22 ein weiteres nicht-erfindungsgemäßes Beispiel für ein optisches System, in dem die strahlformenden Elemente in ein planarisiertes Medium eingebettet sind, um einen definierter Abstand zwischen den optischen Komponenten zu erzeugen;

Figur 23 ein weiteres nicht-erfindungsgemäßes Beispiel für ein optisches System, das aus einer Vielzahl von auf einer elektrischen Leiterplatte oder einem elektrischen Chip montierten optischen Komponenten besteht, die mit einer weiteren optischen Komponente, beispielsweise einem Faserarray, verbunden sind;

Figur 24 ein weiteres nicht-erfindungsgemäßes Beispiel eines optischen Systems, das eine Kopplung zwischen einem in eine Leiterplatte eingebetteten Wellenleiter und einem optischen Chip beinhaltet;

Figur 25 ein nicht-erfindungsgemäßes Beispiel mehrerer optischer Komponente, die um ein strahlformendes Element derart ergänzt wurden, dass herstellungsbedingte Abweichungen der optischen Komponente durch die strahlformende Komponente kompensiert werden;

Figur 26 ein weiteres nicht-erfindungsgemäßes Beispiel für ein optisches System, das aus zwei übereinandergestapelten optischen Chips besteht, wobei einer der optischen Chips eine optisch transparente Aussparung aufweist und wobei die optische Verbindung über strahlformende Elemente erfolgt, die so ausgelegt sind, dass sie in planaren Wellenleitern auf den optischen Chips propagierendes Licht in eine im wesentlichen senkrecht zu den Chipoberflächen orientierte Richtung ablenken;

Figur 27 eine schematische Darstellung eines weiteren nicht-erfindungsgemäßen Beispiels mit einer optische Verbindung zwischen einem mit einem ersten strahlformenden Element verbundenen ersten optischen Komponente und einer zweiten optischen Komponente;

Figur 28 eine schematische Darstellung eines Ausführungsbeispiels zur Kopplung an Wellenleiter sind, die geneigt, d.h. nicht senkrecht, auf die zugehörige Chipkante treffen;

Figur 29 eine schematische Darstellung eines Ausführungsbeispiels für ein strahlformendes Element, das neben dem Strahlprofil auch die Propagationsrichtung zweier Strahlen aneinander anpasst;

Figur 30 eine schematische Darstellung eines Ausführungsbeispiels zur Kopplung an Wellenleiter, die geneigt auf die zugehörige Chipkante treffen, wobei sich die strahlformenden Elemente auf einem zweiten Chip oder Faserarray befinden, bei dem die Wellenleiter senkrecht auf die Kante auftreffen;

Figur 31 eine schematische Darstellung eines Ausführungsbeispiels zur Kopplung an Wellenleiter, die geneigt auf die zugehörige Chipkante treffen, wobei pro Koppelstelle zwei strahlformende Elemente verwendet werden;

Figur 32 eine schematische Darstellung eines Ausführungsbeispiels zur Kopplung von zwei Chips mit Wellenleitern, die geneigt auf die zugehörige Chipkante treffen, wobei pro Koppelstelle zwei strahlformende Elemente verwendet werden;

Figur 33 eine schematische Darstellung eines weiteren Ausführungsbeispiels zur Kopplung von zwei Chips mit Wellenleitern, die geneigt auf die zugehörige Chipkante treffen, wobei pro Koppelstelle zwei strahlformende Elemente verwendet werden; und

Figur 34 eine schematische Darstellung eines Ausführungsbeispiels zur Kopplung an Wellenleiter, die geneigt auf die zugehörige Chipkante treffen, wobei die strahlformenden Elemente jeweils aus nur einer refraktiven Fläche bestehen.

## Beschreibung der Ausführungsbeispiele

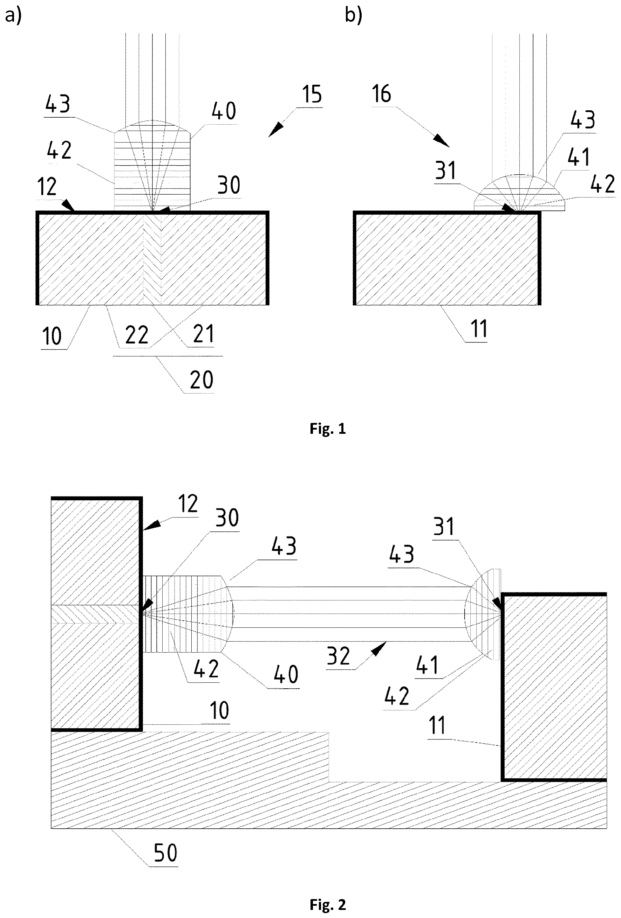

In den Figuren 1 und 2 sind beispielhaft die Schritte c) und d) des vorliegenden Verfahrens zur Herstellung eines optischen Systems aus zwei gesonderten optischen Komponenten 10, 11 dargestellt, wobei sich eine optische Kopplung zwischen der ersten optischen Komponente 10 und der zweiten optischen Komponente 11 ausbildet.

Wie in Figur 1a) dargestellt, wird hierzu gemäß Schritt a) die erste optische Komponente 10 bereitgestellt. In dem vorliegenden Ausführungsbeispiel weist die erste optische Komponente 10 eine unten näher beschriebene Oberflächenmodifikation 12 auf und ist beispielhaft als Licht abstrahlende optische Komponente ausgeführt. Hierzu kann die erste optische Komponente 10 eine optische Faser 20 umfassen, welche einen lichtleitenden Kern 21 und einen den lichtleitenden Kern 21 radial umgebenden Mantel 22 aufweist. Als Folge dieser Ausführung verfügt die erste optische Komponente 10 über ein erstes Strahlprofil 30, welches in dem vorliegenden Ausführungsbeispiel dem bekannten Strahlprofil am Ausgang eines optischen Wellenleiters entspricht. Informationen über das erste Strahlprofil 30 und/oder des das zweite Strahlprofil 31 an der Bauteilfacette lassen sich insbesondere mit einem handelsüblichen Gerät für eine Strahldiagnostik, welches auch als "Beamprofiler" bezeichnet wird, erhalten. Alternativ oder zusätzlich kann das erste Strahlprofil 30 mittels einer Simulation bestimmt werden. Alternativ oder zusätzlich kann das erste Strahlprofil 30 anhand von Herstellerangaben bestimmt werden. Andere Licht abstrahlende optische Komponenten für die erste optische Komponente 10 sind ebenfalls denkbar, darunter aktive optische Komponenten wie z.B. Laser, SLED oder andere Lichtquellen, passive optische Komponenten wie z.B. Einmoden- oder Mehrmodenfasern aus organischen oder anorganischen Materialien, Siliziumphotonik-Chips oder andere integriert-optische Chips auf Basis von Halbleitern oder dielektrischen Materialien wie z.B. Gläsern, Silizium-Dioxid, Silizium-Nitrid oder Polymeren,

Erfindungsgemäß wird die erste optische Komponente 10 gemäß den Schritten b) und c) mit einem für diesen Zweck am Ort der ersten optischen Komponente 10 (in-situ) hergestellten ersten strahlformenden Element 40 versehen. Hierbei wird das erste strahlformende Element 40 über die mit verankernder Wirkung ausgeführte Oberflächenmodifikation 12 wie z.B. einem Haftvermittler derart an der ersten optischen Komponente 10 verankert, dass hierdurch eine um das erste strahlformende Element 40 ergänzte erste optische Komponente 15 erhalten wird. In der in Figur 1a) dargestellten bevorzugten Ausführung wird das erste strahlformende Element 40 derart hergestellt und hierbei auf der Oberflächenmodifikation 12 der ersten Licht abstrahlenden optischen Komponente 10 derart platziert, dass das Licht aus dem Kern 21 der Licht abstrahlenden optischen Faser 20 mit einem möglichst hohem Wirkungsgrad abstrahlen kann. Das erste strahlformende Element 40 wird hierzu vorzugsweise derart ausgeführt, dass der Strahlverlauf sowohl über einen das erste Strahlprofil 30 aufweitenden Abschnitt 42 als auch über einen Abschnitt 43 verfügt, in dem das Strahlprofil 32 einen kollimierten Verlauf aufweist und seinen Querschnitt nur geringfügig ändert. Auf diese Weise lässt sich, wie Figur 1 a) schematisch zeigt, der aus dem Kern 21 der Licht abstrahlenden optischen Faser 20 austretende Lichtstrahl zunächst aufweiten, bevor er anschließend zu einem parallelen (kollimierten) Lichtstrahl gebündelt werden kann. Andere Ausführungen sind jedoch denkbar.

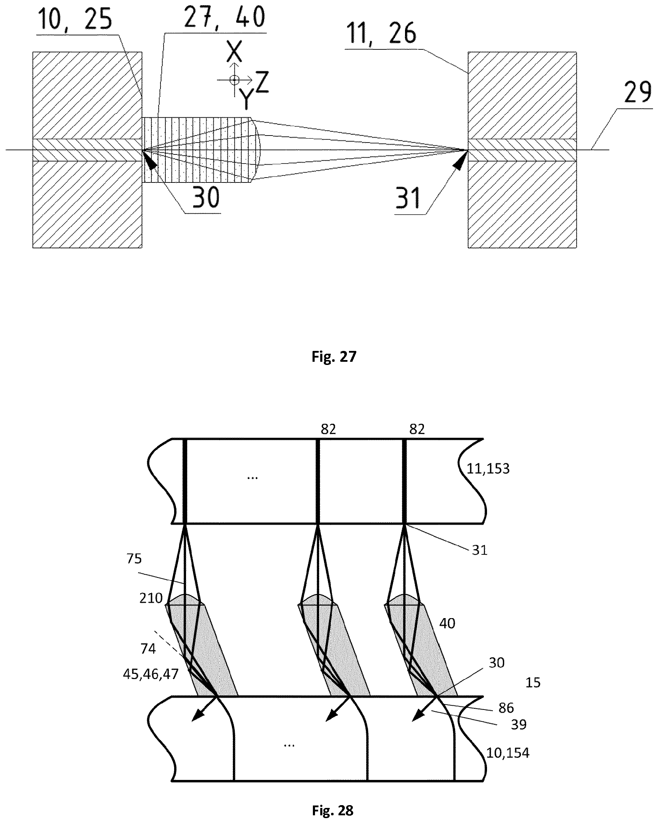

In analoger Weise ist in Figur 1b) schematisch die zweite optische Komponente 11 dargestellt, welche weiterhin gemäß Schritt a) des vorliegenden Verfahrens bereitgestellt wird. Im Unterscheid zur ersten optischen Komponente 10 gemäß Figur 1a) handelt es sich bei der zweiten optischen Komponente 11 um eine Licht empfangende optische Komponente, welche hier beispielsweise als Fotodiode oder Wellenleiter ausgeführt ist. Als Folge dieser Ausführung verfügt die zweite optische Komponente 11 über ein zweites Strahlprofil 31. Gemäß einer besonders bevorzugten Ausgestaltung der vorliegenden Erfindung wird in diesem und den nachfolgenden Ausführungsbeispielen auch die zweite optische Komponente 11 gemäß Schritt b) mit einem für diesen Zweck am Ort der zweiten optischen Komponente 11 (in-situ) hergestellten zweiten strahlformenden Element 41 versehen. Je nach Ausführung des optischen Systems könne auch weitere Ausgestaltungen gewählt werden, insbesondere eine in Figur 27 schematisch dargestellte Ausgestaltung mit nur einem einzigen strahlformenden Element. In der vorliegend dargestellten Ausführung wird das zweite strahlformende Element 41 derart an der zweiten optischen Komponente 11 verankert, dass hierdurch eine um das zweite strahlformende Element 41 ergänzte zweite optische Komponente 16 erhalten wird. Das zweite strahlformende Element 41 wird hierbei derart hergestellt und auf einer Oberfläche der zweiten Licht empfangenden optischen Komponente 11 derart platziert, dass die zweite optische Komponente 11 einen besonders hohen Anteil des sie beaufschlagenden Lichts aufnehmen kann.

In Figur 2 ist schematisch dargestellt, wie sich gemäß Schritt c) das erste strahlformende Element 40 das erste Strahlprofil 30 und das zweite strahlformende Element 41 das zweite Strahlprofil 31 derart verändern, dass sich über ein Modenfeld mit aufgeweitetem Profil 32 eine optische Kopplung zwischen der ersten optischen Komponente 10 und der zweiten optischen Komponente 11 ausbildet. Die optische Kopplung zwischen der ersten optischen Komponente 10 und der zweiten optischen Komponente 11 wird hierbei vorzugsweise derart gewählt, dass die optische Kopplung maximal ist und gleichzeitig eine Positionierungstoleranz oberhalb der Positionierungsgenauigkeit des verwendeten Montagesystems sichergestellt ist.

Zur Erzeugung der optischen Kopplung wurden gemäß Schritt c) die um die strahlformenden Elemente 40, 41 ergänzten optischen Komponenten 15, 16 auf einem gemeinsamen Grundplatte 50 positioniert und fixiert. Die Grundplatte kann hierbei planar ausgeführt sein oder, wie Figur 2 schematisch zeigt, auch über eine nicht-planare Oberfläche, etwa in Form von einer oder mehreren Stufen, verfügen. Die optischen Komponenten 10, 11 werden mit der gewählten Positionierungsgenauigkeit auf der Grundplatte 50 aufgebracht, wobei sich die Positionierungsgenauigkeit aus einer Summe von Abweichungen von einer nach erfolgter Positionierung und Fixierung auf der Grundplatte 50 ermittelten Ist-Position der optischen Komponenten 10, 11 im Vergleich zu einer gewünschten Soll-Position der optischen Komponenten 10, 11 zueinander ergibt.

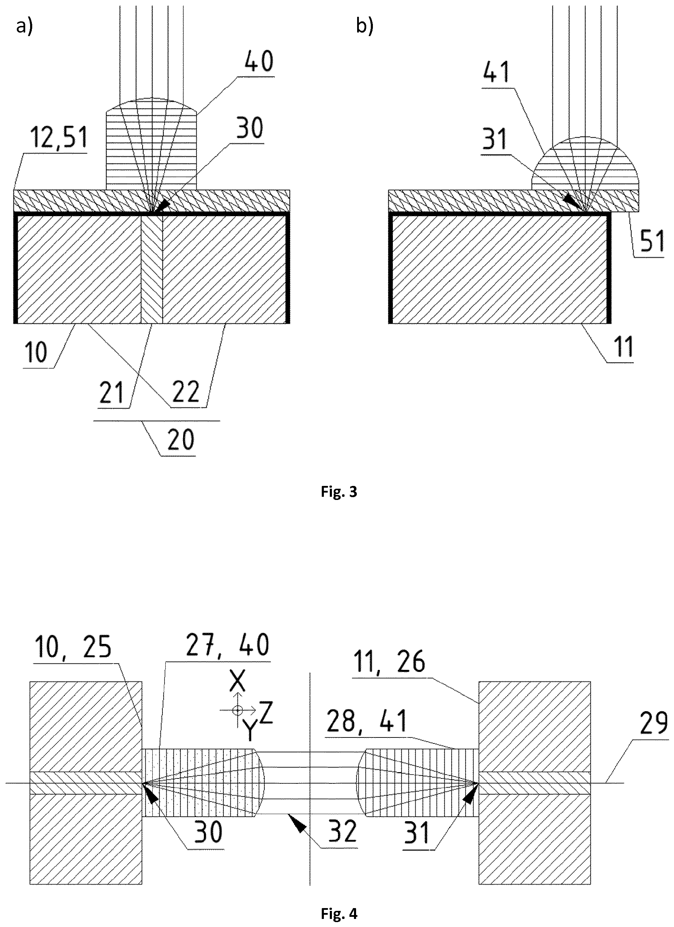

Figur 3a) zeigt eine schematische Darstellung eines weiteren Ausführungsbeispiels für die erste optische Komponente 10, welche mit dem ersten strahlformenden Element 40 verbunden ist. Im Unterschied zur Darstellung gemäß Figur 1a) umfasst hier die Oberflächenmodifikation 12 der ersten Licht abstrahlenden optischen Komponente 10 eine als Abstandhalter 51 ausgeführte Haltestruktur, welcher vorzugsweise in Form einer festen Grundplatte, als eine Oberflächenbeschichtung und/oder eine Funktionalisierung der Oberfläche ausgeführt ist. Alternativ oder zusätzlich kann die Haltestruktur 51 auch durch ein lithographisches Verfahren hergestellt werden, welches vorzugsweise in demselben Verfahrensschritt, der auch die Herstellung der strahlformenden Elemente 40, 41 umfasst, erfolgen kann, siehe Figur 5. Die Verwendung des Abstandhalters 51 und/oder von strahlformenden Elementen 40, 41, welche direkt über eine Haltestruktur 44 (siehe Figur 5) verfügen, kann insbesondere vorteilhaft sein, um die strahlformende Elemente 40, 41 von der optischen Komponente 10, 11 räumlich zu trennen. Dadurch kann eine beim Schreiben der strahlformenden Elemente 40, 41 durch den Lithographiestrahl hervorgerufene Beschädigung der optischen Komponente 10, 11 vermieden werden. Zudem lassen sich hierdurch Wechselwirkungen zwischen der optischen Komponente 10, 11 und einem Lithographie-Laserstrahl, die zu einer Beeinträchtigung der Ergebnisse aus der Lithographie führen können, etwa durch Abschattung oder Mikroexplosionen in der Nähe von metallischen Bauteilen, weitgehend verhindern. Weiterhin verringert sich die auf das strahlformende Element auftreffende Intensität durch mit zunehmendem Abstand des Elements von der Facette des optischen Elements, so dass eine Beabstandung auch zu einer erhöhten Stabilität bzgl. hoher optischer Leistungen führen kann.

Figur 3b) zeigt eine schematische Darstellung eines weiteren Ausführungsbeispiels für die zweite optische Komponente 11, welche mit dem zweiten strahlformenden Element 41 verbunden ist. Im Unterschied zur Darstellung gemäß Figur 1b) ist hier eine dem Licht zugewandte Oberfläche der Licht empfangenden optischen Komponente ebenfalls mit dem Abstandhalter 51 versehen, welcher hier in Form einer Schicht ausgeführt ist.

Figur 4 zeigt schematisch ein weiteres Ausführungsbeispiel für ein optisches System zur optischen Kopplung zwischen einer ersten optischen Komponente 10, die in Form einer ersten Einmodenfaser (Single-Mode Faser, SMF) 25 vorliegt, und einer zweiten optischen Komponente 11, die in Form einer zweiten Einmodenfaser 26 vorliegt. Hierzu wurde mittels Zwei-Photonen-Lithographie sowohl auf der ersten Einmodenfaser 25 eine erste Linse 27 als auch auf der zweiten Einmodenfaser 26 eine zweite Linse 28 erzeugt, welche dazu eingerichtet sind, Licht verlustarm von einer Faser zur anderen zu koppeln. Hierbei konnte in einem Experiment ein Kopplungsverlust von 0,86 dB und eine Positionierungstoleranz bei Bewegung senkrecht zur optischen Achse 29 von 8,5 $\mu$m festgestellt werden. Die Positionierungstoleranz kann insbesondere als Durchmesser des Bereichs definiert werden, in dem die Kopplungverluste weniger als 1 dB betragen, so dass die Kopplungseffizienz mehr als 85 % beträgt.

In einer weiteren Ausführung des optischen Systems gemäß Figur 5 verfügen beide Einmodenfasern 25, 26 über dedizierte Strahlaufweiter (Beam-Expander) 83, die die Divergenz des aus den Bauteilfacetten austretenden Lichtes künstlich vergrößern und damit bei einem gegebenen Strahldurchmesser im kollimierten Abschnitt eine kürzere Bauform der strahlaufweitenden Elemente ermöglichen. In einer ersten experimentellen Realisierung betrug der Kopplungsverlust 1,9 dB und die 3 dB Positionierungstoleranz senkrecht zur optischen Achse 29 ergab einen Wert von 17,7 $\mu$m, welcher etwa doppelt so groß wie im Falle der Struktur nach Figur 4 war.

Weiterhin weist die Ausführung des optischen Systems gemäß den Figuren 5, 6, 8, 9 und 13 Haltestrukturen 44 auf, auf welchen eine Linse aufgebracht ist. Die Haltestrukturen 44, die vorzugsweise in Form von Pfeilern vorliegen, werden bevorzugt derart an einer Stelle der optischen Komponenten 10, 11 verankert, dass entweder keine unerwünschten Wechselwirkungen des Lithographie-Systems mit der zu beschreibenden optischen Komponente 10, 11 auftreten und/oder dass die eventuell durch den Schreibprozess auftretenden Wechselwirkungen unterhalb einer Einflussschwelle bleiben.

Figur 6 zeigt schematisch ein weiteres Ausführungsbeispiel für das optische System, in welchem ein Einbettungsmedium 52 eingesetzt wird. Das Einbettungsmedium 52 ist insbesondere dazu eingerichtet, um etwaige optische Verluste durch Reflexion zu reduzieren und/oder die optischen Strukturen vor Umwelteinflüssen zu schützen. Bei dem Einbettungsmedium 52 handelt es sich bevorzugt um ein transparentes, beispielsweise durch Temperatur oder Beaufschlagung mit UV-Strahlung aushärtendes Medium. Die Einbettung von optischen Bauteilen des optischen Systems in ein Einbettungsmedium 52 kann zu komplexeren optischen Systemen führen, wie in Figur 6 dargestellt. Dies erlaubt es, eine große Anzahl an strahlformenden Elementen 40, 41 zu verwenden, ohne dass hohe Reflexionsverluste entstehen. Das Einbettungsmedium 52 kann, je nach Ausführung hierbei einen niedrigerem oder einen höheren Brechungsindex im Vergleich zu den strahlformenden Elemente 40, 41 aufweisen.

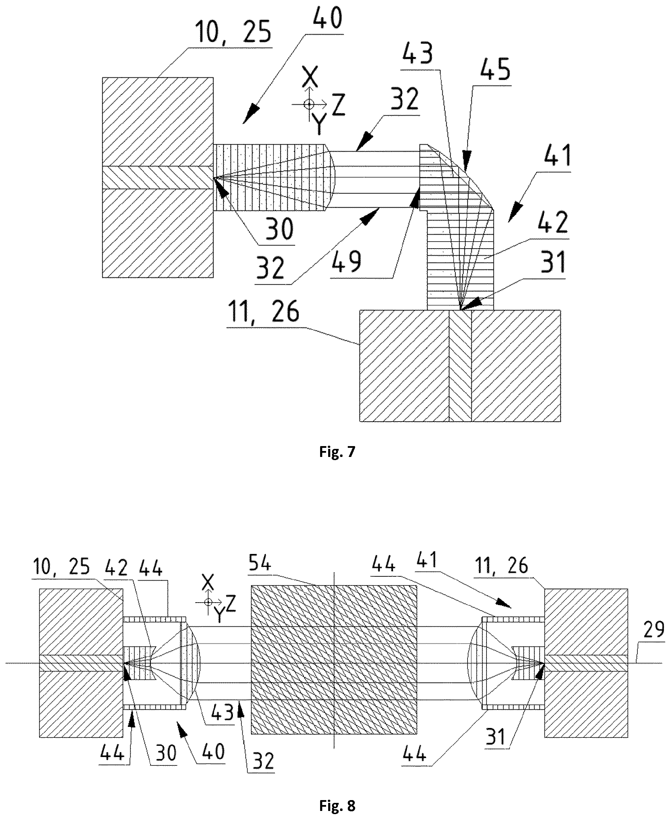

Figur 7 zeigt eine weitere Variation der erfindungsgemäßen Ausgestaltung einer optischen Kopplung, die einen konvexen Spiegel 45 anstelle eines brechenden optischen Bauteils verwendet. Dieser Spiegel kann entweder auf Totalreflexion an der Grenzfläche zwischen dem strahlformenden Element 42 und dem umgebenden Material beruhen, oder aber eine Metallbeschichtung auf dieser Grenzfläche enthalten.

Figur 8 zeigt ein weiteres Ausführungsbeispiel für das optische System, das über ein zusätzliches optisches Element 54 verfügt, welches in die Koppelstrecke eingebracht ist. Das Einbringen des zusätzlichen optischen Elements 54 wird insbesondere dadurch ermöglicht, dass sich durch Vergrößerung und Kollimation des Modenfelds 32 zwischen den beiden optischen Komponenten 10, 11 inhärent ein Lichtstrahl ausbildet, welcher über längere Strecken mit geringer Aufweitung propagieren kann. Bei dem zusätzlichen optischen Element 54 kann es sich beispielsweise um Bauteile handeln, die sich auf optischen Chips nur schwer realisieren lassen, z.B. optische Dünnschicht-Filter, Polarisatoren, Strahlteiler, Wellenplatten, oder nicht-reziproke Bauteile wie Faraday-Rotatoren oder Isolatoren. Das Einbringen von anders ausgestalteten zusätzlichen optischen Elementen 54 ist ebenfalls möglich. Insbesondere kann es sich bei den zusätzlichen optischen Element 54 um ein Durchloch (Via) in einem Chip, um ein transparentes Fenster in einem Chip, oder um einen transparenten Chip handeln.

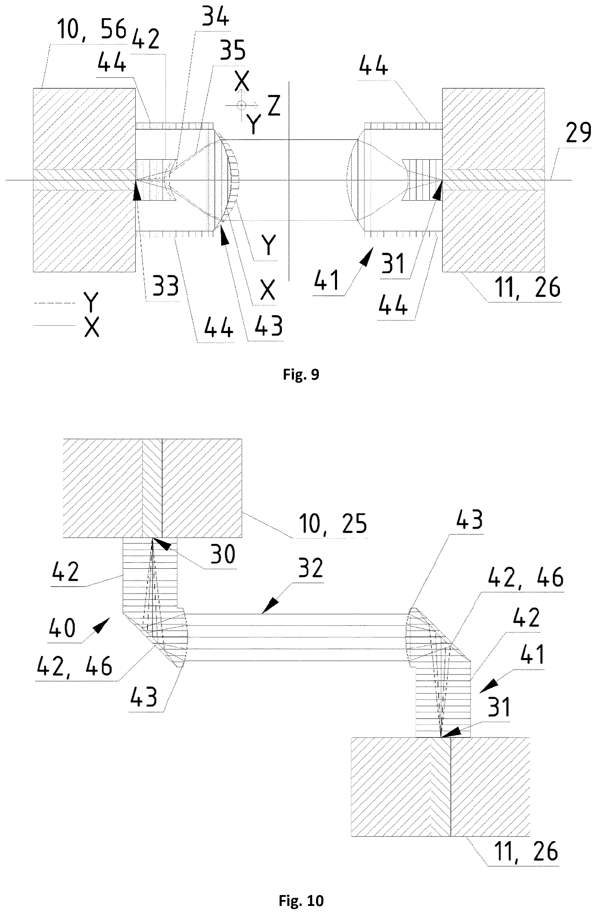

Eine Verwendung von Freiformoptik kann eine Kaskadierung von mehreren strahlformenden Elementen 40, 41 erlauben, wodurch insbesondere die Anzahl von Freiheitsgraden erhöht werden kann. Wie in Figur 9 schematisch dargestellt, kann damit, alternativ oder zusätzlich, auch ein nicht-rotationssymmetrisches Strahlprofil 33, welches eine geringere Ausdehnung in die eine Richtung 35 und eine höhere Ausdehnung in die andere Richtung 34 aufweist, in ein rotationssymmetrisches Strahlprofil 31 überführt werden, wobei sich die strahlformenden Elemente 40, 41 grundsätzlich an einem beliebigen Ort befinden können. Die Ausführung gemäß Figur 9 kann somit beispielsweise zur optischen Ankopplung von kantenemittierenden Halbleiterlasern oder von integriert-optischen Chips 56 mit rechteckigen Wellenleiterquerschnitten eingesetzt werden. Kantenemittierende Halbleiterlaser weisen oftmals ein Strahlprofil auf, welches über unterschiedliche Divergenzen in X- und Y-Richtung verfügt. Um ein derartiges Strahlprofil effizient in die zweite Einmodenfaser 26 einkoppeln zu können, ist eine in Bezug auf die optische Achse 29 nicht rotationssymmetrische Ausgestaltung des optischen Systems erforderlich. Die strahlformenden Elemente 40, 41 sind hierzu vorzugsweise derart beschaffen sein, dass die vom Halbleiterlaser 56 emittierten Lichtstrahlen möglichst im selben Winkel auf die Einmodenfaser 26 treffen und zudem ein Modenfeld 31 ausbilden, welches an das Modenfeld der Einmodenfaser 26 angepasst ist. Damit möglichst geringe Anforderungen an die Positionierungstoleranz auftreten, kann vorzugsweise das in Figur 9 schematisch dargestellte und im Folgenden beschriebene Anpassungsverfahren eingesetzt werden:

Es werden Durchmesser des Strahlprofils 30 des Halbleiterlasers 56 und des Modenfelds 31 der zweiten Einmodenfaser 26 bestimmt. Hierbei können Herstellerangaben oder, alternativ oder zusätzlich, eine Messung des Strahlprofils verwendet werden. Anhand des ermittelten Strahlprofils 30, 31 kann eine vorteilhafte Ausgestaltung des optischen Systems sowohl für den Halbleiterlaser 56 als auch für die Einmodenfaser 26 bestimmt werden. Eine geeignete Auslegung der strahlformenden Elemente kann dabei insbesondere die erreichbare Positionierungstoleranzen für die zu verbindenden optischen Bauteile in Betracht ziehen, ein optional zu verwendendes Cladding-Material berücksichtigen und/oder prozessbedingte Abweichungen von der gewünschten Form, wie z.B. Schrumpf durch eine entsprechende Vorkompensation verhindern. Der Halbleiterlaser 56 und die zweite Einmodenfaser 26 können nun nacheinander oder gemeinsam in einem Lithographie-System fixiert werden. Die Position des Halbleiterlasers wird durch eine kamerabasierte Erkennung oder konfokales bildgebendes Verfahren detektiert. Die Position der Faser bzw. des Faserkerns kann, wie oben näher beschrieben, durch eine kamerabasierte Erkennung oder durch eine kamerabasierte Erkennung von Licht, welches in die Faser gekoppelt wurde, erkannt werden. Die zuvor bestimmte Ausgestaltung des Halbleiterlasers 56 und der zweiten Einmodenfaser 26 werden geschrieben und entwickelt. Anschließend können der Halbleiterlaser 56 und die zweite Einmodenfaser 26 von ihrer Fixierung gelöst und auf der gemeinsamen Grundplatte 50 in der zuvor definierten Position montiert werden, wobei ggf. ein aktives Alignement ausgeführt kann. In einem weiteren Schritt können die strahlformenden Elemente 40, 41 optional in einem gemeinsamen Einbettungsmedium eingebettet werden. Der auf diese Weise verringerte Brechungsindexkontrast wird bei der Ausgestaltung und der Bestimmung der optischen Elemente vorzugsweise mit berücksichtigt. Das hier beschriebene Anpassungsverfahren kann insbesondere für die Kopplung von Fasern, insbesondere von Einmodenfasern, an Strahlungsquellen wie Laser oder SLED, an planare Wellenleiter oder an Fotodioden eingesetzt werden. Falls keine Herabsetzung der Anforderungen an die Positioniergenauigkeit erforderlich ist, kann eines der strahlformenden Elemente 40, 41 auch ausschließlich auf die Laser oder Faser-Facetten geschrieben werden.

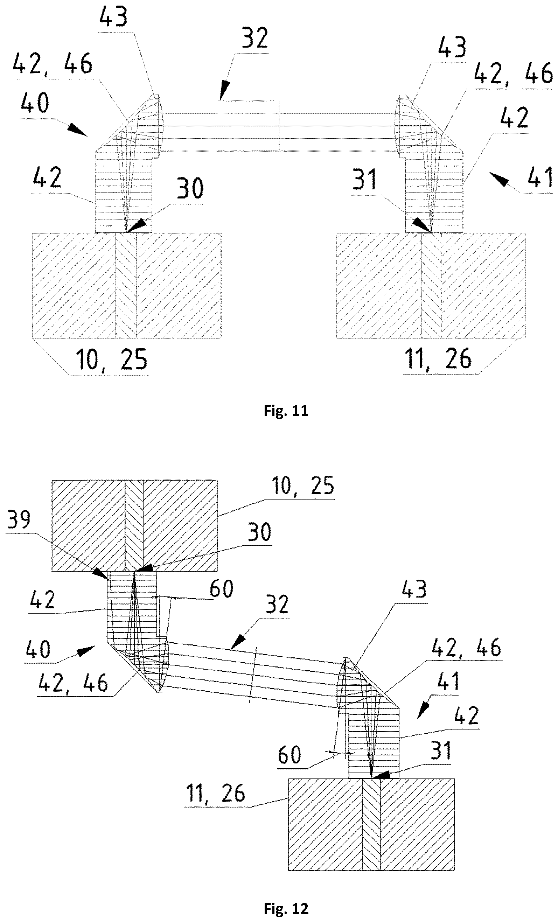

Die Figuren 10, 11 und 12 zeigen jeweils weitere Möglichkeiten, eine optische Kopplung auszugestalten und zwar durch Einsatz von konkaven Spiegeln 46 anstelle von refraktiven optischen Bauteilen. Die in den Figuren 10, 11 und 12 schematisch dargestellten optischen Systeme unterscheiden sich lediglich durch die jeweilige Ausführung des Strahlengangs. Darüber hinaus zeigt Figur 12 eine weitere Möglichkeit, Rückkopplungen durch Rückreflexion 39 zu vermeiden. Dies kann für verschiedene optische Bauteile, insbesondere für Super-Lumineszenz-Dioden (SLEDs) oder Laser, erforderlich oder besonders vorteilhaft sein. Für die Unterdrückung von Rückkopplungen durch Rückreflexionen werden dabei Flächen 47 der strahlformenden Elemente 40, 41, welche die Rückkopplung bewirken könnten, um einen Winkel 60 (Verkippungswinkel) gekippt so dass Lichtstrahlen nicht mehr senkrecht auf Grenzflächen treffen können. Das reflektierte Licht 39 gelangt somit nicht mehr zurück in die optische Komponente 10, 11. In einer bevorzugten Ausgestaltung kann der Winkel 60 einen Wert von 3° bis 40°, besonders bevorzugt von 5° bis 15°, insbesondere von 7° bis 10° annehmen. Der Winkel 60 ist im Allgemeinen abhängig von den verwendeten optischen Bauteilen und ist vorzugsweise so beschaffen sein, dass keine signifikante Rückkopplungen durch Rückreflexionen in dem optischen System auftreten kann.

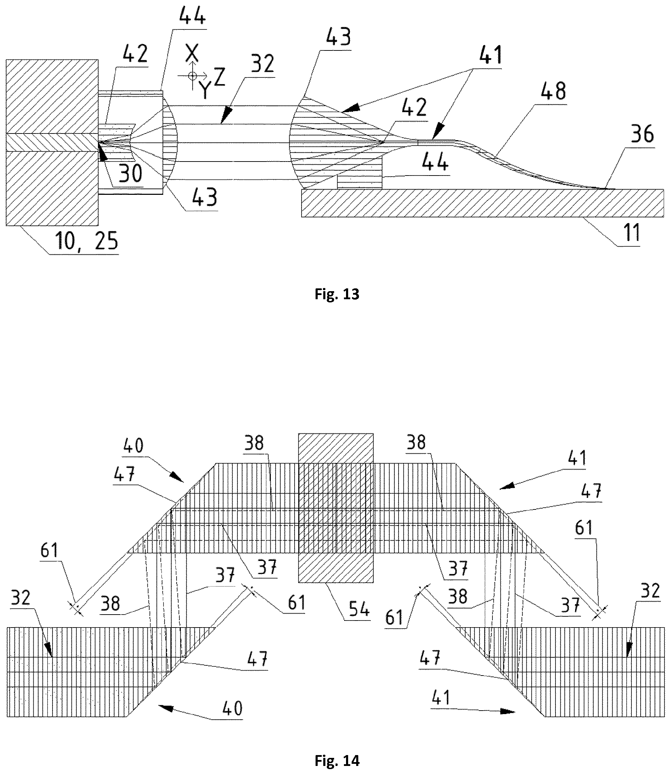

Figur 13 zeigt ein weiteres nicht-erfindungsgemäßes Beispiel für ein optischen System, welches dazu eingerichtet ist, um einen von der Einmodenfaser 25 abgestrahlten Lichtstrahl in das strahlformende Element 41, welches einen optischen Freiformwellenleiter 48 umfasst, einzukoppeln. Für die optische Kopplung eines photonischen Schaltkreises mit der Einmodenfaser 26 wird zunächst die Struktur des Freiformwellenleiters 48 auf eine spitz zulaufende Verjüngung ("Inverser Taper") 36 eines integrierten Siliziumwellenleiters 85 geschrieben, wobei der integrierte Wellenleiter 48 derart dimensioniert ist, dass Licht effizient in integrierten Wellenleiter 85 eingekoppelt werden kann. Das strahlformende Element weist neben dem Wellenleiter 48 noch einen sich aufweitenden Teil 42 auf, in dem aus dem Wellenleiter 42 austretende Lichtstrahl stark divergiert, bevorzugt mit einem Divergenzwinkel von 2° bis 45°, besonders bevorzugt von 4° bis 30°, und ganz besonders bevorzugt von 10° bis 25°. Anschließend wird das Licht in dem kollimierenden Teil 43 des der optischen Komponente 41 kollimiert und durch eine weitere Linse auf die Facette optische Komponente 10 wie im Falle einer Einmodenfaser fokussiert.

Figur 14 zeigt ein weiteres nicht-erfindungsgemäßes Beispiel für ein optisches System, bei welchen sich Winkelabweichungen reflektierender Flächen der strahlformenden Elemente 40, 41 automatisch kompensieren.

Wie bereits erwähnt, sind die optischen Verluste insbesondere von der Anzahl der optischen Grenzflächen sowie der Differenz zwischen den Brechungsindizes (Indexkontrast) zwischen den beiden Materialen, welche eine Grenzfläche bilden, abhängig. Die Figuren 15 a) bis d) zeigen Ausführungsbeispiele für verschiedene strahlformende Elemente 40, in welchen zur Verringerung der Reflexionsverluste wenige optische Grenzflächen mit hohem Indexkontrast durch eine Vielzahl optischer Grenzflächen mit niedrigem Brechungsindex verwendet werden. Während in Figur 15a) das strahlformende Element 40 aus einer einzelnen Sammellinse (bikonvexe Linse) gebildet wird, welche über einen Brennpunkt 70 und eine Brennweite 73 verfügt, zeigen die Figuren 15b) bis d) verschiedene strahlformende Elemente 40, welche über eine Mehrzahl von Linsen unterschiedlicher Form verfügen, die jeweils in das Einbettungsmedium 52, 53 eingebracht sind. Figur 15b) zeigt schematisch ein weiteres Ausführungsbeispiel für das strahlformende Element 40 aus Resistmaterial 57, das drei bikonvexe Linsen aufweist, die in das Einbettungsmedium 52 mit niedrigerem Brechungsindex als die drei bikonvexen Linsen eingebracht sind. Figur 15c) zeigt schematisch ein weiteres Ausführungsbeispiel für das strahlformende Element 40, das drei bikonkave Linsen aufweist, die in das Einbettungsmedium 53 mit höherem Brechungsindex als das Resistmaterial 57 der drei bikonkaven Linsen eingebracht sind. In Figur 15d) ist schließlich ein weiteres Ausführungsbeispiel für das strahlformende Element 40 dargestellt, in welchem das strahlformende Element 40 als drei Hohlräume 55 in Form von bikonkaven Linsen ausgeführt ist. Die Hohlräume 55 können mit einem Medium 52 mit niedrigerem Brechungsindex als der Resist gefüllt werden oder auch ungefüllt bleiben. Insbesondere können sich die Brechungsindizes in den Hohlräumen unterscheiden. Zur Herstellung der strahlformenden Elemente kann auch ein Material genutzt wird, dessen Brechungsindex sich durch eine Belichtung permanent ändert. Hierzu können sich insbesondere ein Ormocer®, ein Glas oder ein Polymer eignen.

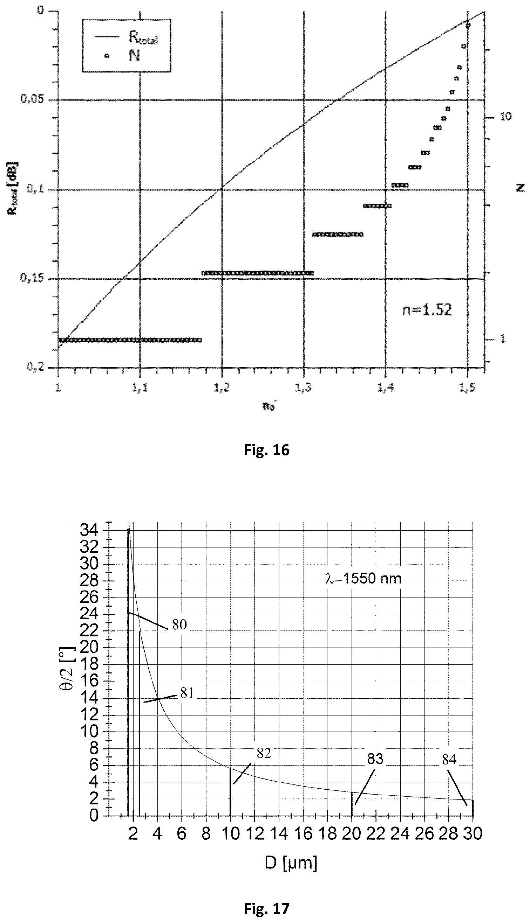

Generell gilt, dass ein optisches System mit vielen optischen Grenzflächen und einem niedrigem Indexkontrast geringere Rückreflexionen aufweist als ein im Hinblick auf die Brechkraft äquivalentes optisches System mit einem hohem Indexkontrast und wenigen Grenzflächen. Dies ist in Figur 16 beispielhaft veranschaulicht, indem die Ergebnisse aus der obigen Gleichung (6) unter einer Annahme dargestellt werden, dass der Brechungsindex n der Linsen 1,52 beträgt. Wie in Figur 16 dargestellt, ergibt sich eine Abnahme des Gesamtverlustes $R_{total}$ bei einer Annährung des Brechungsindex $n'_0$ des Umgebungsmediums an den Brechungsindex der Linsen. Auf diese Weise lassen sich somit Kopplungsverluste verringern, allerdings auf Kosten einer hohen Anzahl an optischen Grenzflächen. Wie oben bereits erwähnt, kann die Anzahl der optischen Grenzflächen bevorzugt von 1 bis 100, besonders bevorzugt von 4 bis 50, insbesondere von 6 bis 12 gewählt werden.

Wie oben bereits erwähnt, kann durch eine Herabsetzung der Positionierungsgenauigkeit eine Erhöhung der Empfindlichkeit der optischen Bauteile im Hinblick auf eine rotatorische Positionierungenauigkeit auftreten. Hierbei kann die Divergenz, welche durch den Öffnungswinkel $\Theta$ quantifiziert wird, bei Abstrahlung eines Modenfelds als Ausgangspunkt für eine Abschätzung der Positionierungstoleranz bezüglich rotatorischer Abweichungen im Fixierungsprozess eingesetzt werden. Figur 17 zeigt den Verlauf des halben Öffnungswinkel ½ $\Theta$ in Grad (°) bei einer Wellenlänge $\lambda$ = 1550 nm gegenüber einem Durchmesser D des Modenfelds bei einer Intensität des Lichts von $1/e^2$, d.h. ca. 13,5 %, der maximalen Intensität des Lichts. und gibt folgende Ausgestaltungen für verschiedene Durchmesser D des Modenfelds an:

- Modenfeldkonverter (taper) basierend auf Silicon-on-Insulator-(SOI-) Wellenleitern 80 mit einem Modenfelddurchmesser von 1,6 μm und einem halben Öffnungswinkel von 34°;
- Modenfeldkonverter (taper) basierend auf Indiumphosphid (InP) 81 mit einem Modenfelddurchmesser von 2,5 μm und einem halben Öffnungswinkel von 22°;
- Einmodenfaser (SMF) 82 mit einem Modenfelddurchmesser von 10 μm und einem halben Öffnungswinkel von 5,6°;
- Aufgeweitetes Modenfeld 32 des Strahlaufweiter (Beam Expander) 83 mit einem Modenfelddurchmesser von 20 μm und einem halben Öffnungswinkel von 2,8°; und
- Aufgeweitetes Modenfeld 32 des Strahlaufweiter in Einbettungsmedium 84 mit einem Strahlprofil von 30 μm und einem halben Öffnungswinkel von 2°.

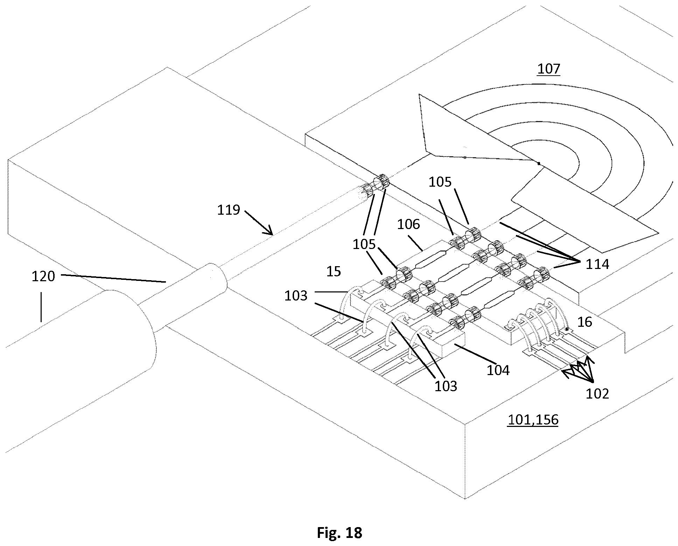

Figur 18 zeigt schematisch ein weiteres Ausführungsbeispiel für ein optisches System, in welchem die optischen Komponenten, hier ein Laserbarren 104 und ein Modulator-Array 106, jeweils über eine Mehrzahl von Koppelstellen 130 bis 137 verfügen können, wobei das optische System gemäß den folgenden Schritten hergestellt werden kann:

1. Bereitstellung einer Grundplatte 101, welche über Leiterbahnen 102 für Hochfrequenz-Signale verfügt. Die Grundplatte 101 weist ein Oberflächenprofil auf, das ein einfaches Fixieren möglichst aller optischen Bauteile auf geeigneter Höhe ermöglicht. Der Begriff "geeignet" bedeutet dabei, dass sich der Mittelpunkt der Modenfeldprofile aller optischen Bauteile auf der gleichen Höhe befindet.

2. Konzeption des optischen Systems. Dieser Schritt umfasst eine Festlegung der Position der optischen Komponenten 104 und 106 sowie die Position der zu erstellenden strahlformenden Elemente 105. In dem Ausführungsbeispiel gemäß Figur 18 handelt es sich dabei um ein Array aus kantenemittierenden Lasern 104, elektrisch kontaktiert mit Bonddrähten 103, Strahlaufweitern (Expandern) 105, einen optischen Chip 106 mit einem Array aus elektro-optischen Modulatoren, elektrisch kontaktiert mit Bonddrähten 103, und ein Arrayed-Waveguide-Grating (AWG) 107 mit optischen Modenfeldaufweitern 114 sowie eine optische Faser 119 mit der Ummantelung 120. Die Konzeption des optischen Systems umfasst weiterhin die Simulation der Strahlaufweiter (Expander) 105 hinsichtlich optimaler Kopplung sowie möglichst großer Aufweitung im kollimierten Teil des Strahlprofils.

3. Umwandlung der in Schritt 2. erstellten Simulationsdaten in ein maschinenlesbares Format und Herstellung der strahlformende Elemente 105 an den zu verbindenden optischen Komponenten 104, 106, 107, wodurch die um die strahlformenden Elemente ergänzten optischen Komponenten erhalten werden.

4. Fixierung der um die strahlformenden Elemente erhaltenen optischen Komponenten an die gemäß Schritt 3 vorgesehenen Positionen. Hierbei wird vorzugsweise eine Positionierungsgenauigkeit eingehalten, welche sich aus den Schritten 2 und 3 ergibt.

5. Optionale Einbettung der um die strahlformenden Elemente ergänzten optischen Komponenten in ein Umgebungsmedium.

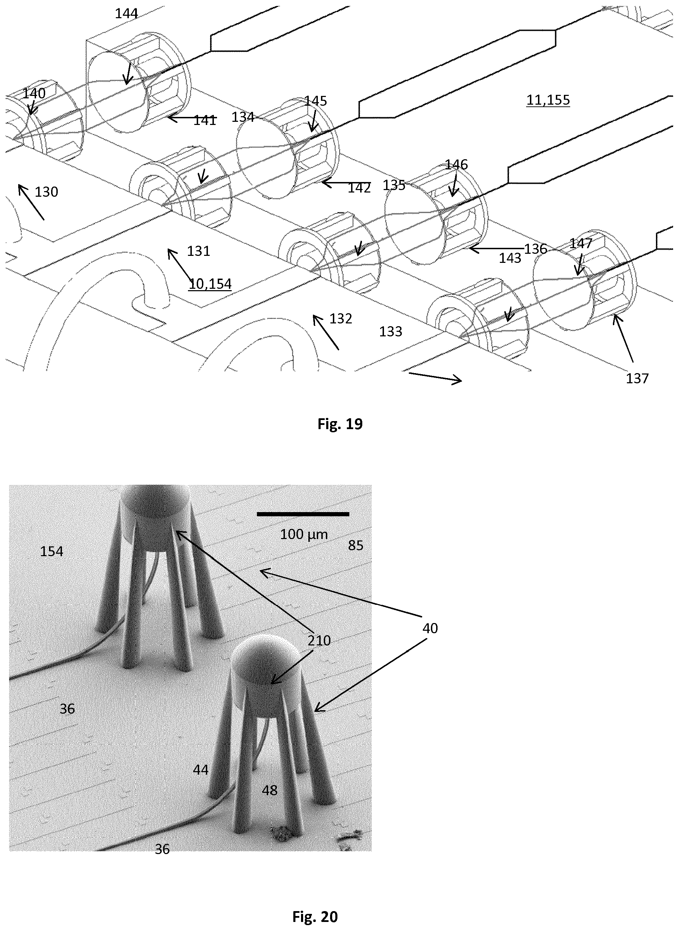

Figur 19 zeigt die Verbindung von optischen Komponenten 10, 11, welche jeweils über eine Mehrzahl von Facetten 130 bis 137 verfügen. Durch die erfindungsgemäß herabgesetzten Anforderungen an die Ausrichtgenauigkeit ist es möglich, die erste optische Komponente 10 und die zweite optische Komponente 11 über die Mehrzahl der Koppelstellen 130 bis 137 durch geeignete, in Figur 19 schematisch dargestellte strahlformende Elemente 140 bis 147 zu verbinden.

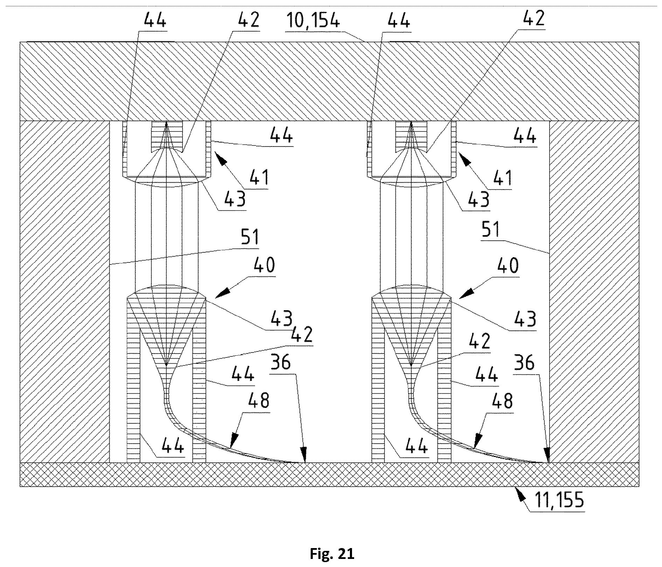

Figur 20 zeigt eine elektronenmikroskopische Aufnahme eines weiteren Ausführungsbeispiels der strahlformenden Elemente 40, 41, welche jeweils eine Kombination aus einem Lichtwellenleiter 48 und einen kollimierendem Teil 43 aufweisen. Die in Figur 20 dargestellten strahlformenden Elemente 40, 41 können insbesondere in dem weiteren Ausführungsbeispiel des optischen Systems in Figur 21 eingesetzt werden. Hierdurch lassen sich zwei optische Komponenten 10, 11 mit geringen Anforderungen an Ausrichtungsgenauigkeiten auch an mehreren Koppelstellen optische miteinander verbinden. Hierbei werden die optischen Komponenten 10, 11 jeweils auf Abstandshaltern 51 platziert, so dass ein definierter Abstand zwischen den optischen Komponenten 10, 11 gegeben ist. In den gezeigten Ausführungsbeispiel handelt es sich bei der optischen Komponente 10 um ein oberflächenemittierendes Bauteil, während 11 einen optischen Chip mit in der Chip-Ebene verlaufenden planaren Wellenleitern darstellt, die an die senkrecht zur Chip-Ebene emittierenden strahlformenden Elemente 40 angeschlossen sind.

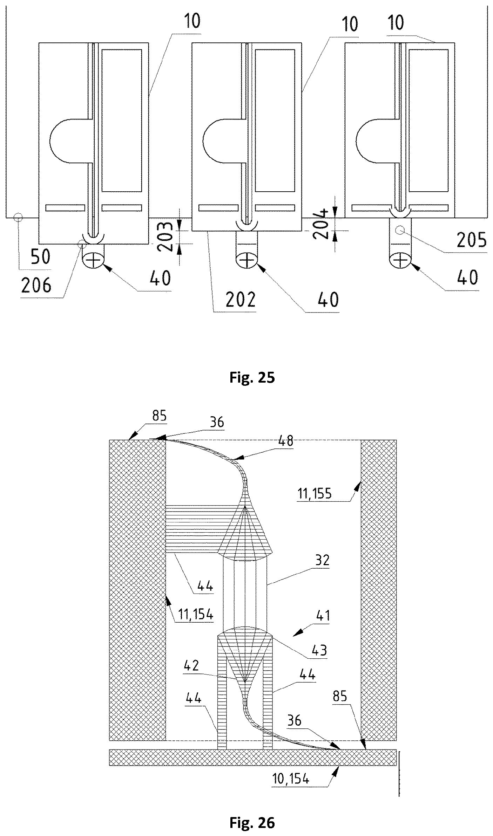

Weiterhin können auch zwei Chips 154 und 155 mit in der Chip-Ebene abstrahlenden planaren Wellenleitern 85 verbunden werden, in der Art- und Weise dass sie aufeinander gestapelt sind und die Oberflächen in die gleiche Richtung zeigen. Ein entsprechendes Ausführungsbeispiel ist in Figur 26 dargestellt. In diesem Fall sind die strahlformenden Elemente so ausgelegt, dass sie zu einer Lichtabstrahlung in einer Richtung führen, die im Wesentlichen senkrecht zur Oberfläche der Chips orientiert ist. In dem in Figur 26 skizzierten Fall emittiert ist das mit dem Chip 155 verbundene strahlformende Element so ausgelegt, dass die Lichtemission durch eine Aussparung oder eine transparentes Fenster im Chip erfolgt bzw. dass Licht aus dieser Richtung empfangen wird. Insbesondere kann es sich dabei um das Material handelt, aus welchem der Chip besteht. In einer weiteren Ausprägung wird das Licht an der Kante des Chips entlang geführt, sodass kein Fenster oder Durchloch im Chip notwendig ist. So lassen sich komplexe gestapelte Multi-Chip-Systeme herstellen, die auch aus mehr als den hier gezeigten zwei Chips bestehen können.

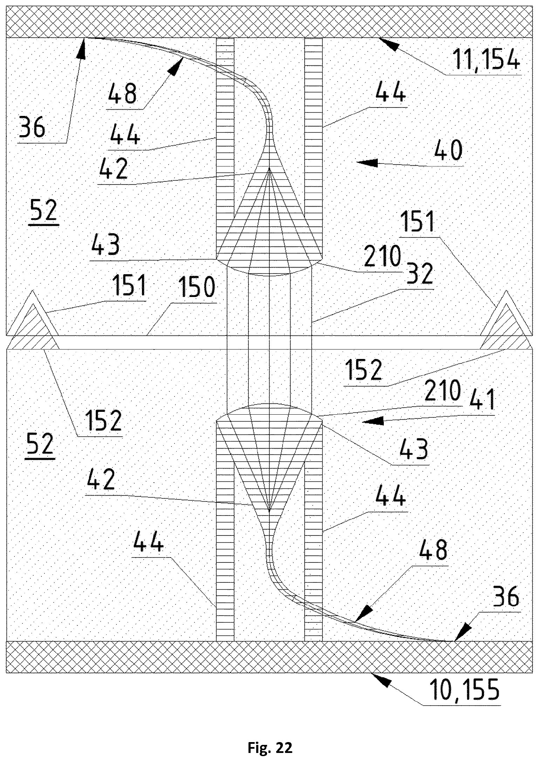

Zusätzlich oder statt der Abstandshalter kann auch, wie in Figur 22 gezeigt, ein an der Oberfläche 150 planarisiertes Umgebungsmedium 52 verwendet werden, welches die strahlformenden Komponenten 40 und 41 einbettet. Zur Erhöhung der Brechkraft der in den strahlformenden Elementen 40 und 41 auftretenden refraktiven Fläche 210 können diese in kaskadierter Form ausgeführt sein, siehe auch Figur 6. Das planarisierte Umgebungsmedium ist derart beschaffen, dass es einen präzisen Abstand zwischen den optischen Komponenten 10 und 11 sicherstellt. Das Planarisierungsmedium kann weiterhin optional mit Ausrichtstrukturen versehen sein. Diese können beispielsweise aus einem Zapfen 152 und einer für den Zapfen geeigneten Nut 151 bestehen. Die Stützstrukturen 44 und die Freiformwellenleiter 48 sind in Figur 21 und Figur 22 derart ausgeführt, dass es keinen physikalischen Kontakt zwischen den beiden Elementen gibt und insbesondere keine Wechselwirkung zwischen dem Licht im Freiformwellenleiter 48 und der Stützstruktur 44.

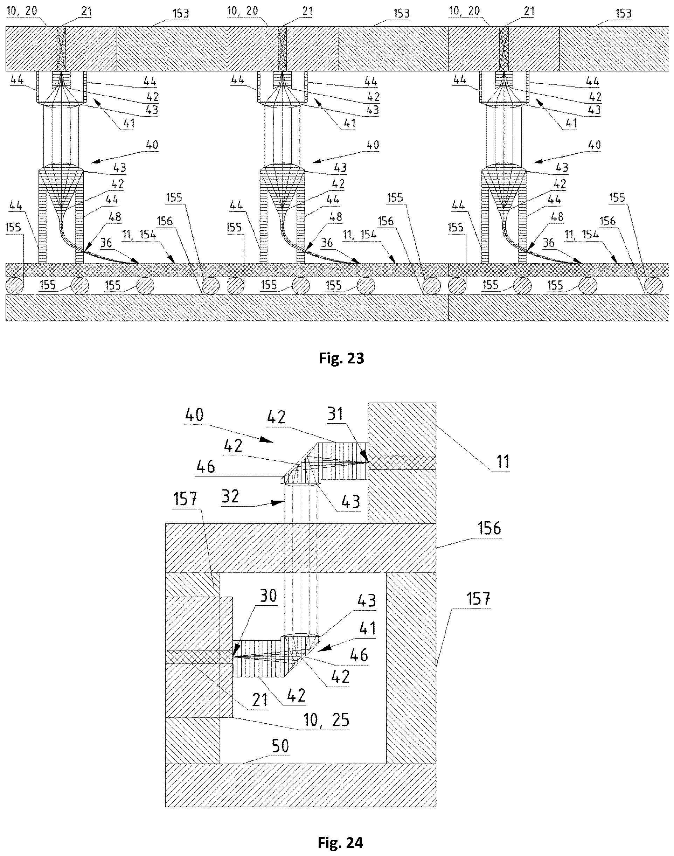

Figur 23 zeigt die Verbindung einer Vielzahl von auf einer Leiterplatte oder einem elektrischen Chip 156 montierten optischen Empfänger- und Senderkomponenten 154 ein- oder zweidimensionalen Faserarray 153. Die Sender- und Empfängerkomponenten 154 sind durch elektrische Kontaktstellen 158 mit dem Halbleiterchip oder der Leiterplatte 156 verbunden. Erste optische Komponenten 10, in dieser Ausführung Lichtwellenleiter wie optische Fasern 20, sind dabei mit den Sender- und Empfängerkomponenten 154, welche zweite optische Komponenten 11 darstellen, durch strahlformende Komponenten 40 und 41 verbunden. Der Winkel zwischen den von den optischen Komponenten (10,11) emittierten Strahlprofilen ist liegt im gezeigten Fall in der Nähe von 90°; erst die Umlenkung des Lichts in den strahlformenden Komponenten 40 ermöglicht die Kopplung.

Figur 24 zeigt die Verbindung einer in einer in eine elektro-optische Leiterplatte 157 eingebettete optische Einmodenfaser 25, welche eine erste optische Komponente 10 darstellt, mit einer zweiten optischen Komponente 11 die sich auf der elektro-optischen Leiterplatte 156 befindet. Hierfür werden die strahlformenden Komponenten 40 und 41 verwendet, wobei das kollimierte Strahlprofil 32 die an der betreffenden Stelle transparent elektro-optische Leiterplatte 156 durchstößt. Die Durchstoßstelle kann optional eine Materialaussparung in Form eines Lochs aufweisen. Bei der Komponente 11 kann es sich beispielsweise um einen integriert-optischen Chip oder einen optischen Interposer handeln.

Figur 25 zeigt die Kompensation von herstellungsbedingten Abweichungen optischer Komponenten 10 von ihrer Sollgröße 202 durch Veränderung der strahlformenden Komponente 40. Figur 25 kann als Aufsicht von Figur 10, 11, 12, 24 in Richtung oder Gegenrichtung des kollimierten Strahls 32 auf die strahlformenden Komponenten 40,41 verstanden werden. Figur 25 kann weiterhin als Aufsicht von strahlformenden Komponente 41 Figur 7 in Strahlrichtung verstanden werden. Dabei wird eine positive Abweichung 203 der optischen Komponente von der Sollgröße 202 (optische Komponente ist zu groß) durch eine Verkürzung 206 der strahlformenden Komponente 40 bewirkt. Eine negative Abweichung 204 von der Sollgröße 202 der optischen Komponente 10 wird durch eine Verlängerung 205 der strahlformenden Komponente 40 kompensiert. Die in Figur 25 gezeigten Abweichungen von der Sollgröße können beispielsweise durch Toleranzen beim Vereinzeln von optischen Chips auftreten, wozu beispielsweise Spalt- oder Sägeverfahren eingesetzt werden. Die durch Veränderungen 205, 206 der strahlformenden Komponente notwendige Kompensation kann zusätzlich oder ausschließlich durch weitere Beschaffenheitsänderungen der strahlformenden Komponente 40 wie z.B. einer Anpassung der Brechkraft erzielt oder verbessert werden. Insbesondere kann sie auch durch eine weitere Beschaffenheitsänderung einer weiteren strahlformenden Komponente 11 (nicht in Figur 25 gezeigt) ergänzt werden.

Figur 27 zeigt ein weiteres nicht-erfindungsgemäßes Beispiel, in welchem das optische System zwei optische Komponenten 10,11 aufweist, und zwar die erste Einmodenfaser 25 als die erste optischen Komponente 10 und die zweite Einmodenfaser 26 als die zweite optische Komponente 11. Im Unterschied zu den vorangehenden Ausführungsbeispielen ist hier genau ein strahlformendes Element 40 vorhanden, das fest mit der ersten optischen Komponente 10 verbunden ist, während die zweite optische Komponente 11 über kein strahlformendes Element verfügt. Das genau eine strahlformende Element 40 ist in diesem Beispiel dazu eingerichtet ist, um das erste Strahlprofil 30 der ersten optischen Komponente 10 derart zu verändern, dass sich nach einer Positionierung der ersten optischen Komponente 10 und der zweiten optischen Komponente 11 eine optische Kopplung zwischen der ersten optischen Komponente 10 und der zweiten optischen Komponente 11 ausbildet. Dies erfolgt insbesondere dadurch, dass das genau eine strahlformende Element 40 die erste Linse 27 aufweist, welche das erste Strahlprofil 30 der ersten optischen Komponente 11 derart verändert, dass ein Lichtstrahl fokussiert als das zweite Strahlprofil 31 auf die die zweite Einmodenfaser 26 auftreffen kann.

Alternativ oder zusätzlich zu den hier dargestellten Ausgestaltungen können auch andere optische Komponenten mit dem vorliegenden Verfahren miteinander verbunden werden. Hierbei werden dieselben Schritte durchgeführt, wobei anstelle der in den Ausführungsbeispielen beispielhaften verwendeten Einmodenfasern, Lasern oder optischen Chips die entsprechend ausgewählte optische Komponente beschrieben wird. Hierfür eignen sich insbesondere die folgenden optischen Komponenten, welche ausgewählt sind aus der Gruppe umfassend Einmoden- oder Mehrmodenfasern aus organischen oder anorganischen Materialien, halbleiterbasierte integriert-optische Chips wie z.B. Laser, Fotodioden, Superlumineszenz-Dioden oder Siliziumphotonik-Chips oder andere integriert-optische Chips auf Basis von Halbleitern oder dielektrischen Materialien wie z.B. Gläsern, Silizium-Dioxid, Silizium-Nitrid oder Polymeren, optische Leiterplatten, oder Elemente für die Freistrahl-Optik wie z.B. Linsen, Strahlteiler, Isolatoren, Spiegel oder Beugungsgitter.

Insbesondere können die optischen Pfade der dargestellten Ausführungsbeispiele invertiert werden, d.h. in beide Richtungen betrieben werden, solang es sich um ausschließlich reziproke Medien handelt. Hierbei kann die Rolle der Licht absendenden Komponente eine Licht empfangende Komponenten übernehmen und die Rolle der Licht empfangende Komponente kann eine Licht absendende Komponente übernehmen. Weiterhin kann eine optische Komponente auch gleichzeitig Licht absenden und empfangen.

Zur optischen Kopplung eignen sich insbesondere die folgenden strahlformenden Elemente, welche ausgewählt sind aus der Gruppe umfassend Linsen, Freiform-Linsen, Gradienten-Index-Optiken (GRIN), Kaskaden von Linsen eingebettet in ein Medium mit geringem Brechungsindexkontrast zum Resistmedium (Low Index Step Optics, LIS), Freiformspiegel basierend auf Reflexion oder Totaler-Interner Reflexion (TIR), diffraktive optische Elemente, photonische Kristalle und Lichtwellenleiter.

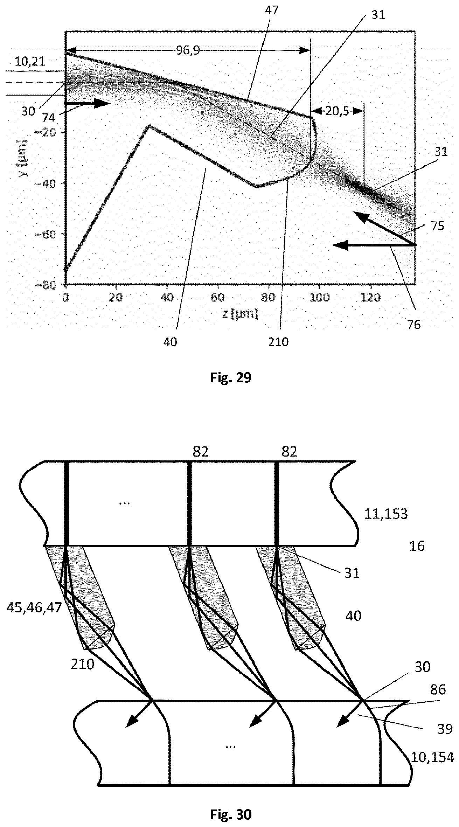

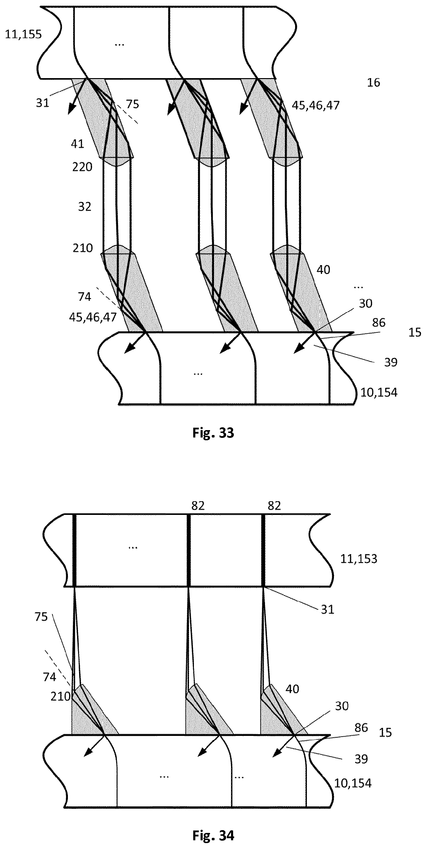

Die Figuren 28 bis 34 zeigen besondere Ausführungsformen, die zur Kopplung an Wellenleiter ausgelegt sind, die nicht senkrecht auf die zugehörige Chipkante treffen. Die Neigung der Wellenleiter bzgl. der Normalenrichtung der Chipkante verhindert, dass Licht bei der Auskopplung partiell in einen geführten Modus des Wellenleiters zurückgekoppelt werden kann, wodurch sich insbesondere eine Reflexionsvermeidung bei Halbleiterlasern oder optischen Halbleiterverstärkern erzielen lässt. Für eine effektive Ankopplung an derartige Wellenleiter oder Wellenleiterarrays ist es vorteilhaft, zusätzlich zum Modenprofil die Ausbreitungsrichtung des von der Facette emittierten Licht im Freiraum anzupassen, wobei bevorzugt eine Ausbreitungsrichtung senkrecht zur Chipkante erreicht werden kann. Dies kann insbesondere dann vorteilhaft sein, wenn ein Array von schräg auf die Facette treffenden Wellenleitern an ein Array von senkrecht auf die Facette treffenden Wellenleitern wie z.B. einem Faserarray angekoppelt werden soll. Zusätzlich kann eine Verringerung von Genauigkeitsanforderungen bei der Platzierung der Chips wünschenswert sein, was insbesondere durch eine Aufweitung des Modenfelddurchmessers erreicht werden kann. Diese Ausführungsbeispiele können insbesondere auch Merkmale der in Figur 12 dargestellten Anordnung aufweisen. Weiterhin können die in den Figuren 28 bis 34 dargestellten strahlformenden Elemente auch in anderen oder weiteren Kombinationen auftreten. So können insbesondere die in den Figuren 30 bis 33 dargestellten Ausführungsbeispiele auch mit den in Figur 34 dargestellten strahlformenden Elementen ausgeführt werden.

Figur 28 zeigt eine bevorzugte Ausführung, bei der ein oder mehrere Wellenleiter 86 eines optischen Chips 154 geneigt, d.h. nicht senkrecht, auf die Facette treffen, sodass die an der Facette auftretende Rückreflexion 39 nicht in einen geführten Modus des jeweiligen Wellenleiters 86 zurückgekoppelt werden kann. Durch besondere an der Facette des optischen Chips 154 angebrachte strahlformende Elemente 40 lässt sich eine effiziente Ankopplung an einen zweiten Chip oder an ein Faserarray 153 erreichen, bei dem die Wellenleiter senkrecht auf die Chipkante bzw. auf die Arraykante treffen. Die strahlformenden Elemente können dazu bevorzugt neben den Strahlprofilen 30, 31 auch Propagationsrichtungen 74, 75 der Strahlen aneinander anpassen. Sie können dazu beispielsweise konkave, konvexe oder ebene Spiegel 45, 46, 47 aufweisen, die beispielsweise das Prinzip der Totalreflexion an einer dielektrischen Grenzfläche ausnutzen können. Zusätzlich können die strahlformenden Elemente refraktive Flächen 210 aufweisen.

Figur 29 zeigt beispielhaft ein Ausführungsbeispiel eines entsprechenden strahlformenden Elements. Das Element wurde für einen unter 9 ° bzgl. der Normalenrichtung 76 auf die Kante eines InP-Chips auftreffenden Wellenleiter ausgelegt, welcher an der Facette ein elliptisches Modenfeld von ca. 3 $\mu$m Durchmesser in horizontaler Richtung und von ca. 3 $\mu$m Durchmesser in vertikaler Richtung aufweist, und bewirkt eine Ablenkung in Richtung der Facettennormalen sowie eine Aufweitung auf ein kreisförmiges Strahlprofil mit einem Durchmesser von ca. 10.4 $\mu$m.

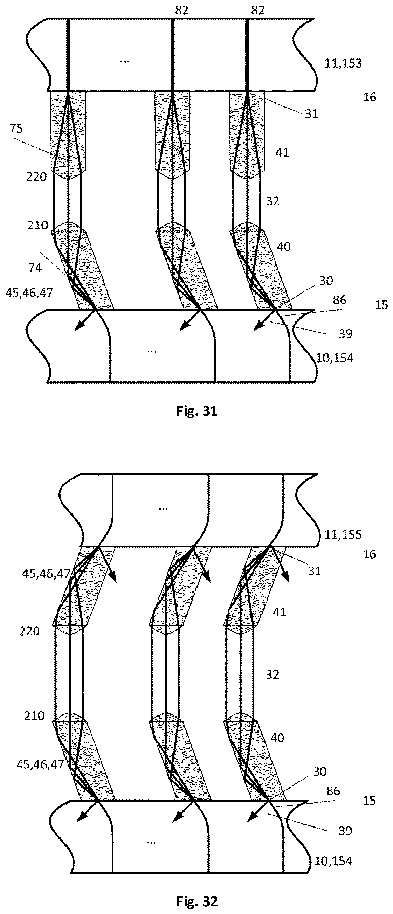

Das strahlformende Element kann, wie in Figur 30 dargestellt, sich in einer weiteren bevorzugten Ausführung auch auf dem zweiten Chip oder Faserarray 153 befinden, bei dem die Wellenleiter senkrecht auf die Kante auftreffen. Weiterhin können, wie in Figur 31 gezeigt, zwei strahlformende Elemente pro Koppelstelle zum Einsatz kommen, wobei sich ein strahlformendes Element 41 auf dem Chip oder Faserarray 153 mit senkrecht auf die Kante auftreffenden Wellenleitern befindet, während sich das andere strahlformende Element 40 auf dem optischen Chip 154 mit geneigt auf die Kante auftreffenden Wellenleitern befindet. Die Verwendung zweier strahlformender Elemente ermöglicht es insbesondere, durch eine entsprechende Strahlaufweitung die Genauigkeitsanforderungen an einen nachfolgenden Positionierungs- und Fixierungsschritt herabzusetzen. Dabei kann das strahlformende Element 41 bevorzugt eine refraktive Fläche 220 umfassen, während das strahlformende Element 40 eine Kombination einer refraktiven Fläche 210 und einer reflektierenden Fläche 45, 46, 47 aufweisen kann. Figur 32 zeigt eine weitere bevorzugte Ausführungsform, bei der zwei optische Chips 154, 155 mit geneigt auf die Kante auftreffenden Wellenleitern durch strahlformende Komponenten 40, 41 verbunden sind, die beide als Kombinationen aus Spiegeln und refraktiven Flächen ausgelegt sind. Hierdurch lassen sich eine Kopplung von Rückreflexionen 39 in geführte Wellenleitermoden an beiden Komponenten 10, 11 vermeiden und zusätzlich die Anforderungen an die Positionierungsgenauigkeit herabsetzen. Dabei können die Wellenleiter 86 der Komponenten 10, 11 so ausgerichtet sein, dass es zu einer parallelen Ausrichtung der Ausbreitungsrichtungen 74, 75 kommt. Figur 33 zeigt eine weitere bevorzugte Anordnung, bei der zur Anpassung der Propagationsrichtungen 74, 75 strahlformende Komponenten 40 zum Einsatz kommen, die jeweils lediglich eine refraktive Fläche 210 umfassen.

**Bezugszeichenliste**

| | |
|---|---|
| 10 | Erste optische Komponente |
| 11 | Zweite optische Komponente |
| 12 | Oberflächenmodifikation |
| 15 | Ergänzte erste optische Komponente |
| 16 | Ergänzte zweite optische Komponente |
| 20 | Optische Faser |
| 21 | Kern der optischen Faser |
| 22 | Mantel der optischen Faser |
| 25 | Erste Einmodenfaser |
| 26 | Zweite Einmodenfaser |
| 27 | Erste Linse |
| 28 | Zweite Linse |
| 29 | Optische Achse des optischen Systems |
| 30 | Erstes Strahlprofil |

| 31 | Zweites Strahlprofil |
|---|---|
| 32 | Modenfeld mit aufgeweitetem Profil |
| 33 | Nicht-rotationssymmetrisches Strahlprofil, welches eine geringere Ausdehnung in X-Richtung und eine größere Ausdehnung in Y-Richtung aufweist |
| 34 | Größer ausgedehnter Anteil des Strahlprofils 33 mit geringer Divergenz. |
| 35 | Geringer ausgedehnter Anteil des Strahlprofils 33 mit höherer Divergenz |
| 36 | Modenfeld im sich verjüngenden Teil (Taper) eines integrierten Wellenleiters |
| 37 | Strahlverlauf ohne Winkelabweichung 61 (durchgezogene Kurve) |
| 38 | Strahlverlauf bei Winkelabweichung 61 (gestrichelte Kurve) |
| 39 | Rückreflexion |
| 40 | (Erstes) strahlformendes Element |
| 41 | Zweites strahlformendes Element |
| 42 | Aufweitender Abschnitt des Strahlengangs oder aufweitender Teil des strahlformenden Elements |
| 43 | Kollimierender Abschnitt des Strahlengangs oder kollimierender Teil das strahlformenden Elements |
| 44 | Abstandshalter, erzeugt mit Zwei-Photonen Lithographie |
| 45 | (Bi-)Konvexer Spiegel |
| 46 | (Bi-)Konkaver Spiegel |
| 47 | Planarer Spiegel |
| 48 | Freiform-Lichtwellenleiter |
| 49 | Freiformfläche ohne optische Funktionalität |
| 50 | Grundplatte |
| 51 | Abstandshalter |
| 52 | Optisch transparentes Material; Einbettungsmedium mit einem niedrigerem Brechungsindex als die strahlformenden Elemente |
| 53 | Optisch transparentes Material; Einbettungsmedium mit einem höherem Brechungsindex als die strahlformenden Elemente |
| 54 | zusätzliches optisches Element |
| 55 | Hohlraum |
| 56 | (Kantenemittierender) Halbleiterlaser |
| 57 | Resistmaterial |
| 60 | Winkel |
| 61 | Winkelabweichung |
| 70 | Brennpunkt (Fokus) |
| 73 | Brennweite |
| 74 | Propagationsrichtung von Licht welches aus der ersten optischen Komponente 10 austritt |
| 75 | Propagationsrichtung von Licht welches aus der zweiten optischen Komponente 11 austritt |
| 76 | Normalrichtung zur ersten optischen Komponente 10 und zur zweiten optischen Komponente 11 |
| 80 | SOI taper |
| 81 | InP taper |
| 82 | Einmodenfaser (SMF) |
| 83 | Strahlaufweiter (Beam Expander) |
| 84 | Strahlaufweiter in Einbettungsmedium |
| 85 | Silizium-Wellenleiter |
| 86 | Wellenleiter, welcher nicht senkrecht auf eine Facette trifft |
| 101 | Grundplatte |
| 102 | Leiterbahnen für Hochfrequenz-Elektronik |
| 103 | Bond-Drähte |
| 104 | Kantenemittierenden Laser |
| 105 | Strahlaufweiter, Expander |
| 106 | Modulator |
| 107 | Arrayed-Waveguide Grating (AWG) |
| 114 | Modenfeldaufweiter, integriert in SiN-Technologie |
| 119 | Einzelmodenfaser (Single-Mode Fiber; SMF) |
| 120 | Mantel einer Einzelmodenfaser 119 |
| 130 bis 137 | Koppelstellen |
| 140 bis 147 | Strahlformende Elemente |
| 150 | Planarisierungsschicht |
| 151 | Nut einer Ausrichtstruktur |

| 152 | Zapfen einer Ausrichtstruktur |
|---|---|
| 153 | Faserarray |
| 154 | Optischer Chip |
| 155 | Weiterer optischer Chip |
| 156 | Elektrischer Chip oder elektrische Leiterplatte |
| 157 | Optische Leiterplatte |
| 158 | Elektrische Kontaktstelle |
| 202 | Sollgröße einer optischen Komponente |
| 203 | Positive Abweichung von Sollgröße einer optischen Komponente |
| 204 | Negative Abweichung von Sollgröße einer optischen Komponente |
| 205 | Verlängerung einer strahlformenden Komponente bei negativer Abweichung einer optischen Komponente von ihrer Sollgröße |
| 206 | Verkürzung einer strahlformenden Komponente bei positiver Abweichung einer optischen Komponente von ihrer Sollgröße |
| 210 | Refraktive Fläche eines strahlformenden Elements |
| 220 | Weitere refraktive Fläche eines strahlformenden Elements |

**Patentansprüche**

1. Verfahren zur Herstellung eines optischen Systems, welches mindestens zwei gesonderte optische Komponenten (10, 11) und mindestens eine optische Verbindung zwischen den zwei optischen Komponenten (10, 11) aufweist, umfassend die folgenden Schritte:

   a) Bereitstellen einer ersten optischen Komponente (10) und einer zweiten, gesonderten optischen Komponente (11), wobei die erste optische Komponente (10) ein erstes Strahlprofil (30) und die zweite optische Komponente (11) ein zweites Strahlprofil (31) aufweist;
   b) Entwerfen des optischen Systems unter Festlegung einer Anordnung der ersten optischen Komponente (10) und der zweiten optischen Komponente (11) sowie von Form und Zielposition eines ersten strahlformenden Elements (40) und eines zweiten strahlformenden Elements (41), wobei das erste strahlformende Element (40) fest mit der ersten optischen Komponente (10) und das zweite strahlformende Element (41) fest mit der zweiten optischen Komponente (11) verbunden werden, wobei das erste strahlformende Element (40) dazu eingerichtet ist, um das erste Strahlprofil (30), und das zweite strahlformende Element (41) dazu eingerichtet ist, um das zweite Strahlprofil (31) derart zu verändern, dass nach einer Positionierung der ersten optischen Komponente (10) und der zweiten optischen Komponente (11) eine optische Kopplung zwischen der ersten optischen Komponente (10) und der zweiten optischen Komponente (11) entsteht;
   c) Herstellen des ersten strahlformenden Elements (40) und des zweiten strahlformenden Elements (41) mittels eines dreidimensional direktschreibenden Lithographieverfahrens in-situ an der Zielposition, wodurch eine um das erste strahlformende Element (40) ergänzte erste optische Komponente (15) und eine um das zweite strahlformende Element (40) ergänzte zweite optische Komponente (16) erhalten werden; und
   d) Positionieren und Fixieren der um das erste strahlformende Element (40) ergänzten ersten optischen Komponente (15) und der um das zweite strahlformende Element (40) ergänzten zweiten optischen Komponente (16) auf einer gemeinsamen Grundplatte (50), wodurch das optische System erhalten wird.

2. Verfahren nach dem vorangehenden Anspruch, wobei die Herstellung des ersten strahlformenden Elements (40) und des zweiten strahlformenden Elements (41) mittels des dreidimensional direktschreibenden Lithographieverfahrens in-situ an den Zielpositionen an der ersten optischen Komponente (10) und an der zweiten optischen Komponente (11) eine Erfassung von auf den optischen Komponenten (10, 11) angebrachten Justiermarken beinhaltet, um die strahlformenden Elemente (40) und (41) relativ zu den zugehörigen optischen Komponenten (10) und (11) zu positionieren.

3. Verfahren nach einem der vorangehenden Ansprüche, wobei für die optische Verbindung ein Strahlengang gewählt wird, welcher zumindest einen Abschnitt (42, 43), ausgewählt aus einem strahlaufweitenden Abschnitt (42), einem kollimierten Abschnitt (43) oder einem strahlverengenden Abschnitt, aufweist, wobei der strahlaufweitende Abschnitt (42) dazu eingerichtet ist, um eine lokale Strahldivergenz zu erhöhen, der kollimierende Teil (43) Abschnitt dazu eingerichtet ist, um einen Strahldurchmesser konstant zu halten, und der strahlverengende Abschnitt dazu eingerichtet ist, um eine lokale Strahldivergenz zu verringern.

**4.** Verfahren nach dem vorangehenden Anspruch, wobei der Strahlengang einen strahlaufweitenden Teil (42), einen Wellenleiter (48) und einen eine Divergenz eines austretenden Strahls verringernden kollimierenden Teil (43) umfasst.

**5.** Verfahren nach einem der vorangehenden Ansprüche, wobei der Strahl der optischen Verbindung in einem kollimierten Abschnitt außerhalb der strahlformenden Elemente (40, 41) bei einer Wellenlänge von 1.55 $\mu$m einen Durchmesser von 5 $\mu$m bis 100 $\mu$m annimmt.

**6.** Verfahren nach einem der vorangehenden Ansprüche, wobei die Zwischenräume zwischen den strahlformenden Elementen (40, 41) zumindest teilweise mit einem optisch transparenten Material (52, 53) aufgefüllt werden, wobei das optisch transparente Material (52, 53) dazu eingerichtet ist, um Reflexionsverluste zwischen den strahlformenden Elementen (40, 41) und/oder eine chromatische Aberration eines die strahlformenden Elemente (40, 41) durchlaufenden Lichtstrahls zu verringern.

**7.** Verfahren nach einem der vorangehenden Ansprüche, wobei mindestens eine optische Komponente (10, 11) als optischer Chip (154) ausgeführt ist, wobei das mindestens eine auf dem optischen Chip (154) aufgebrachte strahlformende Element (40, 41) derart ausgelegt sind, dass eine Umlenkung von in einer Ebene des optischen Chips (154) propagierendem Licht in eine, in einem Winkel zur Oberfläche des optischen Chips (154) orientierten Richtung bewirkt wird und/oder Licht aus einer, aus einem Winkel zur Oberfläche des optischen Chips (154) orientierten Richtung in eine in der Oberfläche des optischen Chips (154) liegende Propagationsrichtung umgelenkt wird, wobei der Winkel mindestens 50° relativ zur Oberfläche des optischen Chips beträgt.

**8.** Verfahren nach dem vorangehenden Anspruch, wobei das propagierende Licht einen weiteren optischen Chip oder ein in den optischen Chip (154) oder in den weiteren optischen Chip eingebrachtes optisch transparentes Fenster durchdringt.

**9.** Verfahren nach einem der beiden vorangehenden Ansprüche, wobei das von einer ersten optischen Komponente (10) propagierende Licht in eine weitere, auf einem zweiten optischen Chip (155) aufgebachte optische Komponente (11) eingekoppelt wird und wobei die auf den optischen Chips (154) und (155) aufgebrachten strahlformenden Elemente (40, 41) derart ausgelegt sind, dass sie Licht aus einer in dem Winkel zur Oberfläche des optischen Chips (154) orientierten Richtung in eine in der Ebene des optischen Chips (155) liegende Propagationsrichtung umlenken.

**10.** Optisches System, umfassend eine erste optische Komponente (10) und eine zweite, gesonderte optische Komponente (11), wobei jede der optischen Komponenten (10, 11) jeweils ein Strahlprofil (30, 31) aufweist, wobei die erste optische Komponente (10) fest mit einem ersten strahlformenden Element (40) und die zweite optische Komponente (11) fest mit einem zweiten strahlformenden Element (41) derart verbunden ist, dass eine um das erste strahlformende Element (40) ergänzte erste optische Komponente (15) und eine um das zweite strahlformende Element (41) ergänzte zweite optische Komponente (16) vorliegen, wobei das erste strahlformende Element (40) dazu eingerichtet ist, um das Strahlprofil (30) der ersten optischen Komponente (10), und das zweite strahlformende Element (41) dazu eingerichtet ist, um das Strahlprofil (31) der zweiten optischen Komponente (10) derart zu verändern, dass eine optische Kopplung zwischen der ersten optischen Komponente (10) und der zweiten optischen Komponente (11) für Licht unterschiedlicher Wellenlängen auftritt, wobei die optische Kopplung zwischen der ersten optischen Komponente (10) und der zweiten optischen Komponente (11) derart ausgestaltet ist, dass die durch die strahlformenden Elemente (40, 41) veränderten Strahlprofile der zu verbindenden optischen Komponenten (10,11) in einem kollimierten Abschnitt außerhalb der strahlformenden Elemente (40, 41) bei einer Wellenlänge von 1.55 $\mu$m einen Strahldurchmesser von 5 $\mu$m bis 100 $\mu$m aufweisen, wobei das erste strahlformende Element (40) und das zweite strahlformende Element (41) mittels eines dreidimensional direktschreibenden Lithographieverfahrens in-situ an der Zielposition erhältlich sind, wobei die erste um das strahlformende Element (40) ergänzte erste optische Komponente (15) und die um das zweite strahlformende Element (40) ergänzte zweite optische Komponente (16) auf einer gemeinsamen Grundplatte (50) positioniert und fixiert sind, wobei mindestens eine der optischen Komponenten (10, 11) derart ausgelegt ist, dass eine Einkopplung und/oder eine Auskopplung von Licht an einer Kante der optischen Komponente (10, 11) erfolgt, oder wobei mindestens eines der auf einem optischen Chip (154) aufgebrachten strahlformenden Elemente (40, 41) derart ausgelegt ist, dass eine Umlenkung von in einer Ebene des optischen Chips (154) propagierendem Licht in eine, in einem Winkel zur Oberfläche des optischen Chips (154) orientierten Richtung bewirkt wird und/oder Licht aus einer, aus einem Winkel zur Oberfläche des optischen Chips (154) orientierten Richtung in eine in der Oberfläche des optischen Chips (154) liegende Propagationsrichtung umgelenkt wird, wobei der Winkel mindestens 50° relativ zur Oberfläche des optischen Chips (154) beträgt.

**11.** Optisches System nach dem vorangehenden Anspruch, wobei das erste strahlformende Element (40) und/oder das zweite strahlformende Element (41) über mindestens einen Teil (42, 43), ausgewählt aus einem strahlaufweitenden Teil (42), einem kollimierenden Teil oder einem strahlverengenden Teil (43), verfügt, wobei der strahlaufweitende Teil (42) dazu eingerichtet ist, um eine lokale Strahldivergenz zu erhöhen, der kollimierende Teil (43) dazu eingerichtet ist, um einen Strahldurchmesser konstant zu halten, und der strahlverengende Teil dazu eingerichtet ist, um eine lokale Strahldivergenz zu verringern.

**12.** Optisches System nach dem vorangehenden Anspruch, wobei das erste strahlformende Element (40) und/oder das zweite strahlformende Element (41) einen strahlaufweitenden Teil (42), einen Wellenleiter (48) und einen eine Divergenz eines austretenden Strahls verringernden kollimierenden Teil (43) umfasst, und/oder wobei der strahlaufweitende Teil (42) über eine Struktur verfügt, welche ausgewählt ist aus einer reflektierenden Struktur (45, 46, 47), einer refraktiven Struktur (210), einer lichtleitenden Struktur (48) oder einer diffraktiven Struktur.

**13.** Optisches System nach einem der drei vorangehenden Ansprüche, wobei die strahlformenden Elemente (40, 41) derart ausgestaltet sind, dass eine optische Achse mindestens eines der durch die strahlformenden Elemente (40, 41) veränderten Strahlprofile (30, 31) in dem kollimierten Abschnitt außerhalb der strahlformenden Elemente (40, 41) annähernd parallel zur optischen Achse mindestens eines der Strahlprofile (30, 31) der optischen Komponenten (10,11) verläuft.

**14.** Optisches System nach einem der vier vorangehenden Ansprüche, wobei sich zwischen den strahlformenden Elementen (40, 41) mindestens eine weitere optische Komponente (54) befindet.

**15.** Optisches System nach einem der fünf vorangehenden Ansprüche, wobei mindestens eine der optischen Komponenten (10,11) einen Wellenleiter (86) aufweist, der nicht senkrecht auf die Facette der betreffenden optischen Komponente (10,11) trifft, und wobei mindestens eines der strahlformenden Elemente (40, 41) Strahlausbreitungsrichtungen (74, 75) ineinander überführt.

**Claims**

**1.** Method for producing an optical system having at least two separate optical components (10, 11) and at least one optical connection between the two optical components (10, 11), comprising the following steps:

a) providing a first optical component (10) and a second, separate optical component (11), the first optical component (10) having a first beam profile (30) and the second optical component (11) having a second beam profile (31);

b) designing the optical system while specifying an arrangement of the first optical component (10) and the second optical component (11) and the form and target position of a first beam-shaping element (40) and a second beam-shaping element (41), the first beam-shaping element (40) being fixedly connected to the first optical component (10) and the second beam-shaping element (41) being fixedly connected to the second optical component (11), with the first beam-shaping element (40) being configured to modify the first beam profile (30) and the second beam-shaping element (41) being configured to modify the second beam profile (31), in such a way that, after positioning the first optical component (10) and the second optical component (11), an optical coupling is formed between the first optical component (10) and the second optical component (11);

c) producing the first beam-shaping element (40) and the second beam-shaping element (41) using a three-dimensional direct-writing lithography method in situ at the target position, whereby a first optical component (15) supplemented by the first beam-shaping element (40) and a second optical component (16) supplemented by the second beam-shaping element (40) are obtained; and

d) positioning and fixing the first optical component (15) supplemented by the first beam-shaping element (40) and the second optical component (16) supplemented by the second beam-shaping element (40) on a common base plate (50), whereby the optical system is obtained.

**2.** Method according to the preceding claim, wherein the production of the first beam-shaping element (40) and the second beam-shaping element (41) by way of the three-dimensional direct-writing lithography method in situ at the target positions on the first optical component (10) and the second optical component (11) includes capturing alignment marks applied to the optical components (10, 11), for positioning the beam-shaping elements (40) and (41) relative to the associated optical components (10) and (11).

3. Method according to either of the preceding claims, wherein a beam path which has at least one portion (42, 43) selected from a beam-expanding portion (42), a collimated portion (43) or a beam-narrowing portion is chosen for the optical connection, the beam-expanding portion (42) being configured to increase a local beam divergence, the collimating part (43) being configured to keep a beam diameter constant, and the beam-narrowing portion being configured to reduce a local beam divergence.

4. Method according to the preceding claim, wherein the beam path comprises a beam-expanding part (42), a waveguide (48) and a collimating part (43) which reduces a divergence of an exiting beam.

5. Method according to any of the preceding claims, wherein the beam of the optical connection in a collimated portion outside of the beam-shaping elements (40, 41) adopts a diameter of 5 $\mu$m to 100 $\mu$m for a wavelength of 1.55 $\mu$m.

6. Method according to any of the preceding claims, wherein the interspaces between the beam-shaping elements (40, 41) are filled at least in part with an optically transparent material (52, 53), the optically transparent material (52, 53) being configured to reduce reflection losses between the beam-shaping elements (40, 41) and/or reduce a chromatic aberration of a light beam passing through the beam-shaping elements (40, 41).

7. Method according to any of the preceding claims, wherein at least one optical component (10, 11) is embodied as an optical chip (154), with the at least one beam-shaping element (40, 41) applied to the optical chip (154) being designed such that a deflection of light propagating in a plane of the optical chip (154) into a direction oriented at an angle to the surface of the optical chip (154) is effected and/or light from a direction oriented at an angle to the surface of the optical chip (154) is deflected into a propagation direction located in the surface of the optical chip (154), the angle being at least 50° relative to the surface of the optical chip.

8. Method according to the preceding claim, wherein the propagating light passes through a further optical chip or through an optically transparent window introduced into the optical chip (154) or into the further optical chip.

9. Method according to one of the two preceding claims, wherein the light propagating from a first optical component (10) is input coupled into a further optical component (11) applied to a second optical chip (155), and wherein the beam-shaping elements (40, 41) applied to the optical chips (154) and (155) are designed such that they deflect light from a direction oriented at an angle to the surface of the optical chip (154) into a propagation direction located in the plane of the optical chip (155).

10. Optical system, comprising a first optical component (10) and a second, separate optical component (11), with each of the optical components (10, 11) having a respective beam profile (30, 31), the first optical component (10) being fixedly connected to a first beam-shaping element (40) and the second optical component (11) being fixedly connected to a second beam-shaping element (41), in such a way that a first optical component (15) supplemented by the first beam-shaping element (40) and a second optical component (16) supplemented by the second beam-shaping element (41) are present, with the first beam-shaping element (40) being configured to modify the beam profile (30) of the first optical component (10) and the second beam-shaping element (41) being configured to modify the beam profile (31) of the second optical component (10), in such a way that there is optical coupling between the first optical component (10) and the second optical component (11) for light at different wavelengths, with the optical coupling between the first optical component (10) and the second optical component (11) being designed such that the beam profiles modified by the beam-shaping elements (40, 41) of the optical components (10, 11) to be connected have a beam diameter of 5 $\mu$m to 100 $\mu$m at a wavelength of 1.55 $\mu$m in a collimated portion outside of the beam-shaping elements (40, 41), with the first beam-shaping element (10) and the second beam-shaping element (41) being obtainable by means of a three-dimensional direct-writing lithography method in situ at the target position, the first optical component (15) supplemented by the beam-shaping element (40) and the second optical component (16) supplemented by the second beam-shaping element (40) being positioned and fixed on a common base plate (50), with at least one of the optical components (10, 11) being designed such that there is input coupling and/or output coupling of light at an edge of the optical component (10, 11), or with at least one of the beam-shaping elements (40, 41) applied to an optical chip (154) being designed such that a deflection of light propagating in a plane of the optical chip (154) into a direction oriented at an angle to the surface of the optical chip (154) is effected and/or light from a direction oriented at an angle to the surface of the optical chip (154) is deflected into a propagation direction located in the surface of the optical chip (154), the angle being at least 50° relative to the surface of the optical chip (154).

11. Optical system according to the preceding claim, wherein the first beam-shaping element (40) and/or the second beam-shaping element (41) has at least one part (42, 43) selected from a beam-expanding part (42), a collimating part and a beam-narrowing part (43), with the beam-expanding part (42) being configured to increase a local beam divergence, the collimating part (43) being configured to keep a beam diameter constant, and the beam-narrowing part being configured to reduce a local beam divergence.

12. Optical system according to the preceding claim, wherein the first beam-shaping element (40) and/or the second beam-shaping element (41) comprises a beam-expanding part (42), a waveguide (48) and a collimating part (43) which reduces a divergence of an exiting beam, and/or wherein the beam-expanding part (42) has a structure selected from a reflective structure (45, 46, 47), a refractive structure (210), a light-guiding structure (48) and a diffractive structure.

13. Optical system according to any of the three preceding claims, wherein the beam-shaping elements (40, 41) are designed such that an optical axis of at least one of the beam profiles (30, 31) modified by the beam-shaping elements (40, 41) runs substantially parallel to the optical axis of at least one of the beam profiles (30, 31) of the optical components (10, 11) in the collimated portion outside of the beam-shaping elements (40, 41).

14. Optical system according to any of the four preceding claims, wherein at least one further optical component (54) is situated between the beam-shaping elements (40, 41).

15. Optical system according to any of the five preceding claims, wherein at least one of the optical components (10, 11) has a waveguide (86) which does not meet the facet of the optical component (10, 11) in question perpendicularly, and wherein at least one of the beam-shaping elements (40, 41) merges the beam propagation directions (74, 75) into one another.

**Revendications**

1. Procédé permettant de fabriquer un système optique qui présente au moins deux composants optiques séparés (10, 11) et au moins une liaison optique entre les deux composants optiques (10, 11), comprenant les étapes suivantes consistant à :

   a) fournir un premier composant optique (10) et un deuxième composant optique séparé (11), dans lequel le premier composant optique (10) présente un premier profil de faisceau (30) et le deuxième composant optique (11) présente un deuxième profil de faisceau (31) ;
   b) concevoir le système optique en définissant un agencement du premier composant optique (10) et du deuxième composant optique (11) ainsi que la forme et la position cible d'un premier élément de formation de faisceau (40) et d'un deuxième élément de formation de faisceau (41), dans lequel le premier élément de formation de faisceau (40) est relié solidement au premier composant optique (10) et le deuxième élément de formation de faisceau (41) est relié solidement au deuxième composant optique (11), dans lequel le premier élément de formation de faisceau (40) est conçu pour modifier le premier profil de faisceau (30), et le deuxième élément de formation de faisceau (41) est conçu pour modifier le deuxième profil de faisceau (31) de façon à créer après un positionnement du premier composant optique (10) et du deuxième composant optique (11) un couplage optique entre le premier composant optique (10) et le deuxième composant optique (11) ;
   c) fabriquer le premier élément de formation de faisceau (40) et le deuxième élément de formation de faisceau (41) au moyen d'un procédé de lithographie par écriture directe tridimensionnelle in situ à la position cible ce qui permet d'obtenir un premier composant optique (15) complété par le premier élément de formation de faisceau (40) et un deuxième composant optique (16) complété par le deuxième élément de formation de faisceau (40) ; et
   d) positionner et fixer le premier composant optique (15) complété par le premier élément de formation de faisceau (40) et le deuxième composant optique (16) complété par le deuxième élément de formation de faisceau (40) sur une plaque de base commune (50) ce qui permet d'obtenir le système optique.

2. Procédé selon la revendication précédente, dans lequel la fabrication du premier élément de formation de faisceau (40) et du deuxième élément de formation de faisceau (41) au moyen du procédé de lithographie par écriture directe tridimensionnelle in situ aux positions cibles au niveau du premier composant optique (10) et du deuxième composant optique (11) comprend une détection de repères d'alignement placés sur les composants optiques (10, 11) afin de positionner les éléments de formation de faisceau (40) et (41) par rapport aux composants optiques (10) et (11) associés.

3. Procédé selon l'une quelconque des revendications précédentes, dans lequel on choisit pour la liaison optique une trajectoire de faisceau qui présente au moins une section (42, 43) sélectionnée parmi une section d'élargissement de faisceau (42), une section collimatée (43) ou une section de rétrécissement de faisceau, dans lequel la section d'élargissement de faisceau (42) est conçue pour augmenter une divergence de faisceau locale, la partie de collimation (43) est conçue pour maintenir un diamètre de faisceau constant, et la section de rétrécissement de faisceau est conçue pour diminuer la divergence locale du faisceau.

4. Procédé selon la revendication précédente, dans lequel la trajectoire de faisceau comprend une partie d'élargissement de faisceau (42), un guide d'onde (48) et une partie de collimation (43) diminuant une divergence d'un faisceau sortant.

5. Procédé selon l'une quelconque des revendications précédentes, dans lequel le faisceau de la liaison optique adopte un diamètre de 5 $\mu$m à 100 $\mu$m dans une section collimatée à l'extérieur des éléments de formation de faisceau (40, 41) à une longueur d'onde de 1,55 $\mu$m.

6. Procédé selon l'une quelconque des revendications précédentes, dans lequel les espaces entre les éléments de formation de faisceau (40, 41) sont remplis au moins partiellement avec un matériau optiquement transparent (52, 53), dans lequel le matériau optiquement transparent (52, 53) est conçu pour diminuer des pertes de réflexion entre les éléments de formation de faisceau (40, 41) et/ou une aberration chromatique d'un faisceau lumineux passant par les éléments de formation de faisceau (40, 41).

7. Procédé selon l'une quelconque des revendications précédentes, dans lequel au moins un composant optique (10, 11) est réalisé comme une puce optique (154), dans lequel ledit au moins un élément de formation de faisceau (40, 41) appliqué sur la puce optique (154) est conçu de façon à provoquer une déviation de la lumière qui se propage dans un plan de la puce optique (154) dans une direction orientée selon un angle par rapport à la surface de la puce optique (154), et/ou à dévier la lumière provenant d'une direction orientée selon un angle par rapport à la surface de la puce optique (154) dans une direction de propagation située dans la surface de la puce optique (154), l'angle étant d'au moins 50° par rapport à la surface de la puce optique.

8. Procédé selon la revendication précédente, dans lequel la lumière qui se propage pénètre dans une autre puce optique ou une fenêtre optiquement transparente pratiquée dans la puce optique (154) ou dans l'autre puce optique.

9. Procédé selon une des deux revendications précédentes, dans lequel la lumière qui se propage à partir du premier composant optique (10) est injectée dans un autre composant optique (11) appliqué sur une deuxième puce optique (155), et dans lequel les éléments de formation de faisceau (40, 41) appliqués sur les puces optiques (154) et (155) sont conçus de façon à dévier la lumière provenant d'une direction orientée selon un angle par rapport à la surface de la puce optique (154) dans une direction de propagation située dans le plan de la puce optique (155).

10. Système optique, comprenant un premier composant optique (10) et un deuxième composant optique séparé (11), dans lequel chacun des composants optiques (10, 11) présente respectivement un profil de faisceau (30, 31), dans lequel le premier composant optique (10) est relié solidement à un premier élément de formation de faisceau (40) et le deuxième composant optique (11) est relié solidement à un deuxième élément de formation de faisceau (41) de telle sorte qu'un premier composant optique (15) complété par le premier élément de formation de faisceau (40) et un deuxième composant optique (16) complété par le deuxième élément de formation de faisceau (41) sont présents, dans lequel le premier élément de formation de faisceau (40) est conçu pour modifier le profil de faisceau (30) du premier composant optique (10), et le deuxième élément de formation de faisceau (41) est conçu pour modifier le profil de faisceau (31) du deuxième composant optique (10) de telle sorte qu'un couplage optique entre premier composant optique (10) et le deuxième composant optique (11) survient pour la lumière de différentes longueurs d'onde, dans lequel le couplage optique entre le premier composant optique (10) et le deuxième composant optique (11) est configuré de telle sorte que les profils de faisceaux modifiés par les éléments de formation de faisceau (40, 41) des composants optiques (10, 11) à relier présentent un diamètre de faisceau de 5 $\mu$m à 100 $\mu$m dans une section collimatée à l'extérieur des éléments de formation de faisceau (40, 41) à une longueur d'onde de 1,55 $\mu$m, dans lequel le premier élément de formation de faisceau (40) et le deuxième élément de formation de faisceau (41) peuvent être obtenus au moyen d'un procédé de lithographie par écriture directe tridimensionnelle in situ dans la position cible, dans lequel le premier le premier composant optique (15) complété par l'élément de formation de faisceau (40) et le deuxième composant optique (16) complété par le deuxième élément de formation de faisceau (40) sont positionnés et fixés sur une plaque de base commune (50), dans lequel au moins l'un des composants optiques (10, 11) est conçu de telle sorte qu'une injection et/ou une extraction de lumière a lieu au niveau d'un bord du composant optique (10, 11), ou dans lequel au moins l'un des éléments de formation de faisceau (40, 41) appliqués sur une puce optique (154) est conçu de telle sorte qu'une déviation de la lumière qui se propage dans un plan de la puce optique (154) est provoquée dans une direction orientée selon un angle par rapport à la surface de la puce optique (154), et/ou la lumière provenant d'une direction orientée selon un angle par rapport à la surface de la puce optique (154) est déviée vers une direction de propagation située dans la surface de la puce optique (154), l'angle étant d'au moins 50° par rapport à la surface de la puce optique (154).

11. Système optique selon la revendication précédente, dans lequel le premier élément de formation de faisceau (40) et/ou le deuxième élément de formation de faisceau (41) dispose(nt) d'au moins une partie (42, 43), sélectionnée parmi une partie d'élargissement de faisceau (42), une partie de collimation ou une partie de rétrécissement de faisceau (43), dans lequel la partie d'élargissement de faisceau (42) est conçue pour augmenter une divergence de faisceau locale, la partie de collimation (43) est conçue pour maintenir constant un diamètre de faisceau, et la partie de rétrécissement de faisceau est conçue pour diminuer une divergence de faisceau locale.

12. Système optique selon la revendication précédente, dans lequel le premier élément de formation de faisceau (40) et/ou le deuxième élément de formation de faisceau (41) comprend/comprennent une partie d'élargissement de faisceau (42), un guide d'onde (48) et une partie de collimation (43) diminuant une divergence d'un faisceau sortant, et/ou dans lequel la partie d'élargissement de faisceau (42) dispose d'une structure qui est sélectionnée parmi une structure réfléchissante (45, 46, 47), une structure réfractive (210), une structure conductrice de lumière (48) ou une structure diffractive.

13. Système optique selon l'une des trois revendications précédentes, dans lequel les éléments de formation de faisceau (40, 41) sont configurés de telle sorte qu'un axe optique d'au moins l'un des profils de faisceau (30, 31) modifiés par les éléments de formation de faisceau (40, 41) dans la section collimatée passe à l'extérieur des éléments de formation de faisceau (40, 41) approximativement en parallèle à l'axe optique d'au moins l'un des profils de faisceau (30, 31) des composants optiques (10, 11).

14. Système optique selon l'une des quatre revendications précédentes, dans lequel au moins un autre composant optique (54) se trouve entre les éléments de formation de faisceau (40, 41).

15. Système optique selon l'une des cinq revendications précédentes, dans lequel au moins l'un des composants optiques (10, 11) présente un guide d'onde (86) qui n'est pas incident perpendiculairement sur la facette du composant optique (10, 11) concerné, et dans lequel au moins l'un des éléments de formation de faisceau (40, 41) fait passer des directions de propagation de faisceau (74, 75) les unes aux autres.

a)

b)

**Fig. 1**

**Fig. 2**

**Fig. 3**

**Fig. 4**

**Fig. 5**

**Fig. 6**

**Fig. 7**

**Fig. 8**

**Fig. 9**

**Fig. 10**

Fig. 11

Fig. 12

**Fig. 13**

**Fig. 14**

**Fig. 15**

Fig. 16

Fig. 17

**Fig. 18**

**Fig. 19**

**Fig. 20**

Fig. 21

**Fig. 22**

**Fig. 23**

**Fig. 24**

Fig. 25

Fig. 26

**Fig. 27**

**Fig. 28**

**Fig. 29**

**Fig. 30**

**Fig. 31**

**Fig. 32**

**Fig. 33**

**Fig. 34**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8903205 B2
- US 9002157 B2
- EP 0940701 A2
- US 8968987 B2
- JP 2011248312 A
- WO 2015134566 A1
- EP 3130950 A1
- DE 19929878 A1
- US 20080142815 A1
- EP 0781423 B1
- US 6302593 B1
- US 6253004 B1

**In der Beschreibung aufgeführte Nicht-Patentliteratur**

- **ZUKAUSKAS et al.** Improvement of the Fabrication Accuracy of Fiber Tip Microoptical Components via Mode Field Expansion. *Journal of Laser Micro/Nano-engineering,* 2014, vol. 9 (1), 68-72
- **Y. FU et al.** Integrated Micro-Cylindrical Lens with Laser Diode for Single-Mode Fiber Coupling. *IEEE Photonics Technology Letters,* 2000, vol. 12 (9), 1213
- **S. THIELE et al.** Ultra-compact on-chip LED collimation optics by 3D-printing. *Opt. Lett.,* 2016, vol. 41, 3029
- **T. GISSIBL et al.** Two-photon direct laser writing of ultracompact multi-lens objectives. *Nature Photonics,* 2016, vol. 10
- **SCHNEIDER et al.** Optical coherence tomography system mass-producible on a silicon photonic chip. *Opt. Express,* 2016, vol. 24, 1573-1586
- **DIETRICH et al.** Lenses for Low-Loss Chip-to-Fiber and Fiber-to-Fiber Coupling Fabricated by 3D Direct-Write Lithography. *Conf. on Lasers and Electro-Optics (CLEO' 16), Paper SM1G.4.,* 2016
- Towards Scalable Hybrid 2D-3D Nanophotonic Circuits. **M. BLAICHER.** Magisterarbeit. Karlsruher Institut für Technologie, 2014
- **NGUYEN MINH-HANG et al.** SU-8 Lenses: Simple Methods of Fabrication and Application in Optical Interconnection Between Fiber/LED and Microstructures. *J. Electronic Materials,* 2016, vol. 45 (5), 2529-2535